(19) Europäisches Patentamt
European Patent Office
Office européen des brevets

(11) EP 2 175 007 A1

(12) EUROPEAN PATENT APPLICATION
published in accordance with Art. 153(4) EPC

(43) Date of publication:
**14.04.2010 Bulletin 2010/15**

(21) Application number: **08790752.3**

(22) Date of filing: **30.06.2008**

(51) Int Cl.:
***C09K 11/73*** (2006.01) ***C09K 11/08*** (2006.01)
***H01L 33/00*** (2010.01)

(86) International application number:
**PCT/JP2008/061839**

(87) International publication number:
**WO 2009/005035 (08.01.2009 Gazette 2009/02)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **29.06.2007 JP 2007173319**
**10.08.2007 JP 2007209521**

(71) Applicant: **Mitsubishi Chemical Corporation**
**Minato-ku**
**Tokyo 108-0014 (JP)**

(72) Inventors:
- **SHIMIZU, Etsuo**
**Yokohama-shi**
**Kanagawa 227-8502 (JP)**
- **OGIRI, Seiko**
**Yokohama-shi**
**Kanagawa 227-8502 (JP)**
- **WATANABE, Hiromu**
**Yokohama-shi**
**Kanagawa 227-8502 (JP)**
- **KIJIMA, Naoto**
**Yokohama-shi**
**Kanagawa 227-8502 (JP)**
- **SAKO, Naoki**
**Yokohama-shi**
**Kanagawa 227-8502 (JP)**
- **ENDOU, Noriko**
**Yokohama-shi**
**Kanagawa 227-8502 (JP)**
- **KANEDA, Hideaki**
**Ushiku-shi**
**Ibaraki 300-1295 (JP)**

(74) Representative: **HOFFMANN EITLE**
**Patent- und Rechtsanwälte**
**Arabellastrasse 4**
**81925 München (DE)**

# (54) PHOSPHOR, METHOD FOR PRODUCING PHOSPHOR, PHOSPHOR-CONTAINING COMPOSITION, AND LIGHT-EMITTING DEVICE

(57) To provide an alkaline-earth metal halogen phosphor that has high luminescent characteristics even when used with an excitation light source that emits light of the near-ultraviolet region, a phosphor-containing composition and a light emitting device using the phosphor, and a display and an illuminating device using the light emitting device,
the phosphor of the present invention has a chemical composition represented by the formula (1) below and an external quantum efficiency, when excited with light of 400-nm wavelength, of 77% or higher.

$$(Sr_{10-x-y-z}M_xEu_yMn_z)(PO_4)_6(Cl_{1-a}Q_a)_2 \quad (1)$$

(In the above formula (1), "M" represents at least one kind of element selected from the group consisting of Ba, Ca, Mg, and Zn, "Q" represents at least one kind of element selected from the group consisting of F, Br, and I, and each of "x", "y", "z", and "a" represents a number satisfying the following requirements: $0 \leq x < 10$, $0.3 \leq y \leq 1.5$, $0 \leq z \leq 3$, $0 \leq a \leq 1$, and $x+y+z \leq 10$.)

EP 2 175 007 A1

## Description

### Technical Field

The present invention relates to a phosphor that is excited by near-ultraviolet light, a phosphor-containing composition and a light emitting device that contain the phosphor. It also relates to an illuminating device and a display using the light emitting device.

### Background Art

Phosphors for use in fluorescent lamps have been developed so that it is excited strongly by ultraviolet light (wavelength of 254 nm, 365 nm or the like) emitted by mercury discharge. Among the phosphors used widely for fluorescent lamps is an alkaline-earth metal halogen apatite phosphor.

In recent years, light emitting devices utilizing a semiconductor luminous element has been attracting attention as excitation light source because it is high in energy efficiency and requires no mercury.

For example, Patent Document 1 discloses an example in which an LED is combined with an alkaline-earth metal halogen apatite phosphor.

Patent Document 2 discloses another example in which an LED is combined with an alkaline-earth metal halogen apatite phosphor.

Patent Document 3 discloses a method for obtaining a phosphor by using a chloride as raw material of amount 1.6 to 2.5 times the theoretical value and performing a firing process only once (see paragraph [0012]).

Patent Document 4 discloses a method for obtaining a phosphor by performing a secondary firing in a weakly reducing atmosphere without using a flux after firing the materials in the air (see the lower right section of page 2).

[Patent Document 1] Japanese Patent Laid-Open Publication No. 2004-253747
[Patent Document 2] the pamphlet of International Publication No. 2002/086978
[Patent Document 3] Japanese Patent Laid-Open Publication No. Hei 5-302082
[Patent Document 4] Japanese Patent Laid-Open Publication No. Sho 61-292848

### Disclosure of the Invention

### Problem to Be Solved by the Invention

In the alkaline-earth metal halogen apatite phosphor disclosed in Patent Document 1, the absorption efficiency is improved by increasing Eu amount. However, against the background of improvement in characteristics of light emitting devices in recent years, a phosphor with higher external quantum efficiency has been desired for use in such light emitting devices.

In Patent Document 2, no mention was made of quantum efficiencies such as external quantum efficiency. In addition, Examples of Patent Document 2 only disclose Eu and Mn coactivation. Further, it is evident from excitation spectra shown in Examples 1 and 9 of Patent Document 2 that the number of photons (%), which indicates intensity of the excitement, dramatically decreases in the near-ultraviolet region. Moreover, though there is a description that particle diameters of 10 $\mu$m to 30 $\mu$m are preferable, there is no disclosure on how to achieve phosphors with such particle diameters.

In addition, phosphors disclosed in Patent Documents 1 to 4 are not sufficient in luminescent characteristics under excitation by light of the near-ultraviolet region, and therefore, further improvement has been demanded. Furthermore, an increase in the amount of activation element (such as Eu) may improve luminescent characteristics, but it leads to the tendency that emission intensity at high temperatures decreases compared to that at room temperature.

The present invention has been made in view of the above problems. The object of the present invention is to provide an alkaline-earth metal halogen phosphor that has high luminescent characteristics even when used with an excitation light source that emits light of the near-ultraviolet region, a phosphor-containing composition and a light emitting device using the phosphor, and a display and an illuminating device using the light emitting device.

### Means for Solving the Problem

The present inventors made an elaborate investigation on composition, shape, production method or the like of phosphors to solve the above problems. In consequence, they have found that a phosphor with an external quantum efficiency of as high as 77% or higher can be obtained when the phosphor possesses a chemical composition represented by the above-mentioned formula (1) and excited by light of near-ultraviolet wavelengths such as around 400 nm.

They have also found that such a phosphor can be produced by a method comprising a plurality of firing steps and carrying out the second or subsequent firing step in the presence of a flux. These findings led to the completion of the present invention.

Namely, the subject matter of the present invention lies in a phosphor of which chemical composition is represented by the formula (1) below, and external quantum efficiency when excited with light of 400-nm wavelength is 77% or higher (claim 1).

$$(Sr_{10-x-y-z}M_xEu_yMn_z)(PO_4)_6(Cl_{1-a}Q_a)_2 \qquad (1)$$

(In the above formula (1), "M" represents at least one kind of element selected from the group consisting of Ba, Ca, Mg, and Zn, "Q" represents at least one kind of element selected from the group consisting of F, Br, and I, and each of "x", "y", "z", and "a" represents a number satisfying the following requirements: $0 \le x < 10$, $0.3 \le y \le 1.5$, $0 \le z \le 3$, $0 \le a \le 1$, and $x+y+z \le 10$.)

In the phosphor of the present invention, it is preferable that the weight median diameter $D_{50}$ is 7.5 μm or larger and 20 μm or smaller (claim 2).

Further, in the phosphor of the present invention, it is preferable that the excitation spectrum at 25°C satisfies the formula (2) below (claim 3).

$$0.8 \le I_{ex}(400)/I_{ex}(350) \qquad (2)$$

(In the above formula (2), $I_{ex}(400)$ represents the intensity of excitation peak at a wavelength of 400 nm, and $I_{ex}(350)$ represents the intensity of excitation peak at a wavelength of 350 nm.)

In the phosphor of the present invention, it is preferable that the absorption efficiency of the excitation light is 80% or higher (claim 4).

In the phosphor of the present invention, it is preferable that the standard deviation (quantile deviation) of the weight median diameter $D_{50}$ takes a value of 0.26 or smaller (claim 5).

It is preferable that the phosphor of the present invention satisfies the formula (3) below (claim 6).

$$0.65 \le I(125)/I(25) \qquad (3)$$

(In the above formula (3), I(25) represents the emission-peak intensity of said phosphor when excited with light of 400-nm wavelength at 25°C, and I(125) represents the emission-peak intensity of said phosphor when excited with light of 400-nm wavelength at 125°C.)

In the above formula (1), it is preferable that the phosphor contains at least Sr (claim 7).

Another subject matter of the present invention lies in a production method of a phosphor represented by the above formula (1), comprising a plurality of firing steps and carrying out the second or subsequent firing step in the presence of a flux (claim 8).

In this case, it is preferable that the production method of the present invention comprises a step in which a firing is performed in the presence of a flux after nucleation of phosphor crystals (claim 9).

Still another subject matter of the present invention lies in a phosphor-containing composition comprising: the phosphor of the present invention and a liquid medium (claim 10).

Still another subject matter of the present invention lies in a light emitting device comprising: a first luminous body and a second luminous body that emits visible light when irradiated with light from the first luminous body, wherein the light emitting device comprises, as the second luminous body, a first phosphor including at least one kind of the phosphor of the present invention (claim 11).

In this case, it is preferable that the light emitting device comprises, as the second luminous body, a second phosphor including at least one kind of a phosphor of which emission-peak wavelength is different from that of the first phosphor (claim 12).

Further, in this case, it is preferable that the first luminous body has an emission peak in the wavelength range of from 300 nm to 420 nm, and the second luminous body comprises, as the second phosphor, at least one kind of a phosphor having an emission peak in the wavelength range of from 500 nm to 570 nm and at least one kind of a phosphor having an emission peak in the wavelength range of from 570 nm to 700 nm (claim 13).

Still another subject matter of the present invention lies in an illuminating device comprising a light emitting device of the present invention (claim 14).
Still another subject matter of the present invention lies in a display comprising a light emitting device of the present invention (claim 15).

Still another subject matter of the present invention lies in a color image display constituted by combining an optical shutter, a color filter corresponding to the optical shutter and comprising at least trichromatic components of red, green, and blue, and a backlight for transillumination, wherein a light source used for the backlight comprises a semiconductor light emitting device in which phosphor is combined with solid luminous element that emits light of ultraviolet to near-ultraviolet region, and the relationship between NTSC ratio W, which is a ratio of color reproduction range of color image display elements, and light utilization efficiency Y is represented by the formula below (claim 16).

$$Y \geq -0.24W+49 \quad (\text{where, } W \geq 87)$$

[Mathematical Formula 1]

$$X = \frac{\int_{380}^{780} \bar{x}(\lambda)S(\lambda)T(\lambda)d\lambda}{\int_{380}^{780} \bar{y}(\lambda)S(\lambda)d\lambda} \qquad x = \frac{X}{X+Y+Z}$$

$$Y = \frac{\int_{380}^{780} \bar{y}(\lambda)S(\lambda)T(\lambda)d\lambda}{\int_{380}^{780} \bar{y}(\lambda)S(\lambda)d\lambda} \qquad y = \frac{Y}{X+Y+Z}$$

$$Z = \frac{\int_{380}^{780} \bar{z}(\lambda)S(\lambda)T(\lambda)d\lambda}{\int_{380}^{780} \bar{y}(\lambda)S(\lambda)d\lambda}$$

where, the symbols in the above formula are defined as follows.

[Mathematical Formula 2]

$\bar{x}(\lambda), \bar{y}(\lambda), \bar{z}(\lambda)$ : Color-matching function in a XYZ colorimetric-system

$S(\lambda)$ : Relative emitting light distribution spectrum of a backlight

$T(\lambda)$ : Transmittance of a color filter

Effect of the invention

According to the present invention, a phosphor having high luminescent characteristics under excitation by light of near-ultraviolet region can be provided.
In addition, the phosphor of the present invention is usually improved in temperature characteristics in comparison with the conventional ones.
Furthermore, since the phosphor of the present invention usually has a flat excitation spectrum in the near-ultraviolet region, the present invention can provide a phosphor showing just a small color shift even when the luminous wavelength of the excitation light source shifts, and can also provide a light emitting device or the like, using the phosphor.

Brief Description of the Drawings

[Fig. 1] Fig. 1 is a schematic perspective view illustrating the positional relationship between an excitation light source (first luminous body) and a phosphor-containing part (second luminous body), in an example of the light emitting device of the present invention.
[Fig. 2] Both Fig. 2(a) and Fig. 2(b) are schematic sectional views illustrating an example of the light emitting device comprising an excitation light source (first luminous body) and a phosphor-containing part (second luminous body).
[Fig. 3] Fig. 3 is a sectional view schematically illustrating an embodiment of the lighting system of the present invention.
[Fig. 4] Fig. 4 is a graph showing the relationship between NTSC ratio and light utilization efficiency of a color image display according to the present invention.
[Fig. 5] Fig. 5 is a graph showing measurement results of X-ray diffraction on Reference Example I-1.
[Fig. 6] Fig. 6 is a graph showing an enlarged view of around the 27.8° peak of the X-ray diffraction measurement results on Reference Example I-1. The solid line shows after the primary firing. The dashed line shows after the secondary firing. The chain line shows after the tertiary firing.
[Fig. 7] Fig. 7 is a graph showing an enlarged view of around the 33° peak of the X-ray diffraction measurement results on Reference Example I-1. The solid line shows after the primary firing. The dashed line shows after the secondary firing. The chain line shows after the tertiary firing.
[Fig. 8] Fig. 8 is a graph of X-ray diffraction patterns measured on the phosphor prepared in Example I-3 of the present invention.
[Fig. 9] FIG. 9 is a photo, which substitutes for a drawing, showing an image of the phosphor prepared in Reference Example I-2, which is observed by a scanning electron microscope.
[Fig. 10] Fig. 10 is a photo, which substitutes for a drawing, showing an image of the phosphor prepared in Example I-2 of the present invention, which is observed by a scanning electron microscope.
[Fig. 11] Fig. 11 is a photo, which substitutes for a drawing, showing an image of the phosphor prepared in Example I-4 of the present invention, which is observed by a scanning electron microscope.
[Fig. 12] FIG. 12 is a photo, which substitutes for a drawing, showing an image of the phosphor prepared in Comparative Example I-2, which is observed by a scanning electron microscope.
[Fig. 13] Fig. 13 is a photo, which substitutes for a drawing, showing an image of the phosphor prepared in Example I-2 of the present invention, which is observed by a scanning electron microscope.
[Fig. 14] Fig. 14 is a photo, which substitutes for a drawing, showing an image of the phosphor prepared in Example I-4 of the present invention, which is observed by a scanning electron microscope.
[Fig. 15] Fig. 15 is a graph showing emission spectral maps of the phosphors prepared in Examples I-3 and I-4 of the present invention.
[Fig. 16] Fig. 16 is a graph showing excitation spectra of the phosphors prepared in Example I-2 of the present invention and Comparative Examples I-1 and I-3. The solid line shows Example I-2. The dashed line shows Comparative Example I-1. The chain line shows Comparative Example I-3.
[Fig. 17] Fig. 17 is a graph showing emission spectral maps of the surface-mount white light emitting devices produced in Examples I-9 and I-10 of the present invention. The chain line shows Example I-9. The solid line shows Example I-10.
[Fig. 18] Fig. 18 is a graph showing the relative emission spectrum of the backlight 1 prepared in Production Example II-1.
[Fig. 19] Fig. 19 is a graph showing the relative emission spectrum of the backlight 2 prepared in Production Example II-2.
[Fig. 20] Fig. 20 is a graph showing the relative emission spectrum of the backlight 3 prepared in Production Example II-3.

[Fig. 21] Fig. 21 is a graph showing the relative emission spectrum of the backlight 4 prepared in Production Example II-4.
[Fig. 22] Fig. 22 is a graph showing the relative emission spectrum of the backlight 5 prepared in Production Example II-5.
[Fig. 23] Fig. 23 is a graph showing the relative emission spectrum of the backlight 6 prepared in Production Example II-6.
[Fig. 24] Fig. 24 is a graph showing the transmittance spectrum of the color filter for Example II-1.
[Fig. 25] Fig. 25 is a graph showing the transmittance spectrum of the color filter for Example II-2.
[Fig. 26] Fig. 26 is a graph showing the transmittance spectrum of the color filter for Example II-3.
[Fig. 27] Fig. 27 is a graph showing the transmittance spectrum of the color filter for Example II-4.
[Fig. 28] Fig. 28 is a graph showing the transmittance spectrum of the color filter for Example II-5.
[Fig. 29] Fig. 29 is a graph showing the transmittance spectrum of the color filter for Example II-6.
[Fig. 30] Fig. 30 is a graph showing the transmittance spectrum of the color filter for Example II-7.
[Fig. 31] Fig. 31 is a graph showing the transmittance spectrum of the color filter for Example II-8.
[Fig. 32] Fig. 32 is a graph showing the transmittance spectrum of the color filter for Example II-9.
[Fig. 33] Fig. 33 is a graph showing the transmittance spectrum of the color filter for Example II-10.
[Fig. 34] Fig. 34 is a graph showing the transmittance spectrum of the color filter for Example II-11.
[Fig. 35] Fig. 35 is a graph showing the transmittance spectrum of the color filter for Example II-12.
[Fig. 36] Fig. 36 is a graph showing the transmittance spectrum of the color filter for Comparative Example II-1.

Explanation of Letters or Numerals

1 second luminous body
2 surface-emitting type GaN-based LD
3 substrate
4 light emitting device
5 mount lead
6 inner lead
7 first luminous body
8 phosphor-containing resinous part
9 conductive wire
10 mold member
11 surface-emitting lighting system
12 holding case
13 light emitting device
14 diffusion plate
22 first luminous body
23 phosphor-containing resinous part
24 frame
25 conductive wire
26 electrode
27 electrode

Best Modes for Carrying Out the Invention

An embodiment of the present invention will be explained in detail below. It is to be understood that the present invention is not limited to the following embodiment and any modification can be added thereto insofar as they do not depart from the scope of the present invention.
Each composition formula of the phosphors in this Description is punctuated by a comma (,). Further, when two or more elements are juxtaposed in parentheses with a comma (,) in between, one kind of or two or more kinds of the juxtaposed elements can be contained in the composition formula in any combination and in any composition. A subscript to show the number of atoms (composition ratio) which is added to the parentheses indicates the total number of atoms of the elements juxtaposed in the parentheses.
For example, a composition formula, "$(Ca,Sr,Ba)Al_2O_4$:Eu", inclusively indicates all of "$CaAl_2O_4$:Eu", "$SrAl_2O_4$:Eu", "$BaAl_2O_4$:Eu", "$Ca_{1-x}Sr_xAl_2O_4$:Eu", "$Sr_{1-x}Ba_xAl_2O_4$:Eu", "$Ca_{1-x}Ba_xAl_2O_4$:Eu" and "$Ca_{1-x-y}Sr_xBa_yAl_2O_4$:Eu" (here, in these formulae, $0<x<1$, $0<y<1$, $0<x+y<1$).

All the relationships between color names and their color coordinates in this Description comply with the Japanese Industrial Standards (JIS Z8110 and Z8701).

[1. Phosphor]

The phosphor of the present invention is **characterized in that** its chemical composition is represented by the formula (1) below, and external quantum efficiency when excited with light of 400-nm wavelength is 77% or higher.
In what follows, the composition and the characteristics of the phosphor of the present invention are described in detail.

[1-1. Composition of phosphor]

The phosphor of the present invention is **characterized in that** it has a chemical composition represented by the formula (1) below. Namely, the phosphor of the present invention is obtained by substituting Eu for a part of Sr site of a host crystal with a chemical composition of $Sr_{10}(PO_4)_6Cl_2$. Furthermore, in the phosphor of the present invention, a part of Sr site may be substituted with specific bivalent metal element, and a part of Cl site may be substituted with other halogen element, if necessary.

$$(Sr_{10-x-y-z}M_xEu_yMn_z)(PO_4)_6(Cl_{1-a}Q_a)_2 \qquad (1)$$

(In the above formula (1),

"M" represents at least one kind of element selected from the group consisting of Ba, Ca, Mg, and Zn,
"Q" represents at least one kind of element selected from the group consisting of F, Br, and I, and each of "x", "y", "z", and "a" represents a number satisfying the following requirements:

$0 \le x < 10$,
$0.3 \le y \le 1.5$,
$0 \le z \le 3$,
$0 \le a \le 1$, and
$x+y+z \le 10$.)

In the above formula (1), "M" represents at least one kind of element selected from the group consisting of Ba, Ca, Mg, and Zn. The above-mentioned "M" can include one kind of these elements singly or two or more kinds of them in any combination and in any ratio. Among others, when the phosphor of the present invention is used in an illuminating device, it is preferable that M includes Ba, Ca, and/or Mg because full width at half maximum of the emission peak can then be broadened and color rendering of the lighting system can then be improved. When the phosphor of the present invention is used in a display, it is preferable that M does not include Ba, Ca, Mg, or Zn because full width at half maximum of the emission peak can then be narrowed, color purity can then be improved, and NTSC ratio of the image display can then be widened.
In the above formula (1), "x" is a numerical value indicating substitution amount of "M" for Sr sites. The numerical value is usually 0 or larger, and usually less than 10, preferably 5 or smaller, more preferably 2 or smaller. Among others, when the phosphor of the present invention is used for lighting system or the like, "x" is usually 0.1 or larger, preferably 0.5 or larger, and usually less than 10, for the sake of obtaining a phosphor with broad full width at half maximum of emission peak and high brightness. On the other hand, when the phosphor of the present invention is used for a backlight of a display, it is preferable that the full width at half maximum of emission peak is narrow. In such a case, "x" is preferably 0.3 or smaller, more preferably 0.
In the above formula (1), "y" is a numerical value indicating substitution amount of Eu for Sr sites. The lower limit of the numerical value is usually 0.3 or higher, preferably 0.4 or higher, particularly preferably 0.5 or higher. When the substitution amount of Eu is too small, sufficient emission intensity may not be achieved. On the other hand, when the substitution amount of Eu is too large, emission intensity may be enhanced, but at the same time, temperature characteristics may decrease. Therefore, the upper limit of the substitution amount of Eu is usually 1.5 or lower, preferably 1.2 or lower, more preferably lower than 1, particularly preferably lower than 0.9. In this way, by adjusting the substitution amount of Eu, temperature characteristics of the obtained phosphor can be excellent while the emission intensity thereof can be kept sufficiently high. Moreover, by a production method of phosphor of the present invention, to be described later, the emission intensity can be improved even when the substitution amount of Eu is not large. This can lead to preparation of a phosphor that excels in both emission intensity and temperature characteristics, which is desirable.
In the above formula (1), "z" is a numerical value indicating substitution amount of Mn for Sr sites. The numerical value is usually 0 or larger, and usually 3 or smaller. Particularly when a blue-light emitting phosphor is intended to be obtained, it is more preferable that Z = 0.

The relationship between "x", "y", and "z" is preferably such that $x+y+z\leq 10$, and more preferably such that $x+y+z<10$. This means that it is more preferable that the chemical composition represented by the formula (1) contains at least Sr.

In the above formula (1), "Q" represents at least one kind of element selected from the group consisting of F, Br, and I. The above-mentioned "Q" can include one kind of these elements singly or two or more kinds of them in any combination and in any ratio.

In the above formula (1), "a" is a numerical value indicating substitution amount of Q for Cl sites. The value "a" is usually 0 or larger, and usually 1 or smaller, preferably 0.1 or smaller. When the value exceeds this range, the emission-peak wavelength may shift. Particularly when a blue-light emitting phosphor is intended to be obtained, it is preferable that a = 0.

As described above, Sr sites in the above-mentioned formula (1) can be substituted with bivalent metal elements such as Ba, Ca, Mg, Zn, and Mn. In addition, Cl sites can be substituted with F, Br, I, or the like. Since the above-mentioned Sr sites are frequently occupied by alkaline-earth metals, they can be called alkaline-earth metal site. Moreover, elements other than those described above can also be used for the substitutions, if in a small amount. For example, metal elements with different valences such as Na or La can be substituted for Sr site.
Therefore, the phosphor of the present invention can be of many kinds of chemical compositions.

The preferable examples of the composition of the phosphor of the present invention are as follows, but the composition of the phosphor of the present invention is not limited to these examples.
The examples are: $(Sr_{9.2}Eu_{0.8})(PO_4)_6Cl_2$, $(Sr_9Eu)(PO_4)_6Cl_2$, $(Sr_{8.2}CaEu_{0.8})(PO_4)_6Cl_2$, $(Sr_{7.2}BaCaEu_{0.8})(PO_4)_6Cl_2$, $(Sr_9Eu)(PO_4)_6Cl_{1.8}F_{0.2}$, $(Sr_{9.1}Eu_{0.8}Mn_{0.1})(PO_4)_6Cl_2$, and $(Sr_6BaCaMgEu)(PO_4)_6Cl_{1.8}F_{0.2}$.

The phosphor of the present invention may further contain element (hereinafter referred to as "trace element" as appropriate) selected from the group consisting of elements having valence of 1, 2, 3, -1 and -3, in addition to the elements included in the above formula (1), namely other than Sr, M, Eu, Mn, $PO_4$, Cl, and Q.

Particularly, as the trace element, it is preferable to contain at least one element selected from the group consisting of alkali metal element, alkaline-earth metal element, zinc (Zn), yttrium (Y), aluminium (Al), scandium (Sc), phosphorus (P), nitrogen (N), rare-earth element, and halogen element.

The total content of the above trace element is usually 1 ppm or more, preferably 3 ppm or more, more preferably 5 ppm or more, and usually 100 ppm or less, preferably 50 ppm or less, more preferably 30 ppm or less. When the phosphor of the present invention contains two or more kinds of trace elements, the total amount of them is adjusted to be in the above range.

[1-2. Characteristics of phosphor]

The phosphor of the present invention shows high external quantum efficiency, as described below. In addition, it is preferable for the phosphor of the present invention to have characteristics described below.

[Absorption efficiency $\alpha_q$, internal quantum efficiency $\eta_i$, external quantum efficiency $\eta_o$]

(External quantum efficiency $\eta_o$)

The external quantum efficiency (hereinafter also represented by "$\eta_o$") is the ratio of the number of photons emitted from a phosphor relative to the number of photons in the light (excitation light) emitted from an excitation light source (corresponding to the "first luminous body" described later). The external quantum efficiency corresponds to the product of the absorption efficiency (hereinafter also represented by "$\alpha_q$") described later and the internal quantum efficiency (hereinafter also represented by "$\eta_i$") described later. Namely, the external quantum efficiency $\eta_o$ is defined by the following formula.

[Mathematical Formula 3]

$$(\text{External quantum efficiency } \eta_o) = (\text{Absorption efficiency } \alpha_q) \times (\text{Internal quantum efficiency } \eta_i)$$

The phosphor of the present invention has high external quantum efficiency $\eta_o$. Specifically, the external quantum efficiency $\eta_o$ of the phosphor of the present invention when excited with a light of 400-nm wavelength is usually 77% or higher, preferably 78% or higher, more preferably 79% or higher, still more preferably 80% or higher. Too low an external quantum efficiency $\eta_o$ of a phosphor tends to decrease the emission intensity when using the phosphor in a light emitting device.

Phosphors are sometimes pulverized in order to control particle diameters of the phosphor particles. For example, a fired product obtained by firing phosphor materials is sometimes pulverized so that a phosphor having desired particle diameters is obtained. In conventional phosphors, such a control of particle diameters of phosphor particles by performing a pulverization causes defects in the crystal lattice, which leads to decrease in internal quantum efficiency. Therefore, such a pulverization also decreases external quantum efficiency, which is the product of internal quantum efficiency and absorption efficiency. However, the phosphor of the present invention can have a high external quantum efficiency as described above, even when the particle diameters are controlled by performing a post-treatment such as pulverization so that the weight median diameter $D_{50}$ is 7.5 $\mu$m or larger and 20 $\mu$m or smaller. This is probably because the phosphor of the present invention excels in crystallinity.

Method for measuring external quantum efficiency $\eta_o$ of a phosphor is as described later.

(Absorption efficiency $\alpha_q$)

The absorption efficiency $\alpha_q$ is the ratio of the number of photons absorbed in a phosphor relative to the number of photons in the excitation light.

The higher the absorption efficiency $\alpha_q$ of the phosphor of the present invention is, the more preferable. Specifically, it is preferable the absorption efficiency $\alpha_q$ of the phosphor of the present invention when excited with a light of 400-nm wavelength is usually 80% or higher, preferably 84% or higher, more preferably 85% or higher, still more preferably 90% or higher. When the absorption efficiency $\alpha_q$ of a phosphor is too low, quantity of the excitation light necessary for a predetermined level of light emission tends to be too large, leading to a large amount of energy consumption. This results in decrease in emission efficiency.

Method for measuring absorption efficiency $\alpha_q$ of a phosphor is as described later.

(Internal quantum efficiency $\eta_i$)

Internal quantum efficiency $\eta_i$ is the ratio of the number of emitted photons from a phosphor relative to the number of photons in the excitation light that is absorbed into the phosphor.

The higher the internal quantum efficiency $\eta_i$ of the phosphor of the present invention is, the more preferable. Specifically, it is preferable that the internal quantum efficiency $\eta_i$ of the phosphor of the present invention when excited with a light of 400-nm wavelength is usually 79% or higher, preferably 85% or higher, more preferably 90% or higher. When the internal quantum efficiency $\eta_i$ of a phosphor is too low, quantity of the excitation light necessary for a predetermined level of light emission tends to be too large, leading to a large amount of energy consumption. This results in decrease in emission efficiency.

Method for measuring internal quantum efficiency $\eta_i$ of a phosphor is as described later.

(Method for measuring absorption efficiency $\alpha_q$, internal quantum efficiency $\eta_i$, and external quantum efficiency $\eta_o$)

In the following, methods for determining the absorption efficiency $\alpha_q$, internal quantum efficiency $\eta_i$, and external quantum efficiency $\eta_o$ of a phosphor will be described.

First, the phosphor sample to be measured (for example, phosphor powder or the like) is stuffed up in a cell with its surface smoothed sufficiently to keep high measurement accuracy, and then it is set on a condenser such as an integrating sphere. The reason for using a condenser such as an integrating sphere is to count up all the photons both reflected at and emitted by a fluorescence phenomenon, from the phosphor sample. In other words, it is to prevent the failure in counting photons going out of the measurement system.

A light emission source for exciting the phosphor sample is attached to the condenser. An Xe lamp can be used as the light emission source, for example. This light emission source is adjusted using a filter, monochromator (grating monochromator) or the like so that the emission-peak wavelength thereof is of a monochromatic light of, for example, 400-nm wavelength.

Then the spectra including those of the emitted light (fluorescence) and reflected light is measured, using a spectrometer (such as MCPD7000 or MCPD2000 manufactured by Otsuka Electronics Co., Ltd.) by irradiating the phosphor sample to be measured with the above-mentioned light from the light emission source, of which emission-peak wavelength is adjusted. The light of which spectrum is to be measured here actually includes, of the lights (hereinafter referred to simply as "excitation lights") from the excitation light source, reflected lights that are not absorbed in the phosphor and lights (fluorescences) having the other wavelengths that are emitted by a fluorescence phenomenon from the phosphor which absorbed the excitation light. Namely, the region of the excitation light corresponds to the reflection spectrum, and the wavelength region of longer wavelengths corresponds to the fluorescence spectrum (also referred to as "emission spectrum").

Absorption efficiency $\alpha_q$ is calculated by dividing N into $N_{abs}$, where $N_{abs}$ is the number of photons in the excitation light that is absorbed in the phosphor sample and N is the number of all the photons in the excitation light. A concrete calculation procedure is as follows.

First, the latter one, namely the total number N of all the photons in the excitation light is determined as follows. That is, the reflection spectrum (hereinafter designated as "$I_{ref}(\lambda)$") is measured using the spectrometer with respect to a substance to be measured having reflectance R of approx. 100% to the excitation light, such as a white reflection plate "Spectralon" manufactured by Labsphere (with 98% of reflectance to an excitation light of 400-nm wavelength), which is attached to the above condenser in the same disposition as the phosphor sample.

From this reflection spectrum $I_{ref}(\lambda)$, a numeric value represented by the (formula I) below is determined. The numeric value represented by the (formula I) below is proportional to N, the total number of photons in the excitation light.

[Mathematical Formula 4]

$$\frac{1}{R}\int \lambda \cdot I_{ref}(\lambda)d\lambda$$

(formula I)

In the above formula (I), the integration may be performed at only such intervals that $I_{ref}(\lambda)$ takes a substantially significant value.

On the other hand, the number $N_{abs}$ of the photons in the excitation light that is absorbed in the phosphor sample is proportional to the amount calculated from the following (formula II).

[Mathematical Formula 5]

$$\frac{1}{R}\int \lambda \cdot I_{ref}(\lambda)d\lambda - \int \lambda \cdot I(\lambda)d\lambda$$

(formula II)

In the above (formula II), "$I(\lambda)$" is a reflection spectrum when the phosphor sample, of which absorption efficiency $\alpha_q$ is intended to be determined, is attached to the condenser.

The integration interval of the above (formula II) is set to be the same as that of the above (formula I). By restricting the integration interval as above, the second term in the above (formula II) becomes a value corresponding to the number of photons emitted from the measurement object, phosphor sample, by the reflection of the excitation light. In other words, it becomes a value corresponding to the number of all photons emitted from the measurement object, phosphor sample, except for the number of photons emitted by the fluorescence phenomenon. Since the actual measurement value of the spectrum is generally obtained as digital data which are divided by a certain finite band width relating to $\lambda$, the integrations of the above (formula I) and (formula II) are calculated as finite sum based on the band width.

Consequently, the absorption efficiency $\alpha_q$ can be calculated from the following formula.

[Mathematical Formula 6]

Absorption efficiency $\alpha_q = N_{abs}/N$ = (formula II)/(formula I)

Next, a method for determining internal quantum efficiency $\eta_i$ will be described.

The internal quantum efficiency $\eta_i$ is the value calculated by dividing $N_{abs}$ into $N_{PL}$, where $N_{PL}$ is the number of photons originating from the fluorescence phenomenon and $N_{abs}$ is the number of photons absorbed in the phosphor sample.

Here, $N_{PL}$ is proportional to the amount calculated from the following (formula III).

[Mathematical Formula 7]

$$\int \lambda \cdot I(\lambda) d\lambda \quad \text{(formula III)}$$

At this point, the integration interval of the above (formula III) is restricted to the wavelength region of photons originating from the fluorescence phenomenon of the phosphor sample. This is because contribution of the photons that are reflected from the phosphor sample should be eliminated from I(λ).

Specifically, the lower limit of the integration interval in the above (formula III) takes the value of upper limit of the integration interval in the above (formula I), and the upper limit of the integration interval takes the value that is necessary and sufficient for including the photons originating from the fluorescence.

Consequently, the internal quantum efficiency $\eta_i$ can be calculated from the following formula.

[Mathematical Formula 8]

Internal quantum efficiency $\eta_i$ = (formula III)/(formula II)

Incidentally, the integration from spectra expressed by digital data can be carried out in the same way as when absorption efficiency $\alpha_q$ is calculated.

The external quantum efficiency $\eta_o$ can be decided as a product of the absorption efficiency $\alpha_q$ and internal quantum efficiency $\eta_i$, which are obtained by the above procedure.

The external quantum efficiency $\eta_o$ can also be calculated from the following relational expression.

[Mathematical Formula 9]

$\eta_o$ = (formula III)/ (formula I)

Namely, the external quantum efficiency $\eta_o$ is equal to a value calculated by dividing N into $N_{PL}$, where $N_{PL}$ is the number of photons originating from fluorescence and N is the number of total photons in the excitation light.

[Excitation wavelength characteristics]

There is no special limitation on the excitation wavelength of the phosphor of the present invention. However, it is preferable that it can be excited by lights of which wavelength ranges are usually 250 nm or longer, particularly 300 nm or longer, more particularly 350 nm or longer, and usually 430 nm or shorter, particularly 410 nm or shorter, more particularly 400 nm or shorter. For example when it can be excited by near-ultraviolet lights (wavelength range: 300 nm or longer and 420 nm or shorter), it can be preferably used for a light emitting device in which a semiconductor luminous element or the like is used as the first luminous body.

In addition, it is preferable that the value of $I_{ex}(400)/I_{ex}(350)$, which relates to the excitation spectrum at a room temperature (25°C) of the phosphor of the present invention, satisfies the formula (2) below. In the formula (2), $I_{ex}(400)$ represents the intensity of excitation peak at a wavelength of 400 nm, and $I_{ex}(350)$ represents the intensity of excitation peak at a wavelength of 350 nm.

[Mathematical Formula 10]

$$0.8 \leq I_{ex}(400)/I_{ex}(350) \qquad (2)$$

Though the value of the left-hand side term of the above formula (2) is 0.8, it is preferably 0.85, more preferably 0.86, still more preferably 0.9. The closer to 1 the value is, the more preferable. In other words, it is desirable that the value of $I_{ex}(400)/I_{ex}(350)$ is 0.8 or larger, preferably 0.85 or larger, more preferably 0.86 or larger, still more preferably 0.9 or larger, and the closer to 1 it is, the more preferable.

The value $I_{ex}(400)/I_{ex}(350)$ characterizes the shape of an excitation spectrum. The closer to 1 the value is, the flatter the shape of the excitation band is. Accordingly, when the value $I_{ex}(400)/I_{ex}(350)$ falls below the above-mentioned range, chromaticity, brightness and the like of the light emitting device may become unstable due to an individual difference in emission-peak wavelength of the excitation light sources occurred as described later.

In addition it is preferable that the value $I_{ex}(400)/I_{ex}(350)$ is usually 1.5 or smaller. This is because a flat shape of the excitation band is preferable, as mentioned above.

Emission-peak wavelengths of semiconductor luminous elements such as LEDs or semiconductor laser diodes (hereinafter abbreviated as "LD" as appropriate) which are used as excitation light sources will be changed owing to use environment such as temperature, humidity, or current carrying amount. It is well-known that there is a tendency of instability with their emission-peak wavelengths.

Semiconductor luminous elements particularly suffer changes in their emission-peak wavelengths due to environmental temperature or, particularly, heat generated by energization because they depend highly on temperature. It is known that the spectra vary from lot to lot of production or due to deterioration of the semiconductor luminous element itself. However, it is difficult at present to suppress change in emission-peak wavelength of semiconductor luminous elements and let them emit lights of a constant wavelength.

Therefore, it is generally preferable for phosphors to have an excitation spectrum of which shape is flat in a predetermined wavelength range. At this point, it is preferable that the excitation band in excitation spectrum is not only flat but also broad. Since the phosphor of the present invention absorbs excitation lights of near-ultraviolet wavelength region, its excitation band in excitation spectrum is broad if it is flat at excitation band of 350 nm to 400 nm. Therefore, it is preferable that the closer to 1 the value $I_{ex}(400)/I_{ex}(350)$ of the phosphor of the present invention is, the more preferable, as described above. This is because a light emitting device of which light emission is stable can be produced then.

(Method of bringing $I_{ex}(400)/I_{ex}(350)$ close to 1)

A method to bring the value $I_{ex}(400)/I_{ex}(350)$ close to 1 is, for example, setting Eu amount in a specific range. As Eu amount is increased, the value $I_{ex}(400)/I_{ex}(350)$ usually increases.

For example, the value $I_{ex}(400)/I_{ex}(350)$ can be 0.8 or larger by setting "y" in the above-mentioned formula (1) at 0.3 or larger.

In addition, carrying out a production method (multistep firing) of the present invention to be described later tends to increase the value $I_{ex}(400)/I_{ex}(350)$.

(Method for measuring excitation spectrum)

Excitation spectra can be measured using a fluorescence spectrophotometer, F-4500 type, (manufactured by Hitachi, Ltd.) at a room temperatures such as 25°C. Specifically, excitation spectra in a wavelength range of from 250 nm to 530 nm is measured using a blue emission peak of wavelength at 447-nm as a monitor. The excitation peak wavelength, value $I_{ex}(400)/I_{ex}(350)$, or the like can be calculated from the obtained excitation spectrum.

[Emission spectrum characteristics]

The emission-peak wavelength $\lambda_p$(nm) of the phosphor of the present invention is in the range of usually 430 nm or longer, preferably 435 nm or longer, more preferably 440 nm or longer, and usually 470 nm or shorter, preferably 465 nm or shorter, more preferably 460 nm or shorter, when it is irradiated with lights of wavelength at near-ultraviolet region (specifically, a light of 400-nm wavelength).

In addition, it is preferable that the value of $I_{em}i(450)/I_{emi}(430)$, which relates to the emission spectrum at a room temperature (25°C) of the phosphor of the present invention, satisfies the formula (IV) below. In the formula (IV), $I_{emi}(450)$ represents the emission intensity of a wavelength component of 450 nm, and $I_{emi}(430)$ represents the emission intensity of a wavelength component of 430 nm.

[Mathematical Formula 11]

$$2.8 \leq I_{emi}(450)/I_{emi}(430) \quad (IV)$$

Though the value of left-hand side term of the above formula (IV) is 2.8, it is preferably 3, more preferably 3.5. In other words, the value of $I_{em}i(450)/I_{emi}(430)$ is preferably 2.8 or larger, more preferably 3 or larger, still more preferably 3.5 or larger.

Furthermore, it is preferable that the value of $I_{em}i(450)$ /$I_{emi}(470)$, which relates to the emission spectrum at a room temperature (25°C) of the phosphor of the present invention, satisfies the formula (V) below. In the formula (V), $I_{emi}(470)$ represents the emission intensity of a wavelength component of 470 nm.

[Mathematical Formula 12]

$$2.5 \leq I_{emi}(450)/I_{emi}(470) \quad (V)$$

Though the value of left-hand side term of the above formula (V) is 2.5, it is preferably 2.8, more preferably 3. In other words, the value of $I_{emi}(450)/I_{emi}(470)$ is preferably 2.5 or larger, more preferably 2.8 or larger, still more preferably 3 or larger.

The values $I_{emi}(450)$ /$I_{emi}(430)$ and $I_{emi}(450)/I_{emi}(470)$ characterize the shape of an emission spectrum. The larger those values are, the sharper the shapes of the emission peaks tend to be, though they depend on the emission-peak wavelengths. When the value $I_{emi}(450)/I_{emi}(430)$ is large, there is a tendency that NTSC ratio is improved, but brightness of the phosphor itself decrease. When the value $I_{emi}(450)/I_{emi}(470)$ is large, there is a tendency that brightness of the phosphor itself is improved, but NTSC ratio decrease. Therefore, it is preferable that both the values of $I_{emi}(450)$ /$I_{emi}(430)$ and $I_{emi}(450)/I_{emi}(470)$ are sufficiently large while they are in good balance, although varying from the use. Incidentally, when the phosphor of the present invention is used for a backlight of a display, it is particularly preferable for the phosphor to have an emission peak that is sharp as described above and located at a wavelength of 450 nm.

(Full width at half maximum of emission peak)

In addition, full width at half maximum (hereinafter abbreviated as "FWHM" as appropriate) of emission peak in the above-mentioned emission spectrum of the phosphor of the present invention is in the range of usually 1 nm or longer, preferably 20 nm or longer, and usually 35 nm or shorter, preferably 32 nm or shorter, more preferably 30 nm or shorter. When the full width at half maximum, FWHM, is too narrow, the emission intensity may decrease. When it is too wide, the color purity may decrease.

(Method for measuring emission spectrum)

Emission spectra can be measured by using a fluorescence measurement apparatus (manufactured by JASCO corporation) equipped with an excitation light source of a 150-W xenon lamp and a spectrum measurement apparatus of multichannel CCD detector, C7041 (manufactured by Hamamatsu Photonics K.K.) at a room temperature such as 25°C. More specifically, lights from the excitation light source are passed through a grating monochromator with focal length of 10 cm so as to isolate lights having wavelengths of from 350 nm to 410 nm, and the isolated excitation lights alone are radiated onto a phosphor via optical fibers. The lights emitted from the phosphor by irradiation of the excitation lights are separated using a grating monochromator with focal length of 25 cm, and the emission intensity of each wavelength of the lights is measured using the spectrum measurement apparatus in the wavelength range of from 300 nm to 800 nm. Then, through a signal processing such as sensitivity correction using a personal computer, the emission spectra can be obtained. The slit width of the receiving spectroscope is specified at 1 nm during the measurement.

[Color coordinates]

The luminescent color of the phosphor of the present invention can be expressed using an x and y colorimetric system (CIE 1931 colorimetric system), which is one of CIE color coordinates.

Specifically, the CIE color coordinate x of the phosphor of the present invention is usually 0.150 or larger, preferably 0.151 or larger, more preferably 0.152 or larger, and usually 0.155 or smaller, preferably 0.154 or smaller, more preferably 0.153 or smaller.
In addition, the CIE color coordinate y of the phosphor of the present invention is usually 0.030 or larger, preferably 0.032 or larger, more preferably 0.034 or larger, and usually 0.037 or smaller, preferably 0.036 or smaller, more preferably 0.035 or smaller.
When the CIE color coordinates x and y are within the above ranges, an advantageous effect of wide color reproduction range, at the time of white light synthesis, can be achieved.
The CIE color coordinates x and y of a phosphor can be calculated from the emission spectrum in the wavelength range of from 420 nm to 800 nm in accordance with JIS Z8724.

[Phosphor shape]

Regarding shape, the phosphor of the present invention has a characteristic that the particle diameter is usually large compared to conventional ones. In the production method of the present invention, a multistep firing is performed to accelerate particle growth, which probably enlarges particle diameter of the phosphor. Large particle diameters are preferable for phosphors because the external quantum efficiency tends to be high then.
In what follows, shape of phosphor of the present invention is described in detail.

(Weight median diameter $D_{50}$ and its standard deviation)

Both weight median diameter $D_{50}$ and its standard deviation are values relating to particle diameters.
In the present invention, weight median diameter $D_{50}$ (hereinafter referred to as "median diameter $D_{50}$") is defined as follows.
Median diameter $D_{50}$ is a value calculated from a weight-standard particle size distribution curve, which can be obtained from a measurement of particle size distribution by laser diffraction/scattering method. Specifically, it can be obtained from a measurement on phosphor particles dispersed in a water solution containing a dispersant using a laser diffraction particle size analyzer (LA-300, manufactured by HORIBA, Ltd.) in a particle diameter range of from 0.1 μm to 600 μm. Median diameter $D_{50}$ is the value of particle diameter whose integrated value is 50% in this weight-standard particle size distribution curve. In the same way, the values of particle diameters at integrated values of 25% and 75% in the weight-standard particle size distribution curve will be expressed by $D_{25}$ and $D_{75}$, respectively.
The standard deviation (quantile deviation, hereinafter referred to as QD) of the median diameter $D_{50}$ is defined as:

$$\text{standard deviation (quantile deviation) } QD = (D_{75}-D_{25})/(D_{75}+D_{25}).$$

A small value of QD means a narrow particle size distribution.
The particle diameter values of the phosphor of the present invention usually have an almost normal distribution. The median diameter $D_{50}$ is usually 7.5 μm or larger, preferably 9 μm or larger, more preferably 10 μm or larger, and usually 20 μm or smaller, preferably 18 μm or smaller, more preferably 15 μm or smaller.
When the median diameter $D_{50}$ is too small, the efficiency with which excitation lights are absorbed tends to be low, leading possibly to decrease in brightness. On the other hand, when the median diameter $D_{50}$ is too large, it tends to be difficult for the phosphor to be used for an instrument equipped with a nozzle or the like from a practical standpoint.
The QD value of the particle diameter distribution of the phosphor of the present invention is, when a phosphor of single median diameter $D_{50}$ is used, usually 0.26 or smaller, preferably 0.24 or smaller, particularly preferably 0.23 or smaller.
When a mixture of two or more kinds of phosphors having different median diameters $D_{50}$ is used for the purpose of enhancing emission efficiency and/or absorption efficiency, the QD of the phosphor mixture may be larger than 0.26.
Phosphors having the aforementioned median diameter $D_{50}$ and QD can be obtained by performing a pulverization process and a classification process, and if necessary, a washing process, a drying process, a surface treatment process or the like, described later in the section [2-6. Post-treatments].

(Particle shape and average circularity)

The more spherical the shape of the phosphor of the present invention is, the more preferable. As index that quantitatively shows sphericity of phosphor particles, can be used average circularity. In this context, average circularity means the degree of circularity, which shows the degree of approximation between a projection of a particle and its corresponding perfect circle having the same particle diameter. Namely, it is defined as follows: degree of circularity = the peripheral length of a perfect circle having the same projected area as that of a particle/ the peripheral length of the projection of a particle. The average circularity of a perfect sphere is 1. Average circularities can be measured using a flow particle image analyzer ("FPIA-2000" manufactured by SYSMEX CORPORATION) by dispersing a sample as is the case for the weight median diameter $D_{50}$ described before.

It is preferable that particles of extremely large or small sizes are removed in the process of phosphor production, but a certain amount of mixing is inevitable practically. Comparisons of the degree of circularity of particles are preferably made not on every particle diameter, but on particle diameters of 5 μm or larger and 30 μm or smaller, in the phosphor of the present invention. When the average circularity of a phosphor is smaller than 0,94, emission efficiency of the light emitting device using the present phosphor may be insufficient. Therefore, the average circularity of the phosphor of the present invention is preferably 0.94 or larger, more preferably 0.95 or larger. The closer to 1 it is, the more preferable. In addition, in the phosphor of the present invention, it is preferable that the ratio of particles having a degree of circularity of smaller than 0.85 relative to all particles of the phosphor is as small as possible. Specifically, the ratio is usually 7% or smaller, preferably 6% or smaller, more preferably 5% or smaller.

When phosphors have irregular shapes such as acicula, plate, or cluster formed by fusing of particles, they tend to aggregate readily in a dispersion medium, making it difficult to obtain uniform phosphor films. Furthermore, when lights are emitted from a phosphor having irregularity in its phosphor shape with their wavelengths converted by the phosphor, the spectrum may be unbalanced.

(Crystal structure)

The crystal of which composition is the above-mentioned formula (1) has an apatite structure. The structure is a hexagonal system and its space group is $P6_3/m$. Apatite is a mineral which exists naturally in nature (refer to Cornelius S. Hurlbut, Jr and Cornelius Klein "Manual of Mineralogy" John Wiley & Sons).

The phosphor of the present invention has a crystal habit originating from apatite structure, which can be observed by a scanning electron microscope (hereinafter occasionally referred to as "SEM") observation (see [Fig. 10], [Fig. 13] and [Fig. 11], [Fig. 14]). Namely, a feature of the phosphor of the present invention is that its particles do not aggregate, and therefore, the particles are showing the original outside shapes of the crystal. In addition, the angles formed between the plain surfaces are usually obtuse, which makes the degree of circularity of the particles close to 1. On the other hand, in conventional phosphors, crystal habits originating from apatite structure are hardly seen, and instead, fracture planes of the crystals are frequently observed (see [Fig. 12]). These fracture planes, each of which forms an acute angle with its neighboring plane, are one of the causes of decrease in degree of circularity of the particles. Moreover, the phosphor of the present invention is nearly spherical and high in proportion of single grains (single grain ratio). Namely, another feature of the phosphor of the present invention is that its particles usually have less fracture planes and similar outside shapes to crystals of natural apatites.

[Temperature characteristics]

The phosphor of the present invention is also superior in temperature characteristics usually. Specifically, it is preferable that the value of I(125)/I(25) satisfies the formula (3) below. In the formula (3), I(125) represents the emission-peak intensity of the phosphor when excited with light of 400-nm wavelength at 125°C, and I(25) represents the emission-peak intensity of the phosphor when excited with light of 400-nm wavelength at 25°C.

[Mathematical Formula 13]

$$0.65 \leq I(125)/I(25) \qquad (3)$$

Though the value of the left-hand side term of the above formula (3) is usually 0.65, it is preferably 0.7, more preferably 0.75. The closer to 1 the value is, the more preferable. In other words, the value of I(125)/I(25) is preferably 0.65 or larger, more preferably 0.7 or larger, still more preferably 0.75 or larger, and the closer to 1 it is, the more preferable. It is hardly possible that the value exceeds 1, but it may be larger than 1 from some reason. However, when the value exceeds 1.5, a color shift may have occurred due to a temperature change.

Furthermore, it is preferable that the value of I(160)/I(25) satisfies the formula (4) below. In the formula (4), I (160) represents the emission-peak intensity of the phosphor when excited with light of 400-nm wavelength at 160°C.

$$0.5 \leq I(160)/I(25) \quad (4)$$

Though the value of the left-hand side term of the above formula (4) is 0.5, it is preferably 0.58, more preferably 0.6. The closer to 1 the value is, the more preferable. In other words, the value of I(160)/I(25) is preferably 0.5 or larger, more preferably 0.58 or larger, still more preferably 0.6 or larger, and the closer to 1 it is, the more preferable. It is hardly possible that the value exceeds 1, but it may be larger than 1 from some reason. However, when the value exceeds 1.5, a color shift may have occurred due to a temperature change.

The above-mentioned temperature characteristics can be examined as follows, for example, using a multichannel spectrum analyzer, MCPD7000, manufactured by Otsuka Electronics Co., Ltd. as emission spectrum measurement device, a luminance colorimeter, BM5A, as brightness measurement device, a stage equipped with a cooling mechanism using a peltiert device and a heating mechanism using a heater, and a light source device equipped with a 150-W xenon lamp. A cell holding a phosphor sample is put on the stage, and the temperature is changed within the range from 20°C to 180°C. After verifying the surface temperature of the phosphor is held constant at 25°C, 125°C, or 160°C, the emission spectrum of the phosphor is measured by exciting it with a light from the light source having 400-nm wavelength which is separated using a diffraction grating. Then the emission-peak intensity is decided from the measured emission spectrum. At this point, as the measurement value of the surface temperature of the phosphor on the side irradiated with the excitation light, is used a value corrected by temperature values measured with a radiation thermometer and a thermocouple.

Conventionally, with a large amount of Eu, brightness improves in return for decrease in temperature characteristics, and with a small amount of Eu, temperature characteristics improves in return for decrease in brightness.
In contrast, in the phosphor of the present invention, a good balance between the temperature characteristics and the brightness can be achieved by using a relatively small amount of Eu and performing a multistep firing, which can promote particles growth.

[Object color]

The phosphor of the present invention has usually a white object color.

[Durability]

The phosphor of the present invention maintains stability in a durability test at a temperature of 85°C and relative humidity of 85% usually for over 200 hrs or longer, preferably for 500 hrs or longer, more preferably for 600 hrs or longer, and particularly preferably for 800 hrs or longer. In such a case, the longer the time for which it is stable is, the more preferable. However, it is usually fully sufficient for it to be stable for as long as 1000 hrs. In this context, the word "stable" means that the ratio of the emission intensity after the durability test to that before the durability test is 50 % or higher. Such durability can be measured by carrying a current of 20 mA at a temperature of 85°C and relative humidity of 85% using an LED aging system manufactured by Yamakatsu Electronics Industry Co., Ltd. The measurement can be performed using other similar equipment.

[Solubility]

It is preferable that the phosphor of the present invention is insoluble in water, and further, hardly soluble in 1N hydrochloric acid. In this context, "insoluble" means not only a hundred percent insolubility but also a very low electric conductivity of the extraction liquid. Specifically, the electric conductivity of the phosphor of the present invention, measured on a liquid extracted by adding 100 g of boiling purified water to 5 g of the phosphor, is usually 6 mS/m or lower, preferably 3 mS/m or lower, more preferably 2 mS/m or lower.

[2. Production method of phosphor of the present invention]

There is no limitation on the production method of phosphor of the present invention, and any production method can be used insofar as the advantage of the present invention is not significantly impaired. However, by producing a phosphor represented by the above-mentioned formula (1) in accordance with a production method (hereinafter also referred to as "production method of the present invention") described below, a phosphor of the present invention having the above-mentioned characteristics can be usually obtained.
In the production method of the present invention, at least two firing steps are carried out in the firing process, and the second or subsequent firing step is performed in the presence of a flux. A detailed explanation of the production method of the present invention will be given below.
In the production method of the present invention, a phosphor of the present invention can be produced by firing a mixture of phosphor materials that is prepared to have the composition represented by the formula (1). As the phosphor materials, metal compounds are usually used. Namely, the phosphor of the present invention can be produced by weighing out the metal compounds so that they have a predetermined composition, mixing them, and then firing the mixture. For example, the phosphor represented by the above-mentioned formula (1) can be produced by mixing an appropriate combination of materials (mixing process) selected from: material of Sr (hereinafter referred to as "Sr source" as appropriate); material of M (hereinafter referred to as "M source" as appropriate); material of Eu (hereinafter referred to as "Eu source" as appropriate); material of Mn (hereinafter referred to as "Mn source" as appropriate); material of $PO_4$ (hereinafter referred to as "$PO_4$ source" as appropriate); material of Cl (hereinafter referred to as "Cl source" as appropriate); and material of Q (hereinafter referred to as "Q source" as appropriate), and firing the obtained mixture (firing process).

[2-1. Phosphor material]

Examples of materials used to produce the phosphor of the present invention (namely, Sr source, M source, Eu source, Mn source, $PO_4$ source, Cl source, and Q source) include oxides, hydroxides, carbonates, nitrates, sulfates, oxalates, carboxylates, and halides of each element of Sr, M, Eu, Mn, $PO_4$, Cl, and Q. Of these compounds, preferable ones can be selected as appropriate in light of reactivity into complex oxynitrides and the amount of $NO_x$, $SO_x$, or the like generated at the time of firing.

(Sr source)

Examples of the above-mentioned Sr source are as follows.
Examples of raw material containing Sr (hereinafter referred to as "Sr source" as appropriate) include: SrO, Sr $(OH)_2 \cdot 8H_2O$, $SrCO_3$, $Sr(NO_3)_2 \cdot 4H_2O$, $SrSO_4$, $Sr(OCO)_2 \cdot H_2O$, $Sr(C_2O_4) \cdot H_2O$, $Sr(OCOCH_3)_2 \cdot 0.5H_2O$, $SrCl_2$, $Sr_3N_2$, and SrNH. Of these, $SrCO_3$ is preferable. This is because it is stable in air and easily decomposed by heat hardly leaving undesirable elements, and further, its highly purified material is easily available. When carbonate is used as the material, it is possible to calcine the carbonate preliminarily before used as material.

(M source)

Examples of the above-mentioned M source can be listed as follows in terms of kinds of M.
Examples of raw material containing Ba (hereinafter referred to as "Ba source" as appropriate) include: BaO, $Ba(OH)_2 \cdot 8H_2O$, $BaCO_3$, $Ba(NO_3)_2$, $BaSO_4$, $Ba(OCO)_2 \cdot H_2O$, $Ba(OCOCH_3)_2$, $BaCl_2$, $Ba_3N_2$, and BaNH. Of these, carbonates, oxides, or the like can be preferably used. However, carbonates are more preferable from the standpoint of easy handling because oxides react easily with atmospheric water. Of these, $BaCO_3$ is preferable. This is because it is stable in air and easily decomposed by heat hardly leaving undesirable elements, and further, its highly purified material is easily available. When carbonate is used as the material, it is possible to calcine the carbonate preliminarily before used as material.
Examples of raw material containing Ca (hereinafter referred to as "Ca source" as appropriate) include: CaO, $Ca(OH)_2$, $CaCO_3$, $Ca(NO_3)_2 \cdot 4H_2O$, $CaSO_4 \cdot 2H_2O$, $Ca(OCO)_2 \cdot H_2O$, $Ca(OCOCH_3)_2 \cdot H_2O$, $CaCl_2$, $Ca_3N_2$, and CaNH. Of these, $CaCO_3$, $CaCl_2$, and the like are preferable. When carbonate is used as the material, it is possible to calcine the carbonate preliminarily before used as material.
Examples of raw material containing Mg (hereinafter referred to as "Mg source" as appropriate) include: MgO, $Mg(OH)_2$, basic magnesium carbonates ($mMgCO_3 \cdot Mg(OH)_2 \cdot nH_2O$), $Mg(NO_3)_2 \cdot 6H_2O$, $MgSO_4$, $Mg(OCO)_2 \cdot H_2O$, Mg $(OCOCH_3)_2 \cdot 4H_2O$, $MgCl_2$, $Mg_3N_2$, and MgNH. Of these, preferable are MgO and basic magnesium carbonates. When carbonate is used as the material, it is possible to calcine the carbonate preliminarily before used as material.
Examples of raw material containing Zn (hereinafter referred to as "Zn source" as appropriate) include zinc compounds (including their hydrates) such as ZnO, $ZnF_2$, $ZnCl_2$, $Zn(OH)_2$, $Zn_3N_2$, ZnNH, $Zn(OCO)_2$, and $ZnSO_4$. Of these, $ZnF_2 \cdot 4H_2O$ (or its anhydrate) and the like are preferable from the standpoint of high efficiency of promoting particles growth. When carbonate is used as the material, it is possible to calcine the carbonate preliminarily before used as material.

(Eu source)

Examples of the above-mentioned Eu source are as follows.

Examples of raw material containing Eu (hereinafter referred to as "Eu source" as appropriate) include: $Eu_2O_3$, $Eu_2(SO_4)_3$, $Eu_2(C_2O_4)_3 \cdot 10H_2O$, $EuCl_2$, $EuCl_3$, $Eu(NO_3)_3 \cdot 6H_2O$, EuN, and EuNH. Of these, $Eu_2O_3$, $EuCl_3$, and the like are preferable. $Eu_2O_3$ is particularly preferable.

(Mn source)

Examples of the above-mentioned Mn source are as follows.

Examples of Mn source include: $MnO_2$, $Mn_2O_3$, $Mn_3O_4$, MnO, $Mn(OH)_2$, $MnCO_3$, $Mn(NO_3)_2$, $Mn(OCOCH_3)_2 \cdot 2H_2O$, $Mn(OCOCH_3)_3 \cdot nH_2O$, and $MnCl_2 \cdot 4H_2O$. Of these, carbonates, oxides, or the like can be preferably used. However, carbonates are more preferable from the standpoint of easy handling because oxides react easily with atmospheric water. Of these, $MnCO_3$ is preferable. This is because it is stable in air and easily decomposed by heat hardly leaving undesirable elements, and further, its highly purified material is easily available. When carbonate is used as the material, it is possible to calcine the carbonate preliminarily before used as material.

($PO_4$ source)

Examples of the above-mentioned $PO_4$ source are as follows.

Examples of $PO_4$ source include: hydrogen phosphates of elements such as Sr, M, Mn, or $NH_4$; phosphates; metaphosphates; pyrophosphates; $P_2O_5$; $PX_3$; $PX_5$; phosphoric acid; methaphosphoric acid; and pyrophosphoric acid. Here, X represents a halogen element. Of these, hydrogen phosphates, metaphosphates and the like can be preferably used. Particularly preferable are $SrHPO_4$, $CaHPO_4$, and $BaHPO_4$. This is because they have high reactivity in the firing process.

(Cl source)

Examples of the above-mentioned Cl source are as follows.

Examples of Cl source include: chlorides, chlorates, and perchlorate of constituent elements of the phosphor. Of these, chlorides of constituent elements of the phosphor are preferable. This is because they have high reactivity in the firing process and have the effect of promoting particle growth.

(Q source)

Examples of the above-mentioned Q source can be listed as follows in terms of kinds of Q.

Examples of F material (hereinafter referred to as "F source" as appropriate) include fluorine compounds of constituent elements of the phosphor. This is because they have high reactivity in the firing process and have the effect of promoting particle growth.

Examples of Br material (hereinafter referred to as "Br source" as appropriate) and I material (hereinafter referred to as "I source" as appropriate) include: those compounds listed as examples of Cl source in each of which Cl is replaced by Br or I.

Each of the above-mentioned Sr source, M source, Eu source, Mn source, $PO_4$ source, Cl source, and Q source can be used either as a single kind thereof or as a mixture of two or more kinds in any combination and in any ratio.

[2-2. Production method of phosphor: mixing process]

The phosphor materials are weighed out so that the desired composition can be obtained and mixed well using a ball mill or the like (mixing process).

No particular limitation is imposed on the method of the above mixing. Specifically, methods (A) and (B) described below can be used.

(A) Dry-type mixing methods in which the above-mentioned phosphor materials are pulverized and mixed by combining pulverization, which is done by means of a dry-type pulverizer such as a hammer mill, roll mill, ball mill and jet mill, or pestle / mortar, and mixing, which is done by means of a mixing apparatus such as ribbon blender, V type blender and Henschel mixer, or pestle / mortar.

(B) Wet-type mixing methods in which solvents or dispersion media such as water are added to the above-mentioned phosphor materials, and mixing is done by means of a pulverizer, pestle / mortar, evaporation dish / stirring rod or the like, to make a solution or slurry, followed by drying by such methods as spray drying, heated drying or air drying.

Mixing of the phosphor materials can be done either by a wet-type method or a dry-type method mentioned above. Preferable is a wet-type method using water or ethanol.

[2-3. Production method of phosphors: firing step]

The phosphor of the present invention is produced by multistep firing including two or more firing processes. The firing conditions are usually different between the first firing (hereinafter referred to as "primary firing") and the second (hereinafter referred to as "secondary firing") and subsequent firings.

[2-3-1. Primary firing]

In the primary firing, the material mixture obtained in the mixing process is fired (primary firing process).
There is no limitation on the specific procedure of the firing. Usually, the material mixture obtained in the mixing process is filled into an alumina firing vessel and then the firing vessel containing the mixture therein is fired. As the firing vessel can be used not only alumina crucibles but also various heat-resistant vessels, such as crucibles or trays, which are made of materials unlikely to react with each phosphor material. Examples of materials that can be used for the firing vessel in addition to alumina include: ceramics such as quartz, boron nitride, silicon nitride, silicon carbide, magnesium, and mullite; and carbon (graphite) and the like. Of these, heat-resistant vessels made of quartz can be used for heat treatment at relatively low temperatures such as 1200°C or lower, and the preferable temperature range of its use is 1000°C or lower.
There is no special limitation on the firing atmosphere in the primary firing, insofar as a phosphor of the present invention can be obtained. Usually, an oxidizing atmosphere is used. Examples of gases (hereinafter referred to as "oxidizing gases") used to form such an oxidizing atmosphere include: air, mixed gas of air and nitrogen, and mixed gas of oxygen and nitrogen or the like. Of these, preferable is air.
The above oxidizing gases can be used by being mixed with inert gases such as nitrogen, rare gases, or flons. In such a case, the ratio (molar ratio) of the oxidizing atmosphere gas relative to the total amount of the gas is usually 5% or higher, preferably 10% or higher, and usually 30% or lower. When the ratio falls below the above range, the carbonate or the like used as the phosphor material may not be fully oxidized, leading possibly to failure in obtaining high purity oxides. When it exceeds the above range, safety at the time of firing may decrease.
The oxidizing atmosphere gas and inert gas can be used either as a single one or as a mixture of more than one kind in any combination and in any ratio, respectively.
The firing temperature (maximum heating temperature) of the primary firing is usually 950°C or higher, preferably 1000°C or higher, and usually 1200°C or lower, preferably 1150°C or lower. When the firing temperature falls below the above range, the carbonates and the like used as the phosphor materials may not be decomposed oxidatively. When the firing temperature exceeds the above range, the phosphor particles may be fused together to form coarse particles. In addition, the temperature rising rate is usually 2 °C/min or faster, preferably 3 °C/min or faster, and usually 10 °C/min or slower, preferably 5 °C/min or slower. When the temperature rising rate falls below the above-mentioned range, the firing time may be prolonged. When the temperature rising rate exceeds the above-mentioned range, the firing instrument, vessel, or the like may be damaged.
The firing time of the primary firing depends on the temperature, pressure, or the like of the firing. It is usually 10 mins or longer, preferably 1 hr or longer, and usually 24 hrs or shorter, preferably 6 hrs or shorter.
There is no special limitation on the pressure at the time of primary firing because it depends on the firing temperature or the like. However, it is usually 0.01 MPa or higher, preferably 0.1 MPa or higher, and the upper limit thereof is usually 10 MPa or lower. Industrially, it is preferably around from atmospheric pressure to 1 MPa from the standpoint of cost and convenience.
By performing the above-mentioned primary firing, a fired product (fired cake) of the material mixture is obtained. Such a primary fired product, which is a mixture of oxides and/or halide phosphates including crystal nuclei of the phosphor of the present invention, obtained by a primary firing performed in an oxidizing atmosphere is still a phosphor with insufficient extent of reduction of the activation element valence or amount of the crystal phase in many cases. Therefore, the phosphor of the present invention can be obtained after performing secondary and/or tertiary firing on the fired product (precursor composition) obtained by the primary firing.

[2-3-2. Secondary firing]

After the primary firing, the obtained fired product is subjected to a secondary firing (secondary firing process). Before performing the second firing (secondary firing), it is preferable to pulverize the fired product obtained in the primary firing with a pulverizer or the like such as exemplified for the mixing process and mix it well with a flux such as strontium chloride. Also in the secondary firing, usually, the fired product is filled into a firing vessel and then the firing vessel containing the fired product is fired, in the same way as the primary firing. As the firing vessel, those exemplified for the primary firing can also be used, for example.

There is no special limitation on the firing atmosphere in the secondary firing, insofar as a phosphor of the present invention can be obtained. Usually, a reducing atmosphere is used. From the standpoint of emission intensity, it is preferable that the valency of the activation element contained in a phosphor is mostly bivalent. It is preferable to perform a firing under a reducing atmosphere because Eu, which are $Eu^{3+}$ in the phosphor materials, is reduced to $Eu^{2+}$.

Examples of the gas used to form a reducing atmosphere (hereinafter referred to as "reducing gas") include: hydrogen and carbon monoxide. These gases can be used alone, but they are usually used as a mixture with an inert gas. Examples of the inert gas include: nitrogen and argon. Hydrogen-containing nitrogen gas is preferable from a practical standpoint.

When using a mixed atmosphere of an inert gas and a reducing gas, the ratio (molar ratio) of the reducing gas relative to the total amount of the gas is usually 0.5% or higher, preferably 2% or higher, more preferably 3% or higher. When the ratio falls below the above range, the fired product obtained in the primary firing may not be reduced sufficiently.

The reducing gas and inert gas can be used either as a single one or as a mixture of more than one kind in any combination and in any ratio, respectively.

The firing temperature (maximum heating temperature) of the secondary firing is usually 950°C or higher, preferably 1000°C or higher, and usually 1200°C or lower, preferably 1150°C or lower. When the firing temperature falls below the above range, $Eu^{3+}$ may not be fully reduced to $Eu^{2+}$ and thus $Eu_2O_3$ may remain. When the firing temperature exceeds the above range, a fused material may be formed.

In addition, the temperature rising rate is usually 2 °C/min or faster, preferably 3 °C/min or faster, and usually 10 °C/min or slower, preferably 5 °C/min or slower. When the temperature rising rate falls below the above-mentioned range, the firing time may be prolonged. When the temperature rising rate exceeds the above-mentioned range, the firing instrument, vessel, or the like may be damaged.

The firing time of the secondary firing depends on the temperature, pressure, or the like of the firing. It is usually 10 mins or longer, preferably 1 hr or longer, and usually 24 hrs or shorter, preferably 6 hrs or shorter.

There is no special limitation on the pressure at the time of secondary firing because it depends on the firing temperature or the like. However, it is usually 0.01 MPa or higher, preferably 0.1 MPa or higher, and the upper limit thereof is usually 10 MPa or lower. Industrially, it is preferably around from atmospheric pressure to 1 MPa from the standpoint of cost and convenience.

Such a secondary firing affords a fired product in which the fired product (precursor composition) obtained by the primary firing is reduced.

The fired product obtained by the secondary firing may be fired further. In such a case, the fired product obtained by the secondary firing can be subjected to the third firing (tertiary firing) after pulverizing it with a pulverizer or the like such as exemplified for the mixing process and mixing it well with a flux such as strontium chloride.

[2-3-3. Tertiary and subsequent firings]

The more the firings are performed, the larger the crystal of the fired product, obtained by the firing process, grows. Therefore, for forming large size single grains, further firing processes may be performed repeatedly even after the secondary firing. When the particle diameter is increased suitably, external quantum efficiency is improved, which gives a phosphor having high emission efficiency. This is preferable. Tertiary and subsequent firings can be performed under the same conditions as those of the secondary firing.

At this point, the more the firing processes are repeated, the higher the production cost will be. Therefore, it is preferable to perform optimal numbers of firings in light of both the resultant single grain size and the cost. From this standpoint, the number of times the firing process is repeated is usually 7 or smaller, preferably 5 or smaller. For example when a phosphor is prepared from materials exemplified in the section [2-1. Phosphor material], it is preferable to perform firings up to the third (tertiary) firing.

Repeating firings a desired number of times completes the firing process. A phosphor of the present invention can be obtained from the fired product which is given by such a firing process after being subjected to post-treatments described later or the like.

[2-3-4. Crushing process]

Particles of the fired product obtained may be frequently aggregated after the primary firing, secondary firing, and tertiary and subsequent firings mentioned above. This is probably because solid state reactions proceed at contact portions between particles of the materials, fired product or the like and each particle undergo sintering. Since a fired product in such a state can not be fired, washed, or used appropriately in the subsequent processes, it is preferable to perform crushing of it after the primary firing, secondary firing, and tertiary and subsequent firings mentioned above. There is no limitation on the specific method of crushing. For example, it is preferable to use pulverizers or the like exemplified for the mixing process to perform crushing.

[2-3-5. Material addition process]

Material may be added during the respective firing processes or between them, of the above-mentioned primary, secondary, tertiary and subsequent firings, if necessary. For example when a phosphor of the present invention is produced using strontium carbonate, strontium hydrogenphosphate, europium oxide, and strontium chloride as materials, the strontium chloride may be added to the fired product after the primary firing and before the secondary firing. In this case, it can be added in more than its stoichiometric ratio. In this way, an advantageous effect of improvement in particles crystallinity can be achieved.

[2-4. Flux]

In the production method of the present invention, a flux is let coexist in the reaction system in at least one firing out of secondary and subsequent firings. For example when up to the tertiary firing is performed, it is preferable to perform the primary firing in the absence of flux, and perform either secondary or tertiary firing in the presence of a flux. It is particularly preferable to let a flux coexist in both the secondary and tertiary firings. In this way, it usually follows that the flux is used after nucleations of phosphor crystals. This makes it possible for single grains to grow effectively.
No particular limitation is imposed on the kind of flux. It is preferable that a compound is used as flux, which is selected from the group consisting of compounds including monovalent element or atomic group and minus monovalent element, compounds including monovalent element or atomic group and minus trivalent element or atomic group, compounds including bivalent element and minus monovalent element, compounds including bivalent element and minus trivalent element or atomic group, compounds including trivalent element and minus monovalent element, and compounds including trivalent element and minus trivalent element or atomic group.
The monovalent element or atomic group is preferably at least one kind of element selected from the group consisting of, for example, alkali metal elements and ammonium group ($NH_4$). More preferably it is cesium (Cs) or rubidium (Rb).
The bivalent element is preferably at least one kind of element selected from the group consisting of, for example, alkaline-earth metal elements and zinc (Zn). More preferably it is strontium (Sr) or barium (Ba).
The trivalent element is preferably at least one kind of element selected from the group consisting of, for example, rare-earth elements such as lanthanum (La), yttrium (Y), aluminum (Al) and scandium (Sc). More preferably it is yttrium (Y) or aluminum (Al).
The minus monovalent element is preferably at least one kind of element selected from the group consisting of, for example, halogen elements. Chlorine (Cl) or fluorine (F) is more preferable.
The minus trivalent element or atomic group is preferably phosphate group ($PO_4$), for example.
Among above, it is preferable that a compound is used as flux, which is selected from the group consisting of alkali metal halides, alkaline-earth metal halides, zinc halides, halides of trivalent element selected from the group consisting of yttrium (Y), aluminium (Al), scandium (Sc) and rare-earth elements, alkali metal phosphates, alkaline-earth metal phosphates, zinc phosphates, and phosphates of trivalent element selected from the group consisting of yttrium (Y), aluminium (Al), lanthanum (La) and scandium (Sc).
The specific examples include: ammonium halides such as $NH_4Cl$ and $NH_4F{\cdot}HF$; alkali metal carbonates such as $NaCO_3$ and $LiCO_3$[SIC]; alkali metal halides such as LiCl, NaCl, KCl, CsCl, LiF, NaF, KF and CsF; alkaline earth metal halides such as $CaCl_2$, $BaCl_2$, $SrCl_2$, $CaF_2$, $BaF_2$ and $SrF_2$; alkaline earth metal oxides such as CaO, SrO and BaO; boron oxides, boric acids and boric acid salts such as $B_2O_3$, $H_3BO_3$ and $NaB_4O_7$; phosphates such as $Li_3PO_4$ and $NH_4H_2PO_4$; aluminum halides such as $AlF_3$; zinc compounds such as zinc halide like $ZnCl_2$ and $ZnF_2$, zinc oxides and zinc sulfates; compounds of the 15th group elements of the periodic table such as $Bi_2O_3$; and nitrides of alkali metals, alkaline earth metals or the 13th group elements such as $Li_3N$, $Ca_3N_2$, $Sr_3N_2$, $Ba_3N_2$ and BN. Of these, preferable are halides. More preferable are alkali metal halides, alkaline earth metal halides and Zn halides. Of these halides, fluorides and chlorides are preferable.
The amount of flux used differs depending on the raw material kind or flux material. It is preferably, relative to 1 mol of the phosphor of the formula (1), in the range of usually 0.01 mole percent or more, preferably 0.1 mole percent or more, more preferably 2 mole percent or more, and usually 20 mole percent or less, preferably 15 mole percent or less. When the amount of the flux is too small, the effect of flux may not be exhibited. When the amount of the flux is too large, the effect of flux may be saturated, or it may be taken up into crystal nuclei, resulting possibly in the change in luminescent color and decrease in brightness. These fluxes can be used either as a single one or as a mixture of two or more kinds in any combination and in any ratio.

[2-5. Discussion on reaction occurring in production method of the present invention]

In the production method of the present invention, the non-luminous object color of the fired product obtained after the primary firing is usually white with a reddish tint (pale pink). As the firing progresses to the secondary and tertiary, the color fades and becomes close to white. This is probably due to the fact that Eu, which is present as trivalent ions $Eu^{3+}$ after the primary firing, is reduced to $Eu^{2+}$ in the fired products after the secondary and tertiary firings.
In the secondary firing, $Eu^{3+}$ is reduced to $Eu^{2+}$, and $Eu^{2+}$ probably occupies $Sr^{2+}$ site of the Sr chloroapatite. Crystal nuclei of $Eu^{2+}$-activated Sr chloroapatite phosphors are thereby formed, which are the object compounds.
In addition, in the production method of the present invention, particle growth of the above-mentioned crystal nuclei is accelerated by performing the secondary and/or subsequent firings in a reducing atmosphere in the presence of a flux. At this point, it is probable that the above-mentioned flux effect can be obtained not by using the flux in the primary firing but in the secondary and/or subsequent firings. When firing is done for example in the primary firing using a flux such as $SrCl_2$ without forming the above crystal nuclei, there is a tendency that microcrystals are fused together to form particles with a low degree of circularity, particle size distribution of the primary particles is broadened, or particles with low crystallinities and indistinct crystal habits are formed.
In this way, in the production method of the present invention, a phosphor of the present invention can be obtained whose crystalline particles (primary particles) are high in crystallinity, distinct in crystal habit, narrow in particle diameter distribution, and high in degree of circularity, probably because the firing is performed in the presence of a flux during or after the formation of the above-mentioned crystal nuclei.
It is particularly preferable to perform firing in the presence of a flux after the formation of crystal nuclei, from the standpoint of obtaining higher crystallinity. For example when firings are performed three times, each using a flux of $SrCl_2$, as in Examples to be described later, the $SrCl_2$ added in the system of the primary firing is charged stoichiometrically and used to form the crystal nuclei. On the other hand, the $SrCl_2$ present in the system of the secondary and tertiary firing, namely, the system after being formed with the crystal nuclei, functions as the flux.

[2-6. Post-treatment]

Steps other than described above can also be carried out in the production method of the present invention if necessary. For example, a pulverization step, washing step, classification step, surface treatment step, drying step or the like can be carried out if necessary after the above-mentioned firing step.

· Pulverization step

In the pulverization step, pulverizers such as those listed in the mixing process of the materials can be used. For example, a hammer mill, roll mill, ball mill, jet mill, ribbon blender, V type blender, and Henschel mixer, or pestle / mortar can be used.
For the sake of crushing the secondary particles while preventing destruction of the phosphor crystals generated, it is preferable to perform a ball milling using a container made of, for example, alumina, silicon nitride, $ZrO_2$, glass or the like and balls made of the same material as the container, iron-core urethane, or the like in the container for on the order of 10 minutes to 24 hours. In this case, a dispersant such as an organic acid or a alkaline phosphate like hexametaphosphate can be used at 0.05 weight % to 2 weight %.

· Washing step

Washing step can be done using, for example, water such as deionized water, organic solvent such as ethanol, or alkaline aqueous solution such as ammonia water. Further, for example for removing the flux used in the firing process, aqueous solution of an inorganic acid such as hydrochloric acid, nitric acid or sulfuric acid, or of an organic acid such as acetic acid can be used. In such a case, it is preferable that, after washing with an acidic aqueous solution, an additional washing is carried out with water.
It is preferable to perform washing to the extent that the pH of the supernatant fluid obtained by dispersing the fired product, after washing it, in water which is 10 times as heavy as the phosphor and leaving it to stand for 1 hour becomes neutral (pH of around 5 to 9). This is because a deviation toward basicity or acidity of the above-mentioned supernatant fluid may affect the liquid medium to be described later or the like when the phosphor is mixed with the liquid medium or the like.
The above-mentioned degree of washing can also be indicated by the electric conductivity of the supernatant fluid that is obtained by dispersing the washed phosphor in water which is 10 times as heavy as the phosphor and leaving it to stand for 1 hour. The lower the electric conductivity is, the more preferable, from the standpoint of higher luminescent characteristics. However, also in consideration of the productivity, it is preferable to repeat the washing treatments until the electric conductivity is usually 10 mS/m or lower, preferably 5 mS/m or lower, and more preferably 4 mS/m or lower.

The method for measuring the electric conductivity is as follows. The phosphor particles, which have larger specific gravity than water, are allowed to precipitate spontaneously, by leaving them to stand for 1 hour after they are stirred in water which is 10 times as heavy as the phosphor for a predetermined period of time, for example, 10 minutes. The electric conductivity of the supernatant fluid at that time may be measured using a conductance meter, "EC METER CM-30G", manufactured by DKK-TOA CORPORATION or the like. There is no special limitation on the water used for the washing treatment and measurement of the electric conductivity, but desalted water or distilled water is preferable. Among them, the one having low electric conductivity is particularly preferable. Its electric conductivity should be usually 0.0064 mS/m or higher, and usually 1 mS/m or lower, preferably 0.5 mS/m or lower. The measurement of the electric conductivity is usually carried out at a room temperature (around 25°C).

· Classification step

Classification step can be done by, for example, water-sieve, or using various classifiers such as air current classifier or vibrating sieve. Particularly, a dry classification using a nylon mesh can be preferably used to obtain a phosphor with a weight median diameter of 20 μm or smaller.

In addition, combination of a dry classification using nylon mesh and elutriation treatment can obtain the phosphor of good dispersibility with weight median diameter of 7.5 μm or larger and 20 μm or smaller.

In a water-sieve or elutriation treatment, phosphor particles are usually dispersed in an aqueous medium at a concentration of around 0.1 weight % to 10 weight %. Also in a water-sieve or elutriation treatment, in order to prevent the alteration of the phosphor, the pH of the aqueous medium is set at usually 4 or larger, preferably 5 or larger, and usually 9 or smaller, preferably 8 or smaller. In addition, for achieving the phosphor with weight median diameter such as described above by a water-sieve or elutriation treatment, it is preferable to perform two-step sieving in which, for example, particles of 50 μm or smaller are sifted out and then particles of 30 μm or smaller are sifted out, in terms of balance between the operating efficiency and the yield. Regarding the lower limit of sieving, it is preferable to sift out particles of usually 1 μm or larger, and preferably 5 μm or larger.

· Drying step

It is preferable to perform drying step after the washing step. There is no special limitation on a method used in the drying step. It is preferable to select an appropriate drying treatment method in accordance with the characteristics of the phosphor, if necessary.

· Surface treatment step

When the phosphor of the present invention obtained by the above-mentioned procedure is used to manufacture a light emitting device by a method described later, the surface of the phosphors may be subjected to surface treatment if necessary such as covering the surfaces with different compound, in order to improve weatherability such as moisture resistance or to improve dispersibility in a resin in the phosphor-containing part of the light emitting device described later.

Examples of the substance that can be applied to the phosphor surface (hereinafter referred to as "surface treatment substance" as appropriate) include: organic compounds, inorganic compounds, and glass materials.

Examples of the organic compounds include: thermofusible polymer such as acrylic resin, polycarbonate, polyamide and polyethylene; latex; and polyorganosiloxane.

Examples of the inorganic compounds include: metal oxides such as magnesium oxide, aluminum oxide, silicon oxide, titanium oxide, zirconium oxide, tin oxide, germanium oxide, tantalum oxide, niobium oxide, vanadium oxide, boron oxide, antimony oxide, zinc oxide, yttrium oxide and bismuth oxide; metal nitrides such as silicon nitride and aluminum nitride; orthophosphates such as calcium phosphate, barium phosphate and strontium phosphate; polyphosphate; and combinations of calcium salt and phosphates of alkali metals and/or alkaline-earth metals such as a combination of calcium nitrate and sodium phosphate.

Examples of the glass material include: boron silicate, phosphorus silicate, and alkali silicate.

These surface treatment substances can be used either as a single one or as a combination of two or more kinds in any combination and in any ratio.

The phosphor of the present invention obtained by the surface treatment mentioned above has a surface treatment substance existing on its surface. The mode of existence of the surface treatment substance can be as follows, for example.

(i) The above surface treatment substance constitutes a continuous layer and covers the surface of the phosphor.
(ii) The above surface treatment substance is attached to the surface of the phosphor as numerous microparticles and these microparticles cover the surface of the phosphor.

There is no special limitation on the amount of the surface treatment substance which can cover or be attached to the surface of the phosphor, insofar as the advantage of the present invention is not significantly impaired. However, the amount, relative to the weight of the phosphor, is usually 0.01 weight % or more, preferably 0.1 weight % or more, more preferably 5 weight % or more, still more preferably 10 weight % or more, and usually 50 weight % or less, preferably 30 weight % or less, more preferably 20 weight % or less. When the amount of the surface treatment substance relative to that of the phosphor is too large, the luminescent characteristics of the phosphor may be impaired. When it is too small, the coverage of the surface may be insufficient, and moisture resistance and dispersibility may not be improved.
There is no special limitation on the film thickness (layer thickness) of the surface treatment substance formed by the surface treatment, insofar as the advantage of the present invention is not significantly impaired. However, it is usually 10 nm or larger, preferably 50 nm or larger, and usually 2000 nm or smaller, preferably 1000 nm or smaller. When the layer is too thick, the luminescent characteristics of the phosphor may be impaired. When it is too thin, the coverage of the surface may be insufficient, and moisture resistance and dispersibility may not be improved.
No particular limitation is imposed on the method of such surface treatment. The examples include the following coating treatment method using a metal oxide (silicon oxide).
The phosphor of the present invention is added to an alcohol such as ethanol, mixed and stirred. To this is added an alkaline aqueous solution such as ammonia water, followed by stirring. A hydrolyzable alkyl silicic acid ester such as tetraethyl orthosilicate is then added and the mixture is stirred. The solution obtained is allowed to stand for 3 to 60 minutes, and then the supernatant containing silicon oxide particles which remain unattached to the surface of the phosphor is removed by pipetting or the like. Then, mixing in alcohol, stirring, allowing to stand and removal of the supernatant are repeated several times and a drying is performed under a reduced pressure at 120°C to 150°C for 10 minutes to 5 hours, for example 2 hours. Thereby, a surface-treated phosphor is obtained.
Examples of other surface treatment methods of phosphors include: various known methods such as a method in which spherical silicon oxide fine powder is attached to the phosphor (Japanese Patent Laid-Open Publications No. Hei 2-209989 and No. Hei 2-233794), a method in which a coating film of Si-compound is attached to the phosphor (Japanese Patent Laid-Open Publication No. Hei 3-231987), a method in which the surface of the phosphor is covered with polymer microparticles (Japanese Patent Laid-Open Publication No. Hei 6-314593), a method in which the phosphor is coated with organic, inorganic, glass and the like materials (Japanese Patent Laid-Open Publication No. 2002-223008), a method in which the surface of the phosphor is covered by means of chemical vapor reaction (Japanese Patent Laid-Open Publication No. 2005-82788), and a method in which particles of a metal compound is attached (Japanese Patent Laid-Open Publication No. 2006-28458).

[3. Use of phosphor]

The phosphor of the present invention can be used for any purposes that use a phosphor. The phosphor of the present invention can be used singly. Otherwise, it can be used as any combination of phosphor mixture, such as a combination of two or more kinds of phosphors of the present invention, or a combination of a phosphor of the present invention and another phosphor.
The phosphor of the present invention can be used preferably for various light emitting devices (namely, "light emitting device of the present invention" to be described later), particularly making the most of such a characteristic that it can be excited by a near-ultraviolet light. Since phosphors of the present invention usually emit blue light, a light emitting device emitting blue green, green, or yellow green light can be produced by combining an excitation light source emitting ultraviolet light, a phosphor emitting green light with a phosphor of the present invention, for example. In addition, a white light emitting device can be produced by combining an excitation light source emitting near-ultraviolet light, a phosphor emitting red light, a phosphor emitting green light with a phosphor of the present invention.
The luminescent colors of such light emitting devices are not limited to white. By selecting combination or content of phosphors appropriately, light emitting devices emitting any color of light, such as light-bulb color (warm white) or pastel color, can also be produced. The light emitting devices thus obtained can be used for lighting systems or illuminant portions of image displays (especially, back-lightings of liquid crystal displays).

[4. Phosphor-containing composition]

The phosphor of the present invention can be used as a mixture with a liquid medium. Particularly when the phosphor of the present invention is used for a light emitting device or the like, it is preferably used as a dispersion in a liquid medium. The phosphor of the present invention that is dispersed in a liquid medium will be referred to as "phosphor-containing composition of the present invention" as appropriate.

[4-1. Phosphor]

There is no limitation on the type of the phosphor of the present invention to be contained in the phosphor-containing composition of the present invention, and any of that can be selected from those described above. The phosphor of the present invention to be contained in the phosphor-containing composition of the present invention can be used as a single kind thereof or as a mixture of two or more kinds in any combination and in any ratio. Furthermore, in the phosphor-containing composition of the present invention, a phosphor other than the phosphor of the present invention can be contained, insofar as the advantage of the present invention is not significantly impaired.

[4-2. Liquid medium]

There is no special limitation on the kind of a liquid medium used for the phosphor-containing composition of the present invention, insofar as the performance of the phosphor can be sufficient enough to achieve the object of the present invention. For example, any inorganic material and/or organic material can be used, insofar as it exhibits liquid characteristics under a desired use condition and lets the phosphor of the present invention be dispersed preferably without any unfavorable reaction.

Examples of the inorganic materials include metal alkoxide, ceramic precursor polymer, a solution obtained by hydrolytic polymerization of a solution containing metal alkoxide using a sol-gel method, or inorganic material obtained by combining such materials (such as an inorganic material containing siloxane bond).

Examples of the organic materials include thermoplastic resin, thermosetting resin and light curing resin. More specifically, the examples include: methacrylic resin such as polymethacrylate methyl; styrene resin such as polystyrene, styreneacrylonitrile copolymer; polycarbonate resin; polyester resin; phenoxy resin; butyral resin; polyvinyl alcohol; cellulose resin such as ethyl cellulose, cellulose acetate and cellulose acetate butyrate; epoxy resin; phenol resin; and silicone resin.

Of these, a silicon-containing compound can be preferably used from the standpoint of high heat resistance, high light resistance and the like, particularly when the phosphor is used for a high-power light emitting device such as an illuminating device.

Silicon-containing compound means a compound of which molecular contains a silicon atom. Examples thereof include organic materials (silicone materials) such as polyorganosiloxane, inorganic materials such as silicon oxide, silicon nitride and silicon oxynitride, glass materials such as borosilicate, phosphosilicate and alkali silicate. Among them, silicone materials are preferably used from the standpoint of ease in handling or the like.

The above-mentioned silicone material usually indicates organic polymers having a siloxane bond as the main chain. Examples thereof include compounds represented by the following formula (i) and/or mixtures of them.

[Chemical Formula 1]

$$(R^1R^2R^3SiO_{1/2})_M(R^4R^5SiO_{2/2})_D(R^6SiO_{3/2})_T(SiO_{4/2})_Q \quad \text{formula (i)}$$

In the above formula (i), $R^1$ to $R^6$ can be the same as or different from each other, and are selected from the group consisting of organic functional group, hydroxyl group and hydrogen atom.

In addition, M, D, T and Q of the above-mentioned formula (i) are each number of 0 or greater and smaller than 1, and they satisfies M+D+T+Q=1.

The silicone material can be used after being sealed with a liquid silicone material and cured by heat or light, when used for sealing a semiconductor luminous element.

When categorizing silicone materials based on the curing mechanism, they usually fall into such categories as addition polymerization-curable type, polycondensation-curable type, ultraviolet ray-curable type and peroxide vulcanized type. Of these, preferable are addition polymerization-curable type (addition type silicone material) and condensation-curable type (condensating type silicone material) and ultraviolet ray-curable type. In the following, addition type silicone material and condensating type silicone material will be explained.

Addition type silicone material represents a material in which polyorganosiloxane chain is crosslinked by means of organic additional bond. Typical examples thereof include a compound having a Si-C-C-Si bond as the crosslinking point, which can be obtained through a reaction between vinylsilane and hydrosilane in the presence of an addition type catalyst such as Pt catalyst. As such compounds, commercially available ones can be used. For example, as concrete commercial names of an addition polymerization-curable type can be cited "LPS-1400", "LPS-2410" and "LPS-3400", manufactured by Shin-Etsu Chemical Co., Ltd.

On the other hand, examples of a condensating type silicone material include a compound having an Si-O-Si bond as the crosslinking point, which can be obtained through hydrolysis and polycondensation of alkyl alkoxysilane. Examples thereof include: a polycondensate obtained by performing hydrolysis and polycondensation of compounds represented by the following general formula (ii) and/or (iii), and/or an oligomer thereof.

$$M^{m+}X_nY^1{}_{m-n} \qquad \text{(ii)}$$

(In the formula (ii), M represents at least one element selected from silicon, aluminum, zirconium and titanium, X represents a hydrolyzable group, $Y^1$ represents a monovalent organic group, m represents an integer of 1 or larger representing the valence of M, and n represents an integer of 1 or larger representing the number of X groups, where m≥n.)

$$(M^{s+}X_tY^1{}_{s-t-1})_uY^2 \qquad \text{(iii)}$$

(In the formula (iii), M represents at least one element selected from silicon, aluminum, zirconium and titanium, X represents a hydrolyzable group, $Y^1$ represents a monovalent organic group, $Y^2$ represents a u-valent organic group, s represents an integer of 1 or larger representing the valence of M, t represents an integer of 1 or larger and s-1 or smaller, and u represents an integer of 2 or larger.)

The condensating type silicone material may contain a curing catalyst. As the curing catalyst, a metal chelate compound can be used preferably, for example. The metal chelate compound preferably contains at least one kind selected from the group consisting of Ti, Ta and Zr, and more preferably contains Zr. The curing catalysts may be used either as a single kind thereof or as a mixture of more than one kind in any combination and in any ratio.

As such condensating type silicone material can be used preferably, for example, semiconductor light emitting device members disclosed in Japanese Patent Applications No. 2006-47274 to No. 2006-47277 and Japanese Patent Application No. 2006-176468.

In the following, particularly preferable ones among condensating type silicone materials will be explained. Silicone materials generally have such problems as low adhesiveness to the substrate at which the semiconductor luminous element and the element are disposed, the package and the like. However, as a silicone material with high adhesion can be especially preferably used a condensating type silicone material having one or more of the following characteristics [1] to [3].

[1] The silicon content is 20 weight % or more.

[2] In the solid Si-nuclear magnetic resonance spectrum (NMR), measured by a method to be described later in detail, it has at least one of Si-originated peaks of the following (a) and/or (b).

(a) A peak whose peak top position is in an area of a chemical shift of -40 ppm or more and 0 ppm or less, with reference to tetramethoxysilane, and whose full width at half maximum is 0.3 ppm or more and 3.0 ppm or less.

(b) A peak whose peak top position is in an area of a chemical shift of -80 ppm or more and less than -40 ppm, with reference to tetramethoxysilane, and whose full width at half maximum is 0.3 ppm or more and 5.0 ppm or less.

[3] The silanol content is 0.1 weight % or more and 10 weight % or less.

It is preferable that the silicone material in the present invention has the characteristic [1], among the above-mentioned characteristics [1] to [3]. It is more preferable that the silicone material has the above-mentioned characteristics [1] and [2]. It is particularly preferable that the silicone material has all the above-mentioned characteristics [1] to [3]. In the following, the above-mentioned characteristics [1] to [3] will be explained.

[Characteristic [1] (silicon content)]

The basic skeleton of a conventional silicone material is an organic resin such as an epoxy resin having carbon-carbon and carbon-oxygen bonds as its basic skeleton. In contrast, the basic skeleton of the silicone material of the present invention is an inorganic siloxane bond which is the same as that of a glass (silicate glass) or the like. As is evident from the chemical bond comparison in [Table 1] shown below, this siloxane bond has superior features as a silicone material, which are listed below.

(I) Light resistance is superior because the bond energy is large and thus pyrolysis and photolysis rarely occur.
(II) Electrically polarized slightly.
(III) The chain structure thereof has a high degree of freedom, and can lead to highly flexible structure and free rotation about the siloxane chain.
(IV) It is highly oxidized so that further oxidization is impossible.
(V) It is high in electrical insulating properties.

[Table 1]

| [Table 1: Chemical bond comparison table] | | | | |
|---|---|---|---|---|
| Bond | Bond distance [Å] | Bond energy [kcal/mol] | Bond angle [°] | |
| Si-O-Si | 1.64 | 108 | 130-160 | |
| C-O-C | 1.43 | 86 | 110 | |
| C-C-C | 1.54 | 85 | 109 | |

From these features, it can be understood that a silicone material based on a skeleton in which siloxane bonds are connected three-dimensionally with a high degree of crosslinking is similar to minerals such as glasses or rocks and can form a protective film that is excellent in heat resistance and light resistance. Particularly, a silicone material having a methyl group as a substituent, is superior in light resistance, because it does not have an absorption range in the ultraviolet region and therefore photolysis is unlikely to occur.

The silicon content in the silicone material that is preferable for the present invention is usually 20 weight % or more. However, it is particularly preferably 25 weight % or more, and more particularly preferably 30 weight % or more. On the other hand, the upper limit thereof is usually 47 weight %, because the silicon content of a glass, consisting only of $SiO_2$, is 47 weight %.

The silicon content of a silicone material can be calculated based on the result of inductively coupled plasma spectrometry (hereinafter abbreviated as "ICP" when appropriate) analysis, carried out in accordance with, for example, a method described below.

{Measurement of silicon content}

A silicone material is kept in a platinum crucible in the air at 450°C for 1 hr and then at 750°C for 1 hr and at 950°C for 1.5 hrs for firing. After removal of carbon components, the small amount of residue obtained is added with a 10-fold amount or more of sodium carbonate, and then heated by a burner to melt it. Then the melted product is cooled and added with deionized water, being diluted to several ppm in silicon, while adjusting pH value to around neutrality using hydrochloric acid. And then ICP analysis is performed.

[Characteristic [2] (solid Si-NMR spectrum)]

When measuring the solid Si-NMR spectrum of a silicone material preferable for the present invention, at least one, preferably two or more of peaks can be observed in the aforementioned peak regions (a) and/or (b), originating from a silicon atom directly bonded with a carbon atom of an organic group.

Summarizing in terms of chemical shifts, in a silicone material preferable for the present invention, the full width at half maximum of the peak described in (a) is generally smaller than that of the peak of (b) described later, due to smaller constraints of molecular motion. Namely, it is in the range of usually 3.0 ppm or less, preferably 2.0 ppm or less, and usually 0.3 ppm or more.
On the other hand, the full width at half maximum of the peak described in (b) is in the range of usually 5.0 ppm or less, preferably 4.0 ppm or less, and usually 0.3 ppm or more, preferably 0.4 ppm or more.

If the full width at half maximum of a peak observed in the above chemical shift areas is too large, a state in which constraints of molecular motion are large and thus the distortion is large is created, leading easy to forming a member inferior in heat resistance, weather resistance, and durability, and of which cracks are more likely to appear. For example when a lot of tetrafunctional silane is used or when large internal stress is generated by a rapid drying in the drying process, the range of the full width at half maximum will be larger than the above range.

If the full width at half maximum of the peak is too small, Si atoms existing in its environment are not involved in the siloxane crosslinking. In such a case, for example when trifunctional silane remains in a non-crosslinked state, the obtained member may be inferior in heat resistance, weather resistance and durability to materials formed mainly of siloxane bonds.

However, even if a peak, of the above-mentioned range of the full width at half maximum, is observed in an area of -80 ppm or more in a silicone material containing a small amount of Si component in a large amount of organic components, the heat resistance, light resistance and coating properties may not be excellent.

The chemical shift value of a silicone material preferable for the present invention can be calculated based on the results of a solid Si-NMR measurement performed by, for example, a method described below. Also, the measured data (the full width at half maximum, silanol amount and so on) is analyzed by a method in which each peak is divided and extracted by the waveform separation analysis or the like utilizing, for example, the Gauss function or Lorentz function.

{Solid Si-NMR spectrum measurement and calculation of the silanol content}

When measuring the solid Si-NMR spectrum of a silicone material, the solid Si-NMR spectrum measurement and the waveform separation analysis are performed under the following conditions. Further, the full width at half maximum of each peak is determined, for the silicone material, based on the obtained waveform data. In addition, the silanol content is determined by comparing the ratio (%) of silicon atoms in silanol to all silicon atoms, decided from the ratio of peak areas originating from silanol to all peak areas, with all silicon content ratio analyzed separately.

{Device conditions}

Device: Infinity CMX-400 nuclear magnetic resonance spectroscope, manufactured by Chemagnetics Inc.
$^{29}$Si resonance frequency: 79.436 MHz
Probe: 7.5 mm $\phi$ CP/MAS probe
Temperature: Room temperature
Rotational frequency of sample: 4 kHz
Measurement method: Single pulse method
1H decoupling frequency: 50 kHz
$^{29}$Si flip angle: 90°
$^{29}$Si90° pulse width: 5.0 $\mu$s
Repetition time: 600 s
Total count: 128 times
Observation width: 30 kHz
Broadening factor: 20 Hz
Internal authentic sample: tetramethoxysilane

For a silicone material, 512 points are taken in as measured data and zero-filled to 8192 points, before Fourier transformation is performed.

{Waveform separation analysis method}

For each peak of the spectrum after Fourier transformation, an optimization calculation is performed by the nonlinear least square method using the center position, height and full width at half maximum of a peak shape, created by a Lorentz waveform, Gauss waveform or a mixture of both, as variable parameters.
For identification of a peak, refer to AIChE Journal, 44(5), p. 1141, 1998 or the like.

[Characteristic [3] (silanol content)]

The silanol content of a silicone material preferable for the present invention is in the range of usually 0.1 weight % or more, preferably 0.3 weight % or more, and usually 10 weight % or less, preferably 8 weight % or less, more preferably 5 weight % or less. When the silanol content is small, the silanol material varies little over time and can be superior in long-term performance stability, as well as in low hygroscopicity and low moisture permeability. However, no silanol content results only in poor adhesion, and therefore, there is such appropriate range of the silanol content as described above.

The silanol content of a silicone material can be decided by such method as described before for {Solid Si-NMR spectrum measurement and calculation of the silanol content} in [Characteristic [2] (solid Si-NMR spectrum)], for example. In such a method, the ratio (%) of silicon atoms in silanol relative to all silicon atoms is determined from the ratio of peak areas originating from silanol relative to all peak areas by means of the solid Si-NMR spectrum measurement, and then, the silanol content can be calculated by comparing the determined silicon ratio with all silicon content analyzed separately.

Since a silicone material preferable for the present invention contains an appropriate amount of silanol, which is usually bound to a polar portion, existing on the device surface, through hydrogen bond, the adhesion develops. The polar portion includes, for example, a hydroxyl group and oxygen in a metalloxane bond.

In addition, a silicone material preferable for the present invention usually forms, due to dehydration condensation, a covalent bond with a hydroxyl group on the device surface when heated in the presence of an appropriate catalyst, leading to a development of still firmer adhesion.

With too much content of silanol, on the other hand, thickening in the system may make the coating difficult, and also, with increased activity, the occurrence of curing before low-boiling point components volatilize by heating may induce a foaming and an increase in internal stress, which may result in crack generations.

[4-3. Content of liquid medium]

There is no special limitation on the content of the liquid medium, insofar as the advantage of the present invention is not significantly impaired. However, it is usually 50 weight % or more, preferably 75 weight % or more, and usually 99 weight % or less, preferably 95 weight % or less, to the whole phosphor-containing composition of the present invention. Even a large amount of liquid medium does not induce any problems particularly, but in order to achieve desired color coordinate, color rendering index, emission efficiency or the like when it is used for a semiconductor light emitting device, it is preferable that the liquid medium is used usually in the above-mentioned proportion. With too small amount of the liquid medium, on the other hand, its handling may be difficult due to too little fluidity.

The liquid medium serves mainly as binder, in the phosphor-containing composition of the present invention. The liquid medium can be used either as a single one or as a mixture of two or more kinds in any combination and in any ratio. For example, when a silicon-containing compound is used for the purpose of improved heat resistance or light resistance, other thermosetting resin such as epoxy resin can be included to the extent that the durability of the silicon-containing compound will not be impaired. In such a case, it is preferable that the content of the other thermosetting resin is usually 25 weight % or lower, preferably 10 weight % or lower, to the whole amount of the liquid medium, which serves as the binder.

[4-4. Other component]

In the phosphor-containing composition of the present invention, other components can be contained in addition to the phosphor and liquid medium, insofar as the advantage of the present invention is not significantly impaired. The other components may be used either as a single kind thereof or as a mixture of more than one kind in any combination and in any ratio.

[5. Light emitting device]

The light emitting device of the present invention (hereinafter simply referred to as "light emitting device" as appropriate) comprises a first luminous body (excitation light source) and a second luminous body which emits visible light when irradiated with light from the first luminous body. The light emitting device comprises, as the second luminous body, first phosphor including at least one kind of the phosphor of the present invention described earlier in the section [1. Phosphor].

As the phosphor of the present invention, a phsophor that emits fluorescence of blue region (hereinafter referred to as "blue phosphor of the present invention" as appropriate) when irradiated with light from the excitation light source is usually used. As the blue phosphor of the present invention, a phosphor having its emission peak in the wavelength range of from 430 nm to 470 nm is preferably used. The blue phosphor of the present invention can be used either as a single one or as a mixture of two or more kinds in any combination and in any ratio.

The use of a blue phosphor of the present invention can make the light emitting device of the present invention high in emission efficiency, with respect to the light from an excitation light source (first luminous body) of near-ultraviolet region. This light emitting device shows superior characteristics when used for a white light emitting device such as an illuminating device, or a light source for a liquid crystal display.

Preferable examples of blue phosphor of the present invention used for light emitting devices of the present invention include the phosphors of the present invention described earlier in the section [1. Phosphor] and phosphors used in each Example of the section [Example] to be described later.

There is no particular limitation on the structure of the light emitting device of the present invention and any known device configuration can be used, insofar as it comprises a first luminous body (excitation light source) and utilizes at least a phosphor of the present invention as the second luminous body. Concrete examples of the device configuration will be described later.

The emission spectrum peak in blue region, of the light emitting device of the present invention, preferably exists in the wavelength range of from 430 nm to 470 nm.

An emission spectrum of a light emitting device can be measured in a room of which temperature is kept at 25±1°C with energization of 20 mA, using a software for measuring color and illumination intensity, manufactured by Ocean Optics, Inc., and a spectroscope of USB2000 series (integrating sphere version). From this emission spectrum data in the wavelength region of 380 nm to 780 nm, can be calculated the chromaticity values (x,y,z) as color coordinates of XYZ colorimetric system, defined in JIS Z8701. In this case, the relational expression of x+y+z=1 holds. In the present Description, the aforementioned XYZ colorimetric system is occasionally referred to as XY colorimetric system and the value thereof is usually represented as (x,y).

It is preferable that the emission efficiency of the light emitting device of the present invention is usually 10 lm/W or higher, preferably 12 lm/W or higher, particularly preferably 14 lm/W of higher. Emission efficiency can be determined by calculating the total luminous flux from the results of emission-spectrum measurement using a light emitting device mentioned earlier and then dividing the lumen value (lm) obtained by the power consumption (W). The power consumption can be obtained as the product of the current value and the voltage value, which is measured using True RMS Multimeters Model 187 and 189 manufactured by Fluke Corporation while 20-mA energization.

Particularly a white light emitting device, among light emitting devices of the present invention, can be obtained with a known device configuration. Specifically, an excitation light source such as described later is used as the first luminous body, and known phosphors, such as a phosphor emitting red fluorescence (hereinafter referred to as "red phosphor" as appropriate), a phosphor emitting green fluorescence (hereinafter referred to as "green phosphor" as appropriate), a phosphor emitting yellow fluorescence (hereinafter referred to as "yellow phosphor" as appropriate), which are described later, are used in arbitral combination, in addition to a blue phosphor such as described before.

In this context, "white" color of the white light emitting device includes all of (Yellowish) White, (Greenish) White, (Bluish) White, (Purplish) White and White, which are defined in JIS Z 8701. Of these, preferable is White.

[5-1. Configuration of light emitting device (luminous body)]

[5-1-1. First luminous body]

The first luminous body of the light emitting device of the present invention emits light for exciting the second luminous body to be described later.

There is no special limitation on its emission-peak wavelength of the first luminous body insofar as it overlaps the absorption wavelength of the second luminous body to be described later, and therefore, various luminous bodies with wide range of luminous wavelength regions can be used. Usually a luminous body having luminous wavelength of from ultraviolet region to blue region is used. Among them, particularly preferable are luminous bodies having luminous wavelength of near-ultraviolet region.

It is preferable that the emission-peak wavelength of the first luminous body usually has a concrete value of 200 nm or longer. Among them, it is preferable that, when a near-ultraviolet light is used as the excitation light, a luminous body having an emission-peak wavelength of usually 300 nm or longer, preferably 330 nm or longer, more preferably 360 nm or longer, and usually 420 nm or shorter, preferably 410 nm or shorter, more preferably 400 nm or shorter is used.

As the first luminous body, a semiconductor luminous element is generally used. Specifically, a light-emitting diode (LED), laser diode (LD) or the like can be used. Other examples of the luminous body that can be used as the first luminous body include an organic electroluminescence luminous element, inorganic electroluminescence luminous element and the like. However, the luminous body that can be used as the first luminous body is not restricted to those exemplified in the present Description.

Among them, a GaN-based LED and GaN-based LD, using a GaN-based compound semiconductor, are preferable for the first luminous body. This is because a GaN-based LED and GaN-based LD have light output and external quantum efficiency far greater than those of an SiC-based LED and the like that emit the same range of light and therefore they can give very bright luminescence with low electric power when used in combination with the above-mentioned phosphor. For example, when applying current load of 20 mA, a GaN-based LED and GaN-based LD usually have emission intensity 100 times or higher than that of an SiC-based ones. As GaN-based LED or GaN-based LD, one having an $Al_XGa_YN$ luminous layer, GaN luminous layer or $In_XGa_YN$ luminous layer is preferable. Among the GaN-based LEDs, one having an $In_XGa_YN$ luminous layer is particularly preferable, and one having a multiple quantum well structure of the $In_XGa_YN$ layer and GaN layer is particularly preferable, due to their remarkably high emission intensities.

In the above description, the X + Y usually takes a value in the range of 0.8 to 1.2. A GaN-based LED having a such kind of luminous layer that is doped with Zn or Si or without any dopant is preferable for the purpose of adjusting the luminescent characteristics.

A GaN-based LED contains, as its basic components, a such kind of luminous layer, p layer, n layer, electrode and substrate. Among them, a GaN-based LED having such a heterostructure as sandwiching the luminous layer with n type and p type of $Al_XGa_YN$ layers, GaN layers, $In_XGa_YN$ layers or the likes is preferable, from the standpoint of high emission efficiency. Moreover, the one whose heterostructure is replaced by a quantum well structure is more preferable because it can show higher emission efficiency.

The first luminous body can be used either as a single one or as a mixture of two or more of them in any combination and in any ratio.

[5-1-2. Second luminous body]

The second luminous body of the light emitting device of the present invention is a luminous body which emits visible light when irradiated with light from the above-mentioned first luminous body. It comprises a first phosphor including a phosphor of the present invention (preferably a blue phosphor of the present invention), and, when considered necessary depending on its use or the like, a second phosphor (red phosphor, green phosphor, yellow phosphor, orange phosphor and the like) to be described later. The second luminous body is formed, for example, so that the first and the second phosphors are dispersed in a sealing material.

There is no special limitation on the composition of the other phosphor than the phosphor of the present invention, which is used in the second luminous body. The examples include compounds incorporating a host crystal, such as a metal oxide typified by $Y_2O_3$, $YVO_4$, $Zn_2SiO_4$, $Y_3Al_5O_{12}$ and $Sr_2SiO_4$, a metal nitride typified by $Sr_2Si_5N_8$, phosphate typified by $Ca_5(PO_4)_3Cl$, a sulfide typified by ZnS, SrS and CaS and an oxysulfide typified by $Y_2O_2S$ and $La_2O_2S$, with an activation element or coactivation element, such as an ion of a rare earth metal including Ce, Pr, Nd, Pm, Sm, Eu, Tb, Dy, Ho, Er, Tm or Yb, or a metal ion of Ag, Cu, Au, Al, Mn or Sb.

Preferable examples of the host crystal include: sulfides such as (Zn,Cd)S, $SrGa_2S_4$, SrS and ZnS; oxysulfides such as $Y_2O_2S$; aluminates such as $(Y,Gd)_3Al_5O_{12}$, $YAlO_3$, $BaMgAl_{10}O_{17}$, $(Ba,Sr)(Mg,Mn)Al_{10}O_{17}$, $(Ba, Sr, Ca)(Mg, Zn,Mn)Al_{10}O_{17}$, $BaAl_{12}O_{19}$, $CeMgAl_{11}O_{19}$, $(Ba,Sr,Mg)O\cdot Al_2O_3$, $BaAl_2Si_2O_8$, $SrAl_2O_4$, $Sr_4Al_{14}O_{25}$ and $Y_3Al_5O_{12}$; silicates such as $Y_2SiO_5$ and $Zn_2SiO_4$; oxides such as $SnO_2$ and $Y_2O_3$; borates such as $GdMgB_5O_{10}$ and $(Y,Gd)BO_3$; halophosphates such as $Ca_{10}(PO_4)_6(F,Cl)_2$ and $(Sr,Ca,Ba,Mg)_{10}(PO_4)_6Cl_2$; and phosphates such as $Sr_2P_2O_7$ and $(La,Ce)PO_4$.

No particular limitation is imposed on the element compositions of the above-mentioned host crystal, and activation element or coactivation element. Partial substitution with an element of the same group is possible. Any phosphor obtained can be used so long as it absorbs light in the near-ultraviolet to visible region and emits visible light.

Concretely, those listed below can be used as the phosphor. However, the lists are just examples and phosphors that can be used in the present invention are not limited to those examples. In the following examples, phosphors with different partial structure are shown abbreviated as a group, as mentioned earlier.

[First phosphor]

The second luminous body in the light emitting device of the present invention contains a first phosphor including at least the above-mentioned phosphor of the present invention. The phosphor of the present invention can be used either as a single one or as a mixture of two or more kinds in any combination and in any ratio.

In addition, the first phosphor may contain, in addition to the phosphor of the present invention, a phosphor (combined same-color phosphor) emitting a fluorescence of the same color as that of the phosphor of the present invention. Since the phosphor of the present invention is usually a blue phosphor, another kind of blue phosphor can be used as a first phosphor in combination with the phosphor of the present invention.

As such a blue phosphor, any blue phosphor can be used, insofar as the advantage of the present invention is not significantly impaired.

Examples of such a blue phosphor include: europium-activated barium magnesium aluminate phosphors represented by $(Ba,Sr,Ca)MgAl_{10}O_{17}$:Eu, which is constituted by growing particles having a nearly hexagonal shape typical of regular crystal growth and emits light in the blue region, europium-activated calcium halphosphate phosphors represented by $(Mg,Ca,Sr,Ba)_5(PO_4)_3(Cl,F)$:Eu, which is constituted by growing particles having a nearly spherical shape typical of regular crystal growth and emits light in the blue region, europium-activated alkaline earth chloroborate phosphors represented by $(Ca,Sr,Ba)_2B_5O_9Cl$:Eu, which is constituted by growing particles having a nearly cubic shape typical of regular crystal growth and emits light in the blue region, and europium-activated alkaline earth aluminate phosphors represented by $(Sr,Ca,Ba)Al_2O_4$:Eu or $(Sr,Ca,Ba)_4Al_{14}O_{25}$:Eu, which is constituted by fractured particles having fractured surfaces and emits light in the blue green region.

Other examples of such a blue phosphor include: Sn-activated phosphate phosphors such as $Sr_2P_2O_7$:Sn; Eu-activated aluminate phosphors such as $(Sr,Ca,Ba)Al_2O_4$:Eu or $(Sr,Ca,Ba)_4AL_{14}O_{25}$:Eu, $BaMgAl_{10}O_{17}$:Eu, $(Ba,Sr,Ca)MgAl_{10}O_{17}$:Eu, $BaMgAl_{10}O_{17}$:Eu,Tb,Sm and $BaAl_8O_{13}$:Eu; Ce-activated thiogalate phosphors such as $SrGa_2S_4$:Ce and $CaGa_2S_4$:Ce; Eu,Mn-activated aluminate phosphors such as $(Ba,Sr,Ca)MgAl_{10}O_{17}$:Eu,Mn; Eu-activated halophosphate phosphors such as $(Sr,Ca,Ba,Mg)_{10}(PO_4)_6Cl_2$:Eu and $(Ba,Sr,Ca)_5(PO_4)_3(Cl,F,Br,OH)$:Eu,Mn,Sb; Eu-activated silicate phosphors such as $BaAl_2Si_2O_8$:Eu, $(Sr,Ba)_3MgSi_2O_8$:Eu; Eu-activated phosphate phosphors such as $Sr_2P_2O_7$:Eu; sulfide phosphors such as ZnS:Ag and ZnS:Ag,Al; Ce-activated silicate phosphors such as $Y_2SiO_5$:Ce; tungstate phosphors such as $CaWO_4$; Eu,Mn-activated borophosphate phosphors such as $(Ba,Sr,Ca)BPO_5$:Eu,Mn, $(Sr,Ca)_{10}(PO_4)_6 \cdot nB_2O_3$:Eu and $2SrO \cdot 0.84P_2O_5 \cdot 0.16B_2O_3$:Eu; Eu-activated halosilicate phosphors such as $Sr_2Si_3O_8 \cdot 2SrCl_2$:Eu; Eu-activated oxynitride phosphors such as $SrSi_9Al_{19}ON_{31}$:Eu and $EuSi_9Al_{19}ON_{31}$; and Ce-activated oxynitride phosphors such as $La_{1-x}Ce_xAl(Si_{6-z}Al_z)(N_{10-z}O_z)$ (here, x and z are numbers satisfying $0 \le x \le 1$ and $0 \le z \le 6$, respectively) and $La_{1-x-y}Ce_xCa_yAl(Si_{6-z}Al_Z)(N_{10-z}O_z)$ (here, x, y and z are numbers satisfying $0 \le x \le 1$, $0 \le y \le 1$ and $0 \le z \le 6$, respectively).

Also applicable as the blue phosphor are, for example, fluorescent dyes such as naphthalimide compound, benzoxazole compound, styryl compound, coumarine compound, pyrazoline compound and triazole compound, and organic phosphors such as thlium complex.

Among them, it is preferable that the blue phosphor contains $(Ca,Sr,Ba)MgAl_{10}O_{17}$:Eu, $(Sr,Ca,Ba,Mg)_{10}(PO_4)_6(Cl,F)_2$:Eu or $(Ba,Ca,Mg,Sr)_2SiO_4$:Eu. It is more preferable that it contains $(Ca,Sr,Ba)MgAl_{10}O_{17}$:Eu, $(Sr,Ca,Ba,Mg)_{10}(PO_4)_6(Cl,F)_2$:Eu or $(Ba,Ca,Sr)_3MgSi_2O_8$:Eu. It is still more preferable that it contains $BaMgAl_{10}O_{17}$:Eu, $Sr_{10}(PO_4)_6(Cl,F)_2$:Eu or $Ba_3MgSi_2O_8$:Eu. Of these, $(Sr,Ca,Ba,Mg)_{10}(PO_4)_6Cl_2$:Eu or $(Ca,Sr,Ba)MgAl_{10}O_{17}$:Eu is particularly preferable in uses for an illuminating device and a display.

The emission peak wavelength $\lambda_p$ (nm) of the first phosphor used in a light emitting device of the present invention is usually 430 nm or longer, preferably 440 nm or longer, more preferably 445 nm or longer, and usually 470 nm or shorter, preferably 460 nm or shorter, more preferably 455 nm or shorter. When it falls below the above-mentioned range, the brightness may be lowered. When it exceeds that range, the color reproduction range of the image display may be narrower.

[Second phosphor]

The second luminous body of the light emitting device of the present invention may contain another phosphor (namely, a second phosphor) in addition to the above-mentioned first phosphor, depending on its use. The second phosphor is a phosphor having a different emission-peak wavelength from that of the first phosphor. Such a second phosphor is usually used for adjusting color tone of light emission of the second luminous body, therefore, in many cases, a phosphor that emits fluorescence of different color from that of the first phosphor as the second phosphor. Since a blue phosphor is usually used as the first phosphor as described above, a phosphor other than blue phosphor, such as orange to red phosphor, green phosphor, or yellow phosphor, is used as the second phosphor.

It is preferable that the weight median diameter $D_{50}$ of second phosphors used for light emitting devices of the present invention is in the range of usually 2 $\mu$m or larger, preferably 5 $\mu$m or larger, and usually 30 $\mu$m or smaller, preferably 20 $\mu$m or smaller. When the weight median diameter $D_{50}$ is too small, the brightness tends to decrease and the phosphor particles tend to aggregate. On the other hand, the weight median diameter is too large, unevenness in coating, clogging in a dispenser or the like tend to occur.

(Orange to red phosphor)

When an orange to red phosphor is used as the second phosphor, any kind of orange to red phosphor can be used, insofar as the advantage of the present invention is not significantly impaired. It is preferable that the emission-peak wavelength of the orange to red phosphor is in the wavelength range of usually 570 nm or longer, preferably 580 nm or longer, more preferably 585 nm or longer, and usually 780 nm or shorter, preferably 700 nm or shorter, more preferably 680 nm or shorter.

Examples of such an orange to red phosphor include an europium-activated alkaline earth silicon nitride phosphor represented by $(Mg,Ca,Sr,Ba)_2Si_5N_8$:Eu, which is constituted by fractured particles having red fractured surfaces and emits light in red region, and an europium-activated rare-earth oxychalcogenide phosphor represented by $(Y,La,Gd,Lu)_2O_2S$:Eu, which is constituted by growing particles having a nearly spherical shapes typical of regular crystal growth and emits light in red region.

Also applicable in the present embodiment is an phosphor containing oxynitride and/or oxysulfide which include at least one element selected from the group consisting of Ti, Zr, Hf, Nb, Ta, W and Mo, described in Japanese Patent Laid-Open Publication (Kokai) No. 2004-300247, and containing an oxynitride having an α-sialon structure in which all or part of Al elements are replaced by Ga elements. These are phosphors which contain oxynitride and/or oxysulfide.

Other examples of the red phosphor include: Eu-activated oxysulfide phosphors such as $(La,Y)_2O_2S$:Eu; Eu-activated oxide phosphors such as $Y(V,P)O_4$:Eu and $Y_2O_3$:Eu; Eu,Mn-activated silicate phosphors such as $(Ba,Mg)_2SiO_4$:Eu,Mn and $(Ba,Sr,Ca,Mg)_2SiO_4$:Eu,Mn; Eu-activated tungstate phosphors such as $LiW_2O_8$:Eu, $LiW_2O_8$:Eu,Sm, $Eu_2W_2O_9$, $Eu_2W_2O_9$:Nb, $Eu_2W_2O_9$:Sm; Eu-activated sulfide phosphors such as (Ca,Sr)S:Eu; Eu-activated aluminate phosphors such as $YAlO_3$:Eu; Eu-activated silicate phosphors such as $Ca_2Y_8(SiO_4)_6O_2$:Eu, $LiY_9(SiO_4)_6O_2$:Eu, $(Sr,Ba,Ca)_3SiO_5$:Eu and $Sr_2BaSiO_5$:Eu; Ce-activated phosphors aluminate such as $(Y,Gd)_3Al_5O_{12}$:Ce and $(Tb,Gd)_3Al_5O_{12}$:Ce; Eu-activated oxide, nitride or oxynitride phosphors such as $(Mg,Ca,Sr,Ba)_2Si_5(N,O)_8$:Eu, $(Mg,Ca,Sr,Ba)Si(N,O)_2$:Eu and $(Mg,Ca,Sr,Ba)AlSi(N,O)_3$:Eu; Ce-activated oxide, nitride or oxynitride phosphors such as $(Mg,Ca,Sr,Ba)AlSi(N,O)_3$:Ce; Eu,Mn-activated halophosphate phosphors such as $(Sr,Ca,Ba,Mg)_{10}(PO_4)_6Cl_2$:Eu,Mn; Eu,Mn-activated silicate phosphors such as $Ba_3MgSi_2O_8$:Eu,Mn and $(Ba,Sr,Ca,Mg)_3(Zn,Mg)Si_2O_8$:Eu,Mn; Mn-activated germanate phosphors such as $3.5MgO\cdot0.5MgF_2\cdot GeO_2$:Mn; Eu-activated oxynitride phosphors such as Eu-activated α-sialon; Eu,Bi-activated oxide phosphors such as $(Gd,Y,Lu,La)_2O_3$:Eu,Bi; Eu,Bi-activated oxysulfide phosphors such as $(Gd,Y,Lu,La)_2O_2S$:Eu,Bi; Eu,Bi-activated vanadate phosphors such as $(Gd,Y,Lu,La)VO_4$:Eu,Bi; Eu,Ce-activated sulfide phosphors such as $SrY_2S_4$:Eu,Ce; Ce-activated sulfide phosphors such as $CaLa_2S_4$:Ce; Eu,Mn-activated phosphate phosphors such as $(Ba,Sr,Ca)MgP_2O_7$:Eu,Mn and $(Sr,Ca,Ba,Mg,Zn)_2P_2O_7$:Eu,Mn; Eu,Mo-activated tungstate phosphors such as $(Y,Lu)_2WO_6$:Eu,Mo; Eu,Ce-activated nitride phosphors such as $(Ba,Sr,Ca)_xSi_yN_z$:Eu,Ce (x,y,z being an integer of 1 or larger); Eu,Mn-activated halophosphate phosphors such as $(Ca,Sr,Ba,Mg)_{10}(PO_4)_6(F,Cl,Br,OH)$:Eu,Mn; and Ce-activated silicate phosphors such as $((Y,Lu,Gd,Tb)_{1-x-y}Sc_xCe_y)_2(Ca,Mg)_{1-r}(Mg,Zn)_{2+r}Si_{z-q}Ge_qO_{12+\delta}$.

Also applicable examples of the red phosphor include: red organic phosphor comprising of rare-earth ion complex containing anions of such as β-diketonate, β-diketone, aromatic carboxylic acid or Bronsted acid as ligands, perylene pigment (for example, dibenzo{[f,f']-4,4',7,7'-tetraphenyl}diindeno[1,2,3-cd:1',2',3'-lm]perylene), anthraquinone pigment, lake pigment, azo pigment, quinacridone pigment, anthracene pigment, isoindoline pigment, isoindolinone pigment, phthalocyanine pigment, triphenylmethane series basic dye, indanthrone pigment, indophenol pigment, cyanine pigment and dioxazine pigment.

Among them, it is preferable that the red phosphor contains $(Ca,Sr,Ba)_2Si_5(N,O)_8$:Eu, $(Ca,Sr,Ba)Si(N,O)_2$:Eu, $(Ca,Sr,Ba)AlSi(N,O)_3$:Eu, $(Ca,Sr,Ba)AlSi(N,O)_3$:Ce, $(Sr,Ba)_3SiO_5$:Eu, (Ca,Sr)S:Eu, $(La,Y)_2O_2S$:Eu or Eu complex. It is more preferable that it contains $(Ca,Sr,Ba)_2Si_5(N,O)_8$:Eu, $(Ca,Sr,Ba)Si(N,O)_2$:Eu, $(Ca,Sr,Ba)AlSi(N,O)_3$:Eu, $(Ca,Sr,Ba)AlSi(N,O)_3$:Ce, $(Sr,Ba)_3SiO_5$:Eu, (Ca,Sr)S:Eu, $(La,Y)_2O_2S$:Eu, β-diketone Eu complex such as Eu(dibenzoylmethane)$_3\cdot$1,10-phenanthroline complex or carboxylic acid Eu complex. Of these, especially preferable are $(Ca,Sr,Ba)_2Si_5(N,O)_8$:Eu, $(Sr,Ca)AlSiN_3$:Eu and $(La,Y)_2O_2S$:Eu.

Among the above examples, a phosphor that can be preferably used as the orange phosphor is $(Sr,Ba)_3SiO_5$:Eu. Of the red phosphors, one or more kinds of them that are selected from the group consisting of $(Sr,Ca)AlSiN_3$:Eu and $La_2O_2S$:Eu are preferable.

The orange to red phosphor exemplified above can be used either as a single kind thereof or as a mixture of two or more kinds in any combination and in any ratio.

(Green phosphor)

When a green phosphor is used as the second phosphor, any kind of green phosphor can be used, insofar as the advantage of the present invention is not significantly impaired. It is preferable that the emission-peak wavelength of the green phosphor is in the wavelength range of usually 500 nm or longer, preferably 510 nm or longer, more preferably 515 nm or longer, and usually 570 nm or shorter, preferably 550 nm or shorter, more preferably 530 nm or shorter.

Examples of such a green phosphor include an europium-activated alkaline earth silicon oxynitride phosphor represented by $(Mg,Ca,Sr,Ba)Si_2O_2N_2$:Eu, which is constituted by fractured particles having a fractured surface and emits light in the green region.

Other examples of such green phosphor include: Eu-activated aluminate phosphors such as $Sr_4Al_{14}O_{25}$:Eu and $(Ba,Sr,Ca)Al_2O_4$:Eu; Eu-activated silicate phosphors such as $(Sr,Ba)Al_2Si_2O_8$:Eu, $(Ba,Mg)_2SiO_4$:Eu, $(Ba,Sr,Ca,Mg)_2SiO_4$:Eu, $(Ba,Sr,Ca)_2(Mg,Zn)Si_2O_7$:Eu and $(Ba,Ca,Sr,Mg)_9(Sc,Y,Lu,Gd)_2(Si,Ge)_6O_{24}$:Eu; Ce,Tb-activated silicate phosphors such as $Y_2SiO_5$:Ce,Tb; Eu-activated borophosphate phosphors such as $Sr_2P_2O_7$-$Sr_2B_2O_5$:Eu; Eu-activated halosilicate phosphors such as $Sr_2Si_3O_8$-$2SrCl_2$:Eu; Mn-activated silicate phosphors such as $Zn_2SiO_4$:Mn; Tb-activated aluminate phosphors such as $CeMgAl_{11}O_{19}$:Tb and $Y_3Al_5O_{12}$:Tb; Tb-activated silicate phosphors such as $Ca_2Y_8(SiO_4)_6O_2$:Tb and $La_3Ga_5SiO_{14}$:Tb; Eu,Tb,Sm-activated thiogalate phosphors such as $(Sr,Ba,Ca)Ga_2S_4$:Eu,Tb,Sm; Ce-activated aluminate phosphors such as $Y_3(Al,Ga)_5O_{12}$:Ce and $(Y,Ga,Tb,La,Sm,Pr,Lu)_3(Al,Ga)_5O_{12}$:Ce; Ce-activated silicate phosphors such as $Ca_3Sc_2Si_3O_{12}$:Ce and $Ca_3(Sc,Mg,Na,Li)_2Si_3O_{12}$:Ce; Ce-activated oxide phosphors such as $CaSc_2O_4$:Ce; Eu-activated oxynitride phosphors such as Eu-activated β-sialon; Eu,Mn-activated aluminate phosphors

such as $BaMgAl_{10}O_{17}$:Eu,Mn; Eu-activated aluminate phosphors such as $SrAl_2O_4$:Eu; Tb-activated oxysulfide phosphors such as $(La,Gd,Y)_2O_2S$:Tb; Ce,Tb-activated phosphate phosphors such as $LaPO_4$:Ce,Tb; sulfide phosphors such as ZnS:Cu,Al and ZnS:Cu,Au,Al; Ce,Tb-activated borate phosphors such as $(Y,Ga,Lu,Sc,La)BO_3$:Ce,Tb, $Na_2Gd_2B_2O_7$:Ce,Tb and $(Ba,Sr)_2(Ca,Mg,Zn)B_2O_6$:K,Ce,Tb; Eu,Mn-activated halosilicate phosphors such as $Ca_8Mg(SiO_4)_4Cl_2$:Eu,Mn; Eu-activated thioaluminate phosphors or thiogallate phosphors such as (Sr,Ca,Ba) $(Al,Ga,In)_2S_4$:Eu; Eu,Mn-activated halosilicate such as $(Ca,Sr)_8(Mg,Zn)(SiO_4)_4Cl_2$:Eu,Mn; and Eu-activated oxynitride phosphors such as $M_3Si_6O_9N_4$:Eu and $M_3Si_6O_{12}N_2$:Eu (here, M represents alkaline earth metal element).

Also applicable as the green phosphor are fluorescent dyes such as pyridine-phthalimide condensed derivative, benzoxadinone compound, quinazolinone compound, coumarine compound, quinophthalone compound, naphthalimide compound, and organic phosphors such as terbium complex.

The green phosphor exemplified above can be used either as a single kind or as a mixture of two or more kinds in any combination and in any ratio.

(Yellow phosphor)

When a yellow phosphor is used as the second phosphor, any kind of yellow phosphor can be used, insofar as the advantage of the present invention is not significantly impaired. It is preferable that the emission-peak wavelength of the yellow phosphor is in the wavelength range of usually 530 nm or longer, preferably 540 nm or longer, more preferably 550 nm or longer, and usually 620 nm or shorter, preferably 600 nm or shorter, more preferably 580 nm or shorter.

Examples of such a yellow phosphor include various phosphors of such as oxide, nitride, oxynitride, sulfide and oxysulfide.

Particularly preferable examples include garnet phosphors having garnet structures, represented by $RE_3M_5O_{12}$:Ce (here, RE indicates at least one element selected from the group consisting of Y, Tb, Gd, Lu and Sm, M indicates at least one element selected from the group consisting of Al, Ga and Sc) and $M^a{}_3M^b{}_2M^c{}_3O_{12}$:Ce (here, $M^a$, $M^b$ and $M^c$ are divalent, trivalent and tetravalent metal element respectively); orthosilicate phosphors represented by $AE_2M^dO_4$:Eu (here, AE indicates at least one element selected from the group consisting of Ba, Sr, Ca, Mg and Zn, $M^d$ indicates Si and/or Ge); oxynitride phosphors in which a part of the oxygen, contained in the above types of phosphors as constituent element, are substituted by nitrogen; and Ce-activated phosphors such as nitride phosphors having $CaAlSiN_3$ structures such as $AEAlSiN_3$:Ce (here, AE indicates at least one element selected from the group consisting of Ba, Sr, Ca, Mg and Zn).

Also applicable as the yellow phosphor are: Eu-activated phosphors including sulfide phosphors such as $CaGa_2S_4$:Eu, $(Ca,Sr)Ga_2S_4$:Eu and $(Ca,Sr)(Ga,Al)_2S_4$:Eu and Eu-activated phosphors such as phosphors oxynitride phosphors having SiAlON structure such as $Ca_x(Si,Al)_{12}(O,N)_{16}$:Eu; and Eu-activated or Eu,Mn-coactivated halogenated borate phosphors such as $(M_{1-a-b}Eu_aMn_b)_2(BO_3)_{1-p}(PO_4)_pX$ (here, M represents one or more kinds of elements selected from the group consisting of Ca, Sr and Ba, X represents one or more kinds of elements selected from the group consisting of F, Cl and Br, and a, b and p are numbers satisfying $0.001 \le a \le 0.3$, $0 \le b \le 0.3$ and $0 \le p \le 0.2$, respectively).

As other examples of the yellow phosphor can be cited fluorescent dyes such as brilliant sulfoflavine FF (Colour Index Number 56205), basic yellow HG (Colour Index Number 46040), eosine (Colour Index Number 45380) and rhodamine 6G (Colour Index Number 45160).

The yellow phosphors exemplified above may be used either as a single kind thereof or as a mixture of more than one kind in any combination and in any ratio.

[Combination of second phosphors]

The above-mentioned second phosphors can be used either as a single kind or as a mixture of two or more kinds in any combination and in any ratio. There is no special limitation on the ratio between the first phosphor and the second phosphor, insofar as the advantage of the present invention is not significantly impaired. Accordingly, the amount of the second phosphors used, as well as the combination and the mixing ratio of the phosphors used as the second phosphor, can be set arbitrarily according to the use or the like of the light emitting device.

Whether the above-described second phosphors (yellow to red phosphors, green phosphors or the like) are used or not and what kind of them are used, in the light emitting device of the present invention, can be decided as appropriate depending on the use of the light emitting device. For example when the light emitting device of the present invention is constructed in a way that it is used as a blue light emitting device, it usually requires only a first phosphor (blue phosphor) and no second phosphor.

When the light emitting device of the present invention is constructed in a way it is used as a white light emitting device, it would be better to combine a first luminous body, a first phosphor (blue phosphor) and a second phosphor appropriately, for synthesizing the desired white color. Concrete examples of preferable combination of a first luminous body, a first phosphor, and a second phosphor, when the light emitting device of the present invention is constructed as a white light emitting device, include the following combinations (i) to (ii).

(i) A near-ultraviolet luminous body (near-ultraviolet LED or the like) is used as the first luminous body. A blue phosphor (phosphor of the present invention or the like) is used as the first phosphor. An orange to red phosphor and a green phosphor are used as the second phosphor.

For each color of phosphor, the above-mentioned phosphors can be preferably used. In the combination (i), as the red phosphor, one or more kinds of red phosphors selected from the group consisting of $(Sr,Ca)AlSiN_3$:Eu and $La_2O_2S$:Eu can be used particularly preferably, and as the orange phosphor, $(Sr,Ba)_3SiO_5$:Eu can be used preferably. It is particularly preferable to use one or more kinds of red phosphors selected from the group consisting of $(Sr,Ca)AlSiN_3$:Eu and $La_2O_2S$:Eu.

As the green phosphor, one or more kinds of green phosphors selected from the group consisting of $BaMgAl_{10}O_{17}$:Eu, Mn, $(Ba,Sr,Ca)_2SiO_4$:Eu, Eu-activated β-sialon, and $(Ba,Sr,Ca)_3Si_6O_{12}N_2$:Eu can be used particularly preferably.

(ii) A near-ultraviolet luminous body (near-ultraviolet LED or the like) is used as the first luminous body. A blue phosphor (phosphor of the present invention or the like) is used as the first phosphor. A yellow phosphor is used as the second phosphor.

For each color of phosphor, the above-mentioned phosphors can be preferably used. In the combination (ii), as the yellow phosphor, one or more kinds of green [SIC] phosphors selected from the group consisting of $(Y,Gd,Tb)_3(Al,Ga)_5O_{12}$:Ce, $(Ba,Sr,Ca)_2SiO_4$:Eu, Eu-activated α-sialon, and $(Ba,Sr,Ca)Si_2O_2N_2$:Eu can be used preferably. When using a ultraviolet to near-ultraviolet luminous body as the first luminous body, light emitted from a blue phosphor (phosphor of the present invention or the like), which is a first phosphor, can excite another color of phosphor (green phosphor, red phosphor or the like).

The phosphor of the present invention can be used as a mixture with another phosphor (in this context, "mixture" does not necessarily mean to blend the phosphors with each other, but means to use different kinds of phosphors in combination). Among them, the combined use of phosphors described above will provide a preferable phosphor mixture. There is no special limitation on the kind or the ratio of the phosphors mixed.

[Sealing material]

The above-mentioned first and/or second phosphors are usually used by being dispersed in a liquid medium, which serves as a sealing material (binder), in the light emitting device of the present invention.

Examples of that liquid medium include the same ones as described in the aforementioned section [4. Phosphor-containing composition].

The liquid medium may contain a metal element that can be a metal oxide having high refractive index, for the purpose of adjusting the refractive index of the sealing member. As examples of a metal element that can be a metal oxide having high refractive indexes can be cited Si, Al, Zr, Ti, Y, Nb and B. These metal elements can be used as a single kind or as a mixture of two or more kinds in any combination and in any ratio.

There is no special limitation on the state of existence of such metal elements, insofar as the transparency of the sealing material does not deteriorate. For example, they may exist as a uniform glass layer of metalloxane bonds or as particles in the sealing member. When they exist in a state of particles, the structure inside the particles may be either amorphous or crystal structure. However, for higher refractive index, the crystal structure is preferable. In such a case, the particle diameter thereof is usually equal to or smaller than the luminous wavelength of a semiconductor luminous element, and preferably 100 nm or smaller, more preferably 50 nm or smaller, particularly preferably 30 nm or smaller, in order not to impair the transparency of the sealing material. The above-mentioned metal elements in a state of particles contained in the sealing material can be obtained by means of mixing, with a silicone material, such particles as silicon oxide, aluminium oxide, zirconium oxide, titanium oxide, yttrium oxide, niobium oxide or the like, for example.

Furthermore, as the above-mentioned liquid medium, a known additive such as diffusing agent, filler, viscosity modifier and UV absorbing agent may be further contained.

[5-2. (Other) configurations of light emitting device]

There is no special limitation on the other configuration of the light emitting device of the present invention, insofar as it comprises the above-mentioned first luminous body and second luminous body. However, it usually comprises a frame on which the above-mentioned first luminous body and second luminous body are located. The location is configured so that the second luminous body is excited (namely, the first and second phosphors are excited) by the light emitted from the first luminous body to emit light and the lights from the first luminous body and/or from the second luminous body are radiated to the outside. At this point, it is not always necessary for the first and second phosphors to be contained in the same layer. Each of different colored phosphors may be contained in the different layer from each other. For example, a layer containing the second phosphor can be laminated on a layer containing the first phosphor.

The light emitting device of the present invention may also utilize a member other than the above-mentioned excitation light source (the first luminous body), the phosphor (the second luminous body) and a frame. As the example can be cited the aforementioned sealing material. The sealing material can be used for, in addition to dispersing the phosphor (the second luminous body), adhering the excitation light source (the first luminous body), the phosphor (the second luminous body) and the frame to each other, in the light emitting device.

The light emitting device of the present invention can be constituted so that it is suitably used as a back-lighting source of a display to be described later by combining a phosphor of the present invention, other specific red phosphor, and specific green phosphor. Namely, since the phosphor of the present invention can be excited by a light of ultraviolet to blue wavelength, the light shows a narrow wavelength width of luminescence at a blue region, and is superior in temperature characteristics, it can constitute a semiconductor light emitting device used as a back-lighting source of a display of which emission efficiency can be specified higher than in the past by combining a first luminous body and three or more kinds of phosphors described below.

As the first luminous body, a semiconductor luminous element of which luminous wavelength is located at a ultraviolet to blue region can be used, as described above. Preferably, a semiconductor luminous element of which luminous wavelength is located at a near-ultraviolet region can be used.

It is preferable to use semiconductor luminous elements of which fluctuations in emission efficiency are little especially for a back-lighting source of a display that uses a plurality of semiconductor luminous elements. Since phosphors excited by a light of near-ultraviolet to blue wavelength change their excitation efficiencies significantly around a wavelength of 400 nm, it is particularly preferable that a semiconductor luminous element of which fluctuation in emission efficiency is little is used. Specifically, the fluctuation, of the semiconductor luminous element, in the luminous wavelength at which emission efficiency is the highest is usually ± 5 nm or smaller, preferably ± 2.5 nm or smaller, more preferably ± 1.25 nm or smaller.

One of the examples of the above-mentioned three or more kinds of phosphors is a combination of a phosphor of the present invention, and a specific red phosphor and a green phosphor that can be excited by a light from the first luminous body, show a narrow wavelength width of luminescence, and are superior in temperature characteristics.

Preferable examples of the combination of phosphors used as a semiconductor light emitting device for a back-lighting source of a display include the following ones.

[Table 2]

| [Table 2] | | |
|---|---|---|
| Blue phosphor | Green phosphor | Red phosphor |
| phosphor of the present invention | one or more kinds of:<br>Eu,Mn-activated aluminate phosphor such as $BaMgAl_{10}O_{17}$:Eu,Mn;<br>Eu-activated silicate phsophor such as $(Ba,Sr,Ca,Mg)_2SiO_4$:Eu;<br>Eu-activated oxynitride phsophor such as Eu-activated<br>β-sialon; and<br>Eu-activated oxynitride such as $M_3Si_6O_{12}N_2$:Eu (here, M represents alkaline earth metal element) | one or more kinds of:<br>Eu-activated oxysulfide phosphor such as $(La,Y)_2O_2S$:Eu;<br>Eu-activated oxide, nitride or oxynitride phosphor such as<br>$(Mg,Ca,Sr,Ba)AlSi(N,O)_3$:Eu; and<br>Eu-activated oxynitride such<br>as Eu-activated α-sialon |

Among others, combinations shown below are preferable.

[Table 3]

| [Table 3] | | |
|---|---|---|
| Blue phosphor | Green phosphor | Red phosphor |
| phosphor of the present invention | one or more kinds of:<br>$BaMgAl_{10}O_{17}$:Eu,Mn;<br>$(Ba,Sr,Ca)_2SiO_4$:Eu;<br>Eu-activated β-sialon; and $(Ba,Sr,Ca)_3Si_6O_{12}N_2$:Eu | one or more kinds of:<br>$(Ca,Sr,Ba)_2Si_5(N,O)_8$:Eu;<br>$(Sr,Ca)AlSiN_3$:Eu; and<br>$(La,Y)_2O_2S$:Eu |

Of these, combinations shown below are more preferable.

[Table 4]

| [Table 4] | | |
|---|---|---|
| Blue phosphor | Green phosphor | Red phosphor |
| phosphor of the present invention | $BaMgAl_{10}O_{17}$:Eu,Mn | one or more kinds of: (Sr,Ca)$AlSiN_3$:Eu and $La_2O_2S$:Eu |

When a sealing material is used for the above-mentioned light emitting device, it is preferable to use a silicone material described earlier from the standpoint of resistance to deterioration due to luminous wavelength of from ultraviolet to blue wavelength region and heat resistance. It is more preferable to use a condensing type silicone material described earlier.

Furthermore, a displaying of high color purity can be realized by using a color filter that is the most suitable for the luminous wavelength of the above-mentioned light emitting device. In other words, since the above-mentioned light emitting device is a light source constituted by combining blue, green, and red light emissions that are high in emission intensities in narrow wavelength ranges and superior in temperature characteristics, it can constitute an excellent image display exhibiting higher light utilization efficiency than in the past even with a high NTSC ratio and showing stable emission intensity and little color shift even when a semiconductor luminous element of a power device, of which temperature frequently rises, is used.

[5-3. Embodiment of light emitting device]

The light emitting device of the present invention will be explained in detail below with reference to a concrete embodiment. However, it is to be noted that the present invention is by no means restricted to the following embodiment and any modifications can be added thereto insofar as they do not depart from the scope of the present invention.

Fig. 1 is a schematic perspective view illustrating the positional relationship between the first luminous body, which functions as an excitation light source, and the second luminous body, constructed as a phosphor-containing part containing a phosphor, in an example of the light emitting device of the present invention. In Fig. 1, the numeral 1 indicates a phosphor-containing part (second luminous body), the numeral 2 indicates a surface emitting type GaN-based LD as an excitation light source (first luminous body), and the numeral 3 indicates a substrate. In order to configure them so that they are in contact with each other, the LD (2) and the phosphor-containing part (second luminous body) (1), prepared separately, may be made contact with each other in their surfaces by means of adhesive or the like, or otherwise, a layer of the phosphor-containing part (second luminous body) may be formed (molded) on the emission surface of the LD (2). With such configurations, the LD (2) and the phosphor-containing part (second luminous body) (1) can be kept contact with each other.

With such device configurations, light quantity loss, induced by a leakage of light emitted from the excitation light source (first luminous body) and reflected on the layer surface of the phosphor-containing part (second luminous body) to outside, can be avoided, which makes possible enhancement in emission efficiency of the entire device.

Fig. 2(a) shows a typical example of a light emitting device generally called a shell type. It is a schematic sectional view illustrating an example of the light emitting device comprising an excitation light source (first luminous body) and a phosphor-containing part (second luminous body). In this light emitting device (4), the numeral 5, numeral 6, numeral 7, numeral 8, numeral 9 and numeral 10 indicate a mount lead, inner lead, excitation light source (first luminous body), phosphor-containing resinous part, conductive wire and mold member, respectively.

Fig. 2(b) shows a typical example of a light emitting device generally called a surface-mount type. It is a schematic sectional view illustrating an example of the light emitting device comprising an excitation light source (first luminous body) and a phosphor-containing part (second luminous body). In the Figure, the numeral 22, numeral 23, numeral 24, numeral 25 and numerals 26, 27 indicate an excitation light source (first luminous body), a phosphor-containing resinous part as phosphor-containing part (second luminous body), a frame, a conductive wire and electrodes, respectively.

[5-4. Use of light emitting device]

There is no special limitation on the use of the light emitting device of the present invention, and therefore it can be used in various fields where a usual light emitting device is used. Owing to its high color rendering, it can be particularly preferably used as a light source of lighting systems or image displays.

[5-4-1. Lighting system]

An application of a light emitting device of the present invention to an illuminating device can be carried out by incorporating a light emitting device such as described earlier into a known lighting system as appropriate. A surface-emitting lighting system (11), shown in Fig. 3, in which the aforementioned light emitting device (4) is incorporated, can be cited as such an example.

Fig. 3 is a sectional view schematically illustrating an embodiment of the lighting system of the present invention. As shown in this Fig. 3, the surface-emitting lighting system comprises a large number of light emitting devices (13) (corresponding to the aforementioned light emitting device (4)) on the bottom surface of a rectangular holding case (12), of which inner surfaces are made to be opaque ones such as white smooth surfaces, and a power supply, circuit or the like (not shown in the figure) for driving the light emitting devices (13) outside the holding case. In addition, it comprises a milky-white diffusion plate (14), such as an acrylic plate, at the place corresponding to the cover part of the holding case (12), for homogenizing the light emitted.

When the surface-emitting lighting system (11) is driven by means of applying a voltage to the excitation light source (the first luminous body) of the light emitting device (13), light is emitted from the light source and the aforementioned phosphor in the phosphor-containing resinous part, which serves as phosphor-containing part (the second luminous body), absorbs a part of the emitted light and emits visible light. On the other hand, the blue light that is not absorbed in the phosphor is mixed with the visible light to form a light emission with high color rendering, and then the mixed light passes through the diffusion plate (14) to be radiated in the upward direction of the figure. Consequently, an illumination light with a brightness that is uniform within the surface of the diffusion plate (14) of the holding case (12) can be obtained.

[5-4-2. Image display]

When the light emitting device of the present invention is used as a light source in a display, there is no limitation on the concrete configuration of the image display. However, it is preferable to be used together with a color filter. For example, a color image display, which is a kind of image display, utilizing a color liquid-crystal display element can be formed by combining the above-mentioned light emitting device as the backlight, an optical shutter utilizing a liquid crystal, and a color filter having red, green and blue picture elements.

When the light emitting device of the present invention is used as a backlight for a color image display, wide color reproduction of the entire image can be achieved without impairing brightness of the image by combining an appropriate color filter. In addition, by carrying out light emission of red, green, and blue with a single chip, the productivity of implementation is maintained. Furthermore, it is easy to calibrate the white balance.

Moreover, backlights and color image displays using a light emitting device of the present invention have the following advantageous effects when the light emitting device is constituted by combining a phosphor of the present invention and a specific phosphor.

(1) External quantum efficiency of the phosphor is enhanced, and therefore, a sufficient amount of light can be supplied from the backlight.

(2) Magnitudes of the emission intensity changes of different-color phosphors can be synchronized by approximately equalize the rates of emission-peak intensity change due to temperature change of the different-color phosphors, making use of the temperature characteristics of the respective phosphors. Thereby, the color shift of the entire backlight can be reduced.

(3) When a color image display is constituted by incorporating color filters, the color shift of the entire display can be reduced by making the rate of emission-peak intensity change of blue phosphors larger than those of green phosphors and red phosphors.

In the above context, the rate of emission-peak intensity change means the ratio (%) of a peak intensity value of emission at a specific temperature, with the emission-peak intensity at 25°C taken as 100.

In addition, the performance of the entire color image display can be improved by specifying the relationship between the NTSC ratio and the light utilization efficiency.

Conventionally, NTSC ratio and light utilization efficiency have been in a trade-off relationship. That is, for improving performance of a color image display, there was no other choice but either to improve NTSC ratio at the expense of light utilization efficiency or to improve light utilization efficiency at the expense of NTSC ratio.

In contrast, the present inventors have found a backlight of which light emission efficiency can be set higher than previous ones by incorporating a plurality of phosphors that can be efficiently excited and emit light of which luminous wavelengths are improved by a luminous element having a specific luminous wavelength. Furthermore, they have found that image displaying of high color purity can be realized by incorporating into the backlight a color filter that is the most suitable for the luminous wavelength of the backlight. In other words, they have found that a color image display with higher light utilization efficiency than previous ones can be obtained even when it has a high NTSC ratio.

Namely, the (semiconductor) light emitting devices, backlights, and color image displays (hereinafter also referred to as "semiconductor light emitting devices of the present invention", "backlights of the present invention", and "color image displays of the present invention", respectively) having the following subject matters [1] to [19] are remarkably high in industrial applicability from the above-mentioned standpoints. In what follows, the "solid luminous element" has the same meaning as the aforementioned "first luminous body".

[1] A semiconductor light emitting device constituted by combining a solid luminous element that emits light of ultraviolet to near-ultraviolet region and phosphor that emits light when excited by the light from the solid luminous element, wherein the phosphor comprises a blue phosphor having one or more emission peaks in a wavelength region of 430 nm to 470 nm, a green phosphor having one or more emission peaks in a wavelength region of 500 nm to 540 nm, and a red phosphor having one or more emission peaks in a wavelength region of 600 nm to 680 nm, and
one or more of the following conditions are satisfied:

the external quantum efficiency of the blue phosphor when excited with an excitation light of 395-nm wavelength is 77% or higher,
the external quantum efficiency of the green phosphor when excited with an excitation light of 395-nm wavelength is 70% or higher, and
the external quantum efficiency of the red phosphor when excited with an excitation light of 395-nm wavelength is 50% or higher.

[2] The semiconductor light emitting device according to the above-mentioned [1], wherein, the difference between the largest and the smallest rates of emission-peak intensity change, under excitation by 395-nm wavelength light from 25°C to 150°C, of the above-mentioned blue, green, and red phosphors is 25% or smaller.

[3] A semiconductor light emitting device constituted by combining a solid luminous element that emits light of ultraviolet to near-ultraviolet region and phosphor that emits light when excited by the light from the solid luminous element, wherein
the phosphor comprises a blue phosphor having one or more emission peaks in a wavelength region of 430 nm to 470 nm, a green phosphor having one or more emission peaks in a wavelength region of 500 nm to 540 nm, and a red phosphor having one or more emission peaks in a wavelength region of 600 nm to 680 nm, and
the rate of emission-peak intensity change under excitation by 395-nm wavelength light from 25°C to 150°C of the blue phosphor is larger than those of the green phosphor and the red phosphor.

[4] The semiconductor light emitting device according to the above-mentioned [3], wherein the difference in the rate of emission-peak intensity change, under excitation by 395-nm wavelength light from 25°C to 150°C, of the above-mentioned blue phosphor compared to the above-mentioned green and red phosphors is 10% or larger and 25% or smaller.

[5] The semiconductor light emitting device according to any one of the above-mentioned [1] to [4], wherein the rates of emission-peak intensity change, under excitation by 395-nm wavelength light from 25°C to 150°C, of the above-mentioned blue, green, and red phosphors are all 25% or smaller.

[6] The semiconductor light emitting device according to any one of the above-mentioned [1] to [5], wherein the above-mentioned solid luminous element is sealed with a silicone material.

[7] The semiconductor light emitting device according to the above-mentioned [6], wherein the above-mentioned silicone material contains the above-mentioned phosphor.

[8] A backlight comprising, as light source, a semiconductor light emitting device according to any one of the above-mentioned [1] to [7].

[9] The backlight according to the above-mentioned [8], further comprising an absorption part that absorbs light of ultraviolet to near-ultraviolet region emitted from the above-mentioned semiconductor light emitting device.

[10] A color image display constituted by combining an optical shutter, a color filter corresponding to said optical shutter and comprising at least trichromatic components of red, green, and blue, and a backlight for transillumination, wherein
a light source used for said backlight comprises a semiconductor light emitting device in which phosphor is combined with solid luminous element that emits light of ultraviolet to near-ultraviolet region, and
the relationship between NTSC ratio W, which is a ratio of color reproduction range of color image display elements, and light utilization efficiency Y is represented by the formula below.
$Y \geq -0.24W+49$ (where, $W \geq 87$)

[Mathematical Formula 14]

$$X = \frac{\int_{380}^{780} \bar{x}(\lambda)S(\lambda)T(\lambda)d\lambda}{\int_{380}^{780} \bar{y}(\lambda)S(\lambda)d\lambda} \qquad x = \frac{X}{X+Y+Z}$$

$$Y = \frac{\int_{380}^{780} \bar{y}(\lambda)S(\lambda)T(\lambda)d\lambda}{\int_{380}^{780} \bar{y}(\lambda)S(\lambda)d\lambda} \qquad y = \frac{Y}{X+Y+Z}$$

$$Z = \frac{\int_{380}^{780} \bar{z}(\lambda)S(\lambda)T(\lambda)d\lambda}{\int_{380}^{780} \bar{y}(\lambda)S(\lambda)d\lambda}$$

where, the symbols in the above formula are defined as follows.

[Mathematical Formula 15]

$\bar{x}(\lambda), \bar{y}(\lambda), \bar{z}(\lambda)$ : Color-matching function in a XYZ colorimetric-system

$S(\lambda)$ : Relative emission distribution spectrum of a backlight

$T(\lambda)$ : Transmittance of a color filter

[11] A color image display according to the above-mentioned [10], wherein the above-mentioned light source has one or more emission peaks in wavelength regions of 430 nm to 470 nm, 500 nm to 540 nm, and 600 nm to 680 nm, respectively.

[12] A color image display according to the above-mentioned [10] or [11], wherein the above-mentioned phosphor comprises a europium-activated red phosphor having an emission spectral component in a wavelength region of 600 nm to 680 nm.

[13] A color image display according to the above-mentioned [12], wherein the above-mentioned red phosphor comprises one or more compounds selected from oxysulfide phosphors, oxide phosphors, nitride phosphors, and oxynitride phosphors.

[14] A color image display according to any one of the above-mentioned [10] to [13], wherein the above-mentioned phosphor contains a cerium-activated and/or europium-activated green phosphor having an emission spectral component in a wavelength region of 500 nm to 540 nm.

[15] A color image display according to the above-mentioned [14], wherein the above-mentioned green phosphor comprises one or more compounds selected from aluminate phosphors, silicate phosphors, and oxynitride phosphors.

[16] A color image display according to any one of the above-mentioned [10] to [15], wherein the above-mentioned phosphor contains a europium-activated blue phosphor having an emission spectral component in a wavelength region of 430 nm to 470 nm.

[17] A color image display according to the above-mentioned [16], wherein the above-mentioned blue phosphor comprises one or more compounds selected from halophosphate phosphors, and aluminate phosphors.

[18] A color image display according to any one of the above-mentioned [10] to [17], further comprising an absorption part that absorbs light of ultraviolet to near-ultraviolet region emitted from the above-mentioned light source.

[19] A color image display according to any one of the above-mentioned [10] to [18], wherein each picture element of the above-mentioned color filter has a film thickness of 0.5 μm or larger and 3.5 μm or smaller.

In each invention mentioned above, the "color image display" means the whole structure including an optical shutter, a color filter, and a backlight, as well as their driving circuit, control circuit, and the like, with which color images can be displayed under control by input signals. On the other hand, the "color image display element" means the structure of the "color image display" except the components for controlling the optical shutter and backlight operation, by which light can be emitted from the backlight through the optical shutter and color filter.

According to the present invention, wide color reproduction of the entire image, including deep red and green reproduction, can be achieved without impairing brightness of the image either by using an light emitting device as light source in which a luminous element having a specific emission wavelength and a phosphor of specific characteristics are combined or by specifying an appropriate relationship between the NTSC ratio and the light utilization efficiency. In addition, in the present color image display, since the light emission of red, green, and blue can be carried out only with a single chip, the productivity of implementation is maintained. Furthermore, it is easy to calibrate the white balance.

The color image display element of the present invention is characterized in that, further by the structure described in detail below, it has a relationship between the color reproduction range (NTSC ratio) W of the color image display element and the light utilization efficiency Y described below represented by the formula (a) below, preferably the formula (b) below.

$$Y \geq -0.24W+49 \quad \cdots \quad (a)$$

$$Y \geq -0.24W+51 \quad \cdots \quad (b)$$

[Mathematical Formula 16]

$$X = \frac{\int_{380}^{780} \bar{x}(\lambda)S(\lambda)T(\lambda)d\lambda}{\int_{380}^{780} \bar{y}(\lambda)S(\lambda)d\lambda} \qquad x = \frac{X}{X+Y+Z}$$

$$Y = \frac{\int_{380}^{780} \bar{y}(\lambda)S(\lambda)T(\lambda)d\lambda}{\int_{380}^{780} \bar{y}(\lambda)S(\lambda)d\lambda} \qquad y = \frac{Y}{X+Y+Z}$$

$$Z = \frac{\int_{380}^{780} \bar{z}(\lambda)S(\lambda)T(\lambda)d\lambda}{\int_{380}^{780} \bar{y}(\lambda)S(\lambda)d\lambda}$$

where, the symbols in the above formula are defined as follows.

[Mathematical Formula 17]

$\bar{x}(\lambda), \bar{y}(\lambda), \bar{z}(\lambda)$ : Color-matching function in a XYZ colorimetric-system

$S(\lambda)$ : Relative emission distribution spectrum of a backlight

$T(\lambda)$ : Transmittance of a color filter

Conventionally, light utilization efficiency can be controlled to some degree up to 85% NTSC ratio. However, a color image display of which structure excels in the light utilization efficiency can not be arrived at even by those skilled in the art, when the NTSC ratio thereof is set at over 85%, namely, when it is set at usually 87% or larger, preferably 90% or larger, particularly 100% or larger. Because of emission spectrum characteristics of the pigment or phosphor used for the resist of conventional color filters and of the backlight in which a semiconductor luminous element and a phosphor are combined.

In the color image display of the present invention, the relationship between the NTSC ratio W and the light utilization efficiency Y is set as follows.

(i) A simulated color filter is created by calculation so that the NTSC ratio of the color image display takes values of 100% and 110%, on the basis of the emission spectrum (actual measured value) of a backlight of a color image display constituted by combining a specific new backlight and a color filter and having an NTSC ratio of over 95%.

(ii) In a simulated color image display comprising the simulated color filter of the above-mentioned (i), light utilization efficiencies are calculated at two NTSC ratios of 100% and 110%. In the present invention, two points of (NTSC ratio, light utilization efficiency) are calculated as (100%, 31.6) and (110%, 29.2).

(iii) The linear function (a) passing through an actual measured value (105%, 23.7) in the color image display of the above-mentioned (ii) is determined taking the gradient of the line connecting the two points calculated in the above-mentioned (ii) as gradient of the relational expression between the NTSC ratio W and the light utilization efficiency Y.

$$Y = -0.24W+49 \quad \cdots \quad (a)$$

In addition, a preferable color image display can be cited of which relationship between the NTSC ratio W and the light utilization efficiency Y is represented by the formula (b) below, which is a linear function passing through an actual measured value (110%, 24.6) in the color image display.

$$Y = -0.24W+51 \quad \cdots \quad (b)$$

Furthermore, another preferable color image display can be cited of which relationship between the NTSC ratio W and the light utilization efficiency Y is represented by the formula (c) below, which is a linear function passing through an actual measured value (108%, 27.4) in the color image display.

$$Y = -0.24W+53 \quad \cdots \quad (c)$$

Fig. 4 shows graphs of the formulae (a), (b), and (c), which represent relationships between the NTSC ratio and the light utilization efficiency.

In the present invention, light utilization efficiencies Y can be specifically calculated by substituting, into the above-mentioned formula, relative emission spectrum S(λ) of the backlight measured with a high-brightness measurement apparatus and transmittance spectrum T(λ) of the color filter measured with a spectrophotometer.

The color image display has a feature of wide color reproduction. Namely, in the color image display of the present invention, which is constituted by combining an optical shutter, a color filter corresponding to the optical shutter and comprising at least trichromatic components of red, green, and blue, and a backlight for transillumination, a light source used for the backlight comprises a semiconductor light emitting device in which phosphor is combined with solid luminous element that emits light of ultraviolet to near-ultraviolet region, and has one or more emission main components in wavelength regions of 430 nm to 470 nm, 500 nm to 540 nm, and 600 nm to 680 nm, respectively. Therefore, color reproduction range of the color image display element is usually 60% or larger in NTSC ratio. The NTSC ratio is preferably 70% or larger, more preferably 80% or larger, still more preferably 90% or larger, and particularly preferably 100% or larger.
In addition, the color image display has a color temperature of usually 5000 K or higher, preferably 5500 K or higher, more preferably 6000 K or higher, and usually 10000K or lower, preferably 9500 K or lower, more preferably 9000 K or lower. When the color temperature is too low, the image displayed may be reddish as a whole. When it is too high, brightness may deteriorate.

[Backlight device]

Explanation will be given on the constitution of the backlight device used for such a color liquid crystal display. The backlight device used for the present invention indicates a planar light source device that is used as backlight source of a transmissive or semi-transmissive color liquid crystal display by being disposed at the backside of a liquid crystal panel. The backlight device comprises a light source emitting white light and an optical homogenizer that converts the light from the light source into almost homogenous, planar light.
Typical examples of installation configuration of such light sources include a method in which a light source is installed directly beneath the backside of the liquid crystal elements (namely, direct type) and one in which light from a light source installed on the lateral side is converted into planar light using a light-transmissible optical waveguide such as acrylic plate to form a planar light source (namely, sidelight type). Of these, sidelight type is preferable for a planar light source that is thin and superior in uniformity of brightness distribution, and such type of light sources are in practical use most widely at present. Sidelight-type backlight devices can make use of characteristics of liquid crystal displays such as light weight and reduced thickness more effectively.
The light source of a backlight device of the present invention has a feature of containing an LED (hereinafter referred to as light-emitting diode as appropriate) in its constitution. Any type of light source can be used insofar as it is generally a type having light emissions in red, green, and blue wavelength regions, namely, in ranges of 580 nm to 700 nm, 500 nm to 550 nm, and 400 nm to 480 nm.
In order for the backlight to meet such a condition, the light source comprises a semiconductor light emitting device constituted by combining a solid luminous element that emits light of ultraviolet to near-ultraviolet region and phosphor that is excited by the light from the solid luminous element. The semiconductor light emitting device is adjusted to have one or more emission main components in respective wavelength regions of red (usually 600 nm or longer, preferably 610 nm or longer, more preferably 620 nm or longer, and usually 680 nm or shorter, preferably 670 nm or shorter), green (usually 500 nm or longer, preferably 510 nm or longer, and usually 540 nm or shorter, preferably 535 nm or shorter, still more preferably 530 nm or shorter, particularly preferably 525 nm or shorter, still particularly preferably 520 nm or shorter), and blue (usually 430 nm or longer, preferably 440 nm or longer, and usually 470 nm or shorter, preferably 460 nm or shorter).
Light quantities of respective red, green, and blue regions of transmissive or semi-transmissive transmission methods are calculated as a product of the light emission from the backlight and the spectral transmittance of the color filter. Accordingly, color materials used for compositions for color filters should be adjusted and a backlight that can meet a specific condition should be selected.
Specific examples of a backlight device of the present invention will be described below. However, the backlight device of the present invention is not limited those examples insofar as it can meet the above-mentioned condition.
The luminous wavelength of the solid luminous element is usually 350 nm or longer, preferably 380 nm or longer, more preferably 390 nm or longer, and usually 420 nm or shorter, preferably 410 nm or shorter, more preferably 405 nm or shorter. As the solid luminous element, ultraviolet to near-ultraviolet LEDs can be preferably used. Ultraviolet to near-ultraviolet LEDs are used preferably from the following standpoints.

(i) Since they have wavelengths that can excite phosphors efficiently, a light source with large light quantity can be obtained.
(ii) Since all of red, green and blue lights are taken out not from the LED directly but from phosphors as fluorescences, the red, green and blue lights are radiated in all direction from the light source uniformly.

As the solid luminous element, InGaN, GaAlN, InGaAlN, ZnSeS, or the like semiconductor luminous elements can be preferably used in which crystals are grown by MOCVD method or the like on a substrate made of silicon carbide, sapphire, gallium nitride, or the like. To obtain high power, the light source can be upsized, or two or more of light sources can be provided. The solid luminous element can also be a laser diode of edge-emitting type or surface-emitting type.

The solid luminous element is usually fixed to a frame. In the frame, there is provided positive and negative electrodes for energizing at least the solid luminous element light source, and the electrodes are electrically connected with the electrodes of the solid luminous element. These electrodes can be connected electrically to each other by, for example, wire bonding or flip-chip mounting. When using wire bonding, a gold wire or an aluminium wire, measuring 20 μm to 40 μm in diameter, can be selected.

It is preferable that a concave cup is formed in the frame and the solid luminous element is disposed at the bottom thereof because a directivity can then be given to the outgoing light so as to make effective use of the light. In addition, the reflectance with respect to the entire visible lights can be enhanced by plating the inner surface of the frame concavity or the entire frame with a high-reflectance metal such as silver, platinum, or aluminium or with an alloy of the same characteristics. This is more preferable because utilization efficiency of the light can then be improved. Forming the surface of the frame concavity or the entire frame with a resin used for injection moldings which contains a high-reflectance material such as white glass fiber, alumina powder, or titanium powder can also produce the same effect.

For fastening the solid luminous element, epoxy, imide, or acrylic adhesives, solders such as AuSn or AgSn, or bumps such as Au can be used, for example.

When current is carried to the solid luminous element through an adhesive, it is preferable to use an adhesive containing a conductive filler like silver particulates, such as silver paste or carbon paste and apply it thinly and uniformly. When fastening a light-emitting diode or laser diode of heavy current type, in which heat dissipating property is particularly critical, it is effective to use solder for the fastening. When current is carried to the solid luminous element through other than the adhesive, any kind of adhesive can be used. However, in the case where heat dissipation is important, it is preferable to use silver paste or a solder.

When using two or more solid luminous elements, use of solder may deteriorate the solid luminous elements because they are then exposed to high temperatures repeatedly or for a long time. On the other hand, bumps can be used for connecting the solid luminous elements and the frame more easily and securely, since they can be treated at lower temperatures than solders. Particularly when using a flip chip LED, use of silver paste adhesive may cause a short between p-type and n-type electrodes. However, there is no need to worry about it with bumps, and therefore, bumps can then be used preferably.

For the semiconductor light emitting device to have one or more emission main components in each wavelength region of the above-mentioned red, green, and blue, it is preferable to combine three or more kinds of phosphors including a phosphor emitting a fluorescence of blue region (blue phosphor), a phosphor emitting a fluorescence of green region (green phosphor), and a phosphor emitting a fluorescence of red region (red phosphor). These respective color phosphors are usually mixed in a transparent binder such as epoxy resin or silicone resin and applied so that it covers the solid luminous element. The mixing ratio of each color phosphor can be changed as appropriate so as to obtain the desired chromaticity. In addition, the blue, green, and red phosphors can be applied to the solid luminous element separately. A binder added with a diffusing agent can further homogenize the outgoing light. As such diffusing agent, a colorless material of 100 nm to several tens μm in mean particle diameter can be preferably used. For example, alumina, zirconia, or yttria can be preferably used as the diffusing agent because they are stable in a practical temperature range of from -60°C to 120°C. A diffusing agent with high refractive index is more preferable because diffusion effect is then enhanced. When using a phosphor with large particle diameter, it is preferable for the binder to contain an antisettling agent to prevent color heterogeneity or color shift due to a sedimentation of the phosphor. Fumed silica is generally used as an antisettling agent.

It is preferable that the solid luminous element is sealed with a sealant. When the solid luminous element is sealed with a sealant, the phosphor can be contained in that sealant.

There is no special limitation on the kind of the sealant. Usually, a curable material that can be molded to cover the solid luminous element is used. The curable material indicates a fluid material that can be cured by a certain curing treatment. Liquid media described in the section [4-2. Liquid medium] can be used, for example.

[Phosphor]

When the phosphor comprises a red phosphor, a green phosphor, and a blue phosphor of the present invention, it is preferable that the phosphors of respective colors have the characteristics described below.

[External quantum efficiency]

In the phosphors used for the present invention, it is preferable that one or more of the following conditions A to C, with respect to the external quantum efficiency under excitation by a light of 395-nm wavelength, are satisfied.
(Condition A) The external quantum efficiency of the blue phosphor is 77% or higher, preferably 78% or higher, more preferably 79% or higher.

(Condition B) The external quantum efficiency of the green phosphor is 70% or higher, preferably 73% or higher, more preferably 75% or higher.

(Condition C) The external quantum efficiency of the red phosphor is 50% or higher, preferably 70% or higher, more preferably 75% or higher.

Meeting one or more of the above conditions A to C can obtain a light emitting device with high emission intensity. A display in which such a light emitting device is used as the light source of the backlight can show bright images.

External quantum efficiency (hereinafter also represented by "$\eta_o$") is the ratio of the number of photons emitted from a phosphor relative to the number of photons in the light (excitation light) emitted from an excitation light source (here, the solid luminous element). The external quantum efficiency corresponds to the product of absorption efficiency (hereinafter also represented by "$\alpha_q$") described later and internal quantum efficiency $\eta_i$ (hereinafter also represented by "$\eta_i$") described later. Namely, the external quantum efficiency $\eta_o$ is defined by the following formula.

$$(\text{External quantum efficiency } \eta_o) = (\text{Absorption efficiency } \alpha_q) \times (\text{Internal quantum efficiency } \eta_i)$$

The absorption efficiency $\alpha_q$ is the ratio of the number of photons absorbed in a phosphor relative to the number of photons in the excitation light. The higher the absorption efficiency $\alpha_q$ of the phosphor is, the more preferable.

Specifically, it is preferable that the absorption efficiencies $\alpha_q$ of the phosphors when excited with a light of 395-nm wavelength are as follows. The absorption efficiency $\alpha_q$ of the blue phosphor is usually 80% or higher, preferably 84% or higher, more preferably 85% or higher. The absorption efficiency $\alpha_q$ of the green phosphor is usually 75% or higher, preferably 80% or higher, more preferably 85% or higher. The absorption efficiency $\alpha_q$ of the red phosphor is usually 75% or higher, preferably 80% or higher, more preferably 85% or higher. When the absorption efficiency $\alpha_q$ of a phosphor is too low, quantity of the excitation light necessary for a predetermined level of light emission tends to be too large, leading to a large amount of energy consumption. This results in decrease in emission efficiency.

Internal quantum efficiency $\eta_i$ is the ratio of the number of emitted photons from a phosphor relative to the number of photons in the excitation light that is absorbed into the phosphor. The higher the internal quantum efficiency $\eta_i$ of the phosphor is, the more preferable.

Specifically, it is preferable that the internal quantum efficiencies $\eta_i$ of the phosphors when excited with a light of 395-nm wavelength are as follows. The internal quantum efficiencies $\eta_i$ of the blue phosphor is usually 79% or higher, preferably 85% or higher, more preferably 90% or higher. The internal quantum efficiencies $\eta_i$ of the green phosphor is usually 75% or higher, preferably 80% or higher, more preferably 85% or higher. The internal quantum efficiencies $\eta_i$ of the red phosphor is usually 65% or higher, preferably 80% or higher, more preferably 85% or higher. When the internal quantum efficiency $\eta_i$ of a phosphor is too low, quantity of the excitation light necessary for a predetermined level of light emission tends to be too large, leading to a large amount of energy consumption. This results in decrease in emission efficiency.

Methods for determining the absorption efficiency $\alpha_q$, internal quantum efficiency $\eta_i$, and external quantum efficiency $\eta_o$ of phosphors are the same as those described in the section [Absorption efficiency $\alpha_q$, internal quantum efficiency $\eta_i$, external quantum efficiency $\eta_o$] of the chapter [1-2. Characteristics of phosphor].

[Temperature dependence of emission-peak intensity]

The light emitted from the solid luminous element is absorbed in the phosphor and a binder holding the phosphor. The binder thereby generates heat and the phosphor is thereby heated. In addition, the phosphor itself generates heat by absorbing lights emitted from the solid luminous element. Furthermore, when the solid luminous element emits light by energization, the luminous element generates heat due to internal electrical resistance of the solid luminous element. As that temperature rises, the phosphor is heated by the heat transferred. By these heating action, the temperature of the phosphor usually reaches 150°C or so. Emission-peak intensity of phosphors depends on its temperature. The higher the phosphor temperature becomes, the lower the emission-peak intensity tends to be. Therefore, in order to keep the color tone unchanged as a whole even after a continuous irradiation by the solid luminous element, it is preferable to prevent the emission-peak intensities of the respective color phosphors from getting far out of balance even if they are changed by a temperature rising.

Therefore, when the external quantum efficiencies of the respective color phosphors meet one or more of the aforementioned conditions A to C, it is preferable that the difference between the largest and the smallest rates of emission-peak intensity change, under excitation by 395-nm wavelength light from 25°C to 150°C, of the blue, green and red phosphors is 25% or smaller. This makes it possible to keep the color tone of the light emitted from the light emitting device unchanged as a whole, because changes in the emission-peak intensities, caused by a temperature rising, of the respective color phosphors are in the same range.
Temperature dependence can be measured specifically as described below, for example.

[Measurement example of temperature dependence]

Temperature dependence can be examined as follows, for example, using a multi-channel spectrum analyzer, MCPD7000, manufactured by Otsuka Electronics Co., Ltd. as emission spectrum measurement device, a luminance colorimeter, BM5A, as brightness measurement device, a stage equipped with a cooling mechanism using a peltiert device and a heating mechanism using a heater, and a light source device equipped with a 150-W xenon lamp.
A cell holding a phosphor sample is put on the stage, and the temperature is changed from 25°C to 150°C, followed by verifying the surface temperature of the phosphor at each temperature. Then, the brightness value and the emission spectrum are measured by exciting the phosphor with a light from the light source having a wavelength of 395 nm, which is separated using a diffraction grating. Then the emission-peak intensity is decided from the measured emission spectrum. At this point, as the measurement values of the surface temperature of the phosphor on the side irradiated with the excitation light, are used values corrected by the temperature values measured with a radiation thermometer and a thermocouple.
In addition to the above-mentioned structure, it is preferable that the rates of emission-peak intensity change, under excitation by 395-nm wavelength light from 25°C to 150°C, of the blue, green, and red phosphors are all 25% or smaller. This makes it possible to prevent, when the temperature of the phosphor is raised, reduction in the emission intensity as a whole while preventing change in the color tone of the light from the light emitting device.
Incidentally, the light emitting device according to the present invention can be used preferably as a light source for a backlight. As an example of the color image display utilizing the backlight can be cited a liquid crystal display such as mentioned before. Liquid crystal displays are constituted by sandwiching a liquid crystal with polarizing plates. As the polarizing plate, a film formed by extending an iodine-containing PVA (polyvinyl alcohol) is usually used. Since the film has a low quenching ratio of blue region (short wavelength region), the leakage of blue lights is large. Therefore, there is a characteristic of bluish black, when displaying black by on-off of the liquid crystal.
On the other hand, among color image displays with so-called a direct type backlight unit, such as those disclosed in Japanese Patent Laid-Open Publication (Kokai) No. 2006-128163 or Japanese Patent Laid-Open Publication (Kokai) No. 2006-351540, is one in which on-off of the light is controlled by the current value of the backlight mentioned above.
In such a case, it is preferable that the black color displayed by a liquid crystal on-off and that displayed by control of the backlight current value are the same.
Therefore, in such a case, it is preferable that the rate of emission-peak intensity change due to temperature rise of the blue phosphor is designed to be larger than those of the green and red phosphors. This makes it possible to display the same bluish black when displaying black as image displays using polarizing plates because the emission intensity of the blue light is relatively high when the light from the backlight is weak relative to when it is strong. This results in the same color tone as when using polarizing plates. Specifically, it is preferable that the rate of emission-peak intensity change under excitation by 395-nm wavelength light from 25°C to 150°C of the blue phosphor is larger than those of the green and red phosphors. In this case, the relationship between the rates of emission-peak intensity change of the respective color phosphors can be set independently of the external quantum efficiencies.
In the above-mentioned structure, more specifically, it is more preferable that the difference in the rate of emission-peak intensity change from 25°C to 150°C, of the blue phosphor compared to the green and red phosphors is 10% or larger and 25% or smaller.
In addition to the above-mentioned structure, it is more preferable that the rates of emission-peak intensity change, under excitation by 395-nm wavelength light from 25°C to 150°C, of the blue, green, and red phosphors are all 25% or smaller. This makes it possible to prevent, when the temperature of the phosphor is raised, reduction in the emission intensity as a whole while preventing change in the color tone of the light from the light emitting device.

[Preferable combination of respective color phosphors]

The red, green, and blue phosphors have been explained above. Examples of preferable combinations of those respective color phosphors are listed in Table 5.

[Table 5]

| [Table 5] | |
|---|---|
| Red phosphor | one or more kinds of:<br>Eu-activated oxysulfide phosphor such as $(La,Y)_2O_2S:Eu$;<br>Eu-activated oxide, nitride or oxynitride phosphor such as $(Mg,Ca,Sr,Ba)AlSi(N,O)_3:Eu$; and Eu-activated oxynitride phosphor such as Eu-activated $\alpha$-sialon |
| Green phosphor | one or more kinds of:<br>Eu,Mn-activated aluminate phosphor such as $BaMgAl_{10}O_{17}:Eu, Mn$;<br>Eu-activated silicate phsophor such as $(Ba,Sr,Ca,Mg)2SiO_4:Eu$;<br>Eu-activated oxynitride phsophor such as Eu-activated $\beta$-sialon; and<br>Eu-activated oxynitride phosphor such as $M_3Si_6O_{12}N_2:Eu$ (here, M represents alkaline earth metal element) |
| Blue phosphor | one or more kinds of:<br>Eu-activated halophosphate such as $(Sr,Ca,Ba,Mg)_{10}(PO_4)_6(Cl,_F)_2:Eu$; and<br>Eu-activated aluminate phosphor such as (Ca, Sr, Ba) $MgAl_{10}O_{17}:Eu$ |

Table 6 shows more preferable combinations of the combinations listed in Table 5.

[Table 6]

| [Table 6] | |
|---|---|
| Red phosphor | one or more kinds of:<br>$(Ca,Sr,Ba)_2Si_5(N,O)_8:Eu$;<br>$(Sr,Ca)AlSiN_3:Eu$; and<br>$(La,Y)_2O_2S:Eu$ |
| Green phosphor | one or more kinds of:<br>$BaMgAl_10O_{17}:Eu,Mn$;<br>$(Ba,Sr,Ca)\ _2SiO_4:Eu$;<br>Eu-activated $\beta$-sialon; and<br>$(Ba,Sr,Ca)\ _3Si_6O_{12}N_2:Eu$ |
| Blue phosphor | one or more kinds of:<br>$(Sr,Ca,Ba,Mg)_{10}(PO_4)_6(Cl,F)_2:Eu$; and<br>$(Ca,Sr,Ba)MgAl_1O_{17}:Eu$ |

Moreover, Table 7 shows a particularly preferable combination.

[Table 7]

| [Table 7] | |
|---|---|
| Red phosphor | $(Sr,Ca)AlSiN_3:Eu$ |
| Green phosphor | $BaMgAl_{10}O_{17}:Eu,Mn$ |
| Blue phosphor | $(Sr,Ca,Ba,Mg)_{10}(PO_4)_6Cl_2:Eu$ |

Of the respective color phosphors listed in Tables 5 to 7, it is preferable to select phosphors that can be excited by lights of ultraviolet to near-ultraviolet region, have an emission of narrow wavelength width in the corresponding red, green, or blue region, and exhibits an excellent temperature characteristic of hardly varying in emission-peak intensity due to temperature changes.

Therefore, by combining three or more kinds of phosphors including these respective color phosphors with a solid luminous element emitting light of ultraviolet to near-ultraviolet region, a semiconductor light emitting device, suitable for the light source used for the backlight of the color image display of the present invention, can be obtained of which emission efficiency can be set higher than in the past.

When a sealant is used for the semiconductor light emitting device, it is preferable to use a silicone material described earlier as the sealant from the standpoint of resistance to deterioration due to irradiation of ultraviolet to near-ultraviolet wavelength region and heat resistance. Among others, it is more preferable to use a condensing type silicone material.
Furthermore, a displaying of high color purity can be realized by using a color filter that is the most suitable for the luminous wavelength of the above-mentioned semiconductor light emitting device. That is, by using the above-mentioned semiconductor light emitting device in which a red, green, and blue phosphors that are high in emission intensities in a narrow wavelength range and superior in temperature characteristics as the light source for the backlight, an excellent color image display can be obtained that exhibits higher light utilization efficiency than in the past even with a high NTSC ratio and shows stable emission intensity and little color shift even when the temperature of the semiconductor light emitting device is raised due to heat generated by driving a solid luminous element used.

[Color filter]

There is no special limitation on the color filter used for the color image display of the present invention. For example, those described below can be used.
Color filters comprise a transparent substrate made of glass or the like and fine picture elements of red, green, blue or the like formed on the substrate by a method such as staining, printing, electrodeposition, or pigment dispersion. In many cases, a light shielding pattern called black matrix is provided at the gaps between the picture elements for the sake of cutoff of light leakage from the gaps between the picture elements and image displaying with higher quality.
In a staining method, color filters are manufactured by forming an image with a photosensitive resin, in which a bichromate is mixed as a photosensitizing agent with gelatin or polyvinyl alcohol, and subsequently stainning it, for example.
In a printing method, color filters are manufactured by transferring a heat curing or light curing ink to a transparent substrate made of glass or the like in such a way as screen printing, gravure printing, flexography, reverse printing, soft lithography (imprint printing), or the like, for example.
In an electrodeposition method, color filters are formed by immersing a transparent substrate made of glass or the like on which electrodes are provided in a bath containing a pigment or a dye and subjecting it to an electrophoresis, for example.
In a pigment dispersion method, a pattern of a color filter is formed by applying a composition in which a color material such as pigment is dispersed or dissolved in a photosensitive resin on a transparent substrate made of glass or the like to form a coated film, exposing it to radiation via a photomask, and removing unexposed area with a developer, for example.
Other examples of methods for forming color filters include: applying a polyimide resinous composition in which a color material is dispersed or dissolved, followed by forming pixel images by etching; affixing a film, on which a resinous composition containing a color material is coated, on a transparent substrate, peeling off it, and exposing and developing it to form pixel images; and forming pixel images by an ink jet printer.
In production of color filters for liquid-crystal display elements of recent years, the pigment dispersion method has been predominant in terms of its high productivity and excellent micro manipulation properties. However, any of the above-mentioned methods can be used for producing color filters according to the present invention.
Examples of methods for forming a black matrix include: forming a chromium and/or chromium oxide layer (single or laminated layer) on a transparent substrate made of glass or the like by sputtering or the like, followed by removing only its color pixel part by etching; and applying a photosensitive composition, in which a light shielding component is dispersed or dissolved, on a transparent substrate made of glass or the like to form a coated film, exposing it to radiation via a photomask, followed by removing the unexposed area with a developer to form a pattern.

[Production method of color filter]

In what follows, an example of production method of a color filter according to the present invention is described. A color filter according to the present invention can be usually produced by forming red, green, and blue pixel images on a transparent substrate provided with a black matrix. In forming each color pixel on the transparent substrate, basically, their pigments contained and film thicknesses should be optimized so that the peak wavelengths of the backlight emission spectrum existing in the red, blue, and green regions are allowed to transmit best. More specifically, an optimized pigment and film thickness is determined by calculating the white point, the chromaticity index of the backlight spectrum, and the desired NTSC ratio with a color matching system.
When producing a color image display with an NTSC ratio of 90% or higher, preferably 100% or higher in the present invention, it is important to select an optimum combination of color materials such as pigments. Particularly for the green phosphor, it is preferable to use pigment green 7 or zinc bromide phthalocyanine pigment in place of pigment green 36, from the standpoint of film-formation capability.
Regarding the zinc bromide phthalocyanine, one that contains an average of 13 or more bromine atoms per molecule is preferable because it has high transmittance and is suitable for forming green pixels of color filters. More preferable is a zinc bromide phthalocyanine that contains 13 to 16 bromine atoms per molecule and zero or an average of 3 or less chlorine atoms per molecule. Particularly preferable is a zinc bromide phthalocyanine that contains an average of 14 to 16 bromine atoms per molecule and zero or an average of 2 or less chlorine atoms per molecule.
When using pigment green 36, there is a possibility of faulty development or defects and foreign matters in a die coating treatment due to high pigment concentration. For example, when producing the color filter of the backlight of Example II-3 described later using pigment green 36 for green resist (Mixture Example 1), the sum of the pigment concentration is 37.6 weight % as shown in table 8. On the other hand, when using pigment green 7 for the green resist of the color filter (Mixture Example 2), the sum of the pigment concentration is 31.9 weight %, and when using zinc bromide phthalocyanine (Mixture Example 3), the sum is 32.9 weight %. These Mixture Examples 1, 2, and 3 correspond to Examples II-2, II-4, and II-6 to be described later, respectively.
[Table 8]

| [Table 8] | | | | | |
|---|---|---|---|---|---|
| | pigment green 36 | pigment green 7 | zinc bromide phthalocyanine | pigment yellow 150 | clear resist |
| Mixture Example 1 | 14.3 | | | 22.6 | 63.1 |
| Mixture Example 2 | | 9.8 | | 22.1 | 68.1 |
| Mixture Example 3 | | | 18.0 | 17.0 | 65.1 |

The particularly preferable combination of pigments for the green resist is zinc bromide phthalocyanine and pigment green 150, or particularly 7 and pigment yellow 150, for producing in the present invention a color image display with an NTSC ratio of 90% or higher, particularly 100% or higher. The proportion of (pigment green 7) : (pigment yellow 150) is usually 9:1 or higher, preferably 8:2 or higher, more preferably 7:3 or higher, and usually 1:9 or lower, preferably 2:8 or lower, more preferably 3:7 or lower. In this context, the word "high" and "low" are distinguished in such a way that the "high" means the direction in which the amount of pigment yellow 150 gets larger and the "low" means the direction in which it gets smaller.

[Other constituent]

The color image display preferably comprises an absorption part containing an absorbing agent that absorbs light of ultraviolet to near-ultraviolet region emitted from the semiconductor light emitting device. The absorption part may be provided in the panel portion, where images are displayed, or in the backlight.
When the absorption part is disposed in the panel portion, its specific location may be, for example, one or more of: the gap between the light-diffusion sheet and the polarizing plate; the gap between the polarizing plate and the glass substrate; the gap between the glass substrate and the polarizing plate; the surface of the polarizing plate; and the like. When the absorption part is disposed in the backlight, its specific location may be, for example, one or more of: the gap between the light source and the optical waveguide; the gap between the optical waveguide and the dimming sheet; the surface of the dimming sheet; and the like.
Whether the absorption part is provided in the panel portion or in the backlight, it may be formed as a resinous sheet containing an absorbing agent, or it may be provided as a coated film. As another option, it may be provided by mixing an absorbing agent in any members listed above.
By providing an absorption part in the color image display in such a method as described above, it is possible to inhibit the influence of the ultraviolet to near-ultraviolet light on a variety of members constituting the color image display or on observers. From the standpoint of inhibition of the influence on observers, there is no limitation on where to provide the absorption part. On the other hand, from the standpoint of inhibition of the influence on members constituting the color image display, it is preferable to dispose the absorption part as close to the semiconductor light emitting device as possible in the direction of optical path from the semiconductor light emitting device. Especially from the standpoint of inhibition of liquid crystal or color filter deterioration due to light of ultraviolet to near-ultraviolet region, it is preferable to dispose the absorption part at a closer position to the semiconductor light emitting device than the liquid crystal in the direction of optical path from the semiconductor light emitting device.
Detailed explanation will be given here on the absorbing agent contained in the absorption part. There is no special limitation on the absorbing agent used in the present invention insofar as it can absorb light in ultraviolet to near-ultraviolet region. Examples thereof include: benzophenones such as o-hydroxybenzophenone, 2-hydroxy-4-n-octoxybenzophenone, and 2-hydroxy-4-methoxybenzophenone; benzotriazoles such as 2-(2'-hydroxyphenyl)benzotriazole, 2-(2'-hydroxy-5'-t-octylphenyl)benzotriazole, 2-(2'-hydroxy-3'-t-butyl-5'-methylphenyl)-5-chlorobenzotriazole, and 2-(2'-hydroxy-5'-methylphenyl)benzotriazole; cyanoacrylates such as ethyl-2-cyano-3,3'-diphenylacrylate and 5-ethylhexyl-2-cyano-3,3-diphenylacrylate; salicylates such as phenylsalicylate and 4-t-butylphenylsalicylate; and oxalic acid anilides such as 2-ethyl-5'-t-butyl-2'-ethoxy-N,N'-diphenyloxalamide. Further, examples thereof include: inorganic oxides such as zinc oxide, titanium oxide, and zirconium oxide. These inorganic oxides can be included in glass to be used as ultraviolet light-shielding glass.

Absorbing agents are superior in transparency because they can be used as solution in a resin. Inorganic absorbing agents can form an absorption part superior in transparency by using dispersed particles the mean particle diameter of which is 100 nm or smaller. It is preferable that, for photoactive compounds such as titanium oxide, the surface of the particles are treated with inactive compounds such as silica. These absorbing agents can be adjusted for their UV shielding effect by adjusting the amount added to the resin. Of these agents, benzophenones and zinc oxide can be used as the absorbing agent for shielding UV light of 350 nm or shorter. These can be used either alone or as a combination of two or more kinds of them. By using these absorbing agents, it is possible to substantially block light whose wavelength is 350 nm or shorter. In order to prevent deterioration of organic compounds such as binder resin and improve durability of the color image display, it is preferable to block near-ultraviolet light whose wavelength is 400 nm or shorter and this can be achieved by suitable selection of absorbing agents mentioned above.

The absorbing agent is usually used as a mixture with a suitable resin. Examples of the resin used then include: thermoplastic resins, thermosetting resins, and light curing resins. Specific examples are: acrylic resins such as methyl polymethacrylate; styrene resins such as polystyrene and styreneacrylonitrile copolymer; polycarbonate resins; polyester resins; phenoxy resins; butyral resins; polyvinyl alcohol; cellulose resins such as ethyl cellulose, cellulose acetate, and cellulose acetate butyrate; epoxy resins; phenol resins; and silicone resins. Of these, resins such as epoxy resins, butyral resins, and polyvinyl alcohol are desirable from the standpoint of transparency, heat resistance and light fastness.

Example

The present invention will be described in more detail below by referring to examples. However, it should be understood that the present invention is by no means limited by the following examples insofar as they do not depart from the scope of the invention. In the description of Examples, the word "part(s)" means "part(s) by weight".

[Example Group I]

First, explanation will be given on Examples about phosphors of the present invention and light emitting devices using the phosphor.

[Measurement methods of physical property values]

The physical property values of the phosphors obtained in Examples, Comparative Examples, and Reference Examples to be described later were measured and calculated by the following methods in Example Group I.

[Luminescent characteristics]

<Emission spectrum>

Emission spectra were measured at a room temperature (25°C) by using a fluorescence measurement apparatus (manufactured by JASCO corporation) equipped with a 150-W xenon lamp as an excitation light source and a multichannel CCD detector, C7041 (manufactured by Hamamatsu Photonics K.K.), as a spectrum measurement apparatus.
More specifically, lights from the excitation light source were passed through a grating monochromator with a focal length of 10 cm so as to isolate lights having wavelengths between 350 nm and 410 nm, and the isolated excitation lights alone were radiated onto phosphors via optical fibers. The lights emitted from the phosphors by irradiation of the excitation light were separated using a grating monochromator with a focal length of 25 cm, and the emission intensity of each wavelength was measured using the spectrum measurement apparatus at the wavelength range of from 300 nm to 800 nm. Then, through a signal processing such as sensitivity correction by a personal computer, the emission spectra were obtained. The measurement was performed with the slit width of the receiving spectroscope being specified at 1 nm.

<Emission-peak intensity>

Each emission-peak intensities was calculated as a relative amount with the emission-peak intensity of a blue phosphor (Ba,Eu)$MgAl_{10}O_{17}$ manufactured by Kasei Optonics, Ltd. (Product Number: LP-B4) taken as 100%, in the visible region of the emission spectrum obtained as above except the excitation wavelength region.

<Full width at half maximum of emission peak>

Full width at half maximum of each emission peak (hereinafter simply referred to as "the full width at half maximum" occasionally) was calculated from the emission spectra obtained as above.

<Brightness>

Each relative brightness (hereinafter simply referred to as "brightness" as appropriate) was calculated from the stimulus value Y in the XYZ colorimetric system calculated in accordance with JIS Z8724 as a relative amount with the stimulus value Y of a blue phosphor (Ba,Eu)$MgAl_{10}O_{17}$ manufactured by Kasei Optonics, Ltd. (Product Number: LP-B4) taken as 100%, in the visible region of the emission spectrum obtained as above except the excitation wavelength region.

<Emission intensity ratio>

Each emission intensity ratio was calculated as values represented by $I_{emi}(450)/I_{emi}(430)$ and $I_{emi}(450)/I_{emi}(470)$, where $I_{emi}(470)$ is the emission intensity of the 470-nm wavelength component, $I_{emi}(450)$ is the emission intensity of the 450-nm wavelength component, and $I_{emi}(430)$ is the emission intensity of the 430-nm wavelength component in each emission spectrum obtained as above.

<Color coordinates>

Color coordinates of x, y colorimetric system (CIE 1931 colorimetric system) were calculated as color coordinates CIEx and CIEy of the XYZ colorimetric system which is defined in JIS Z8701 by a method based on JIS Z8724 from the emission spectra data in the wavelength region between 420 nm and 800 nm (under excitation by the 400-nm wavelength light).

<Excitation spectrum>

Each excitation spectrum was measured at a room temperature (25°C) with a fluorescence spectrophotometer F-4500 manufactured by Hitachi, Ltd. More specifically, excitation spectra in a wavelength range of from 380 nm to 530 nm were measured using a blue emission peak of 447-nm as a monitor.

The excitation spectrum characteristic was calculated as the value represented by $I_{ex}(400)/I_{ex}(350)$ from the excitation spectra obtained as above, where $I_{ex}(400)$ is the excitation peak intensity of 400-nm wavelength and $I_{ex}(350)$ is the excitation peak intensity of 350-nm wavelength.

[Particle diameter]

<Weight median diameter $D_{50}$>

Before measuring weight median diameters $D_{50}$, samples were dispersed by ultrasonic wave using a ultrasonic dispersion apparatus (manufactured by KAIJO corporation) for 120 secs at a frequency of 19 KHz and ultrasonic power of 25 W. To the dispersion liquid, a trace quantity of surfactant was added in order to prevent the re-flocculation.
The weight median diameters $D_{50}$ were calculated, from the weight-standard particle size distribution curve preliminarily obtained, as a value of a particle diameter when the integrated value is 50% using a laser diffraction/scattering particle size distribution analyzer (LA-300, manufactured by HORIBA, Ltd.).

<QD (quantile deviation)>

Each QD was calculated as the value represented by $(D_{75}-D_{25})/(D_{75}+D_{25})$, where $D_{25}$ is a value of particle diameter when the integrated value is 25%, and $D_{75}$ is a value of particle diameter when the integrated value is 75%, which could be measured from the weight-standard particle size distribution curve that was determined by the laser diffraction/scattering particle size distribution analyzer.

[Shapes of phosphor particles]

<Average circularity>

Before measuring average circularities, samples were dispersed in the same way as the case of the weight median diameter $D_{50}$ described earlier.
The average circularities were measured using a flow particle image analyzer ("FPIA-2000", manufactured by SYSMEX CORPORATION).

<Scanning electron microscope (SEM) photograph>

In order to observe shapes or the like of the phosphors, SEM photos were taken on each Example and Comparative Example using an SEM (S-4500, manufactured by Hitachi, Ltd.) under magnifications of 3000x, 5000x, or 6000x.

[Quantum efficiencies]

(Method for measuring absorption efficiency $\alpha_q$, internal quantum efficiency $\eta_i$, and external quantum efficiency $\eta_o$)

For determining quantum efficiencies (absorption efficiency $\alpha_q$, internal quantum efficiency $\eta_i$, and external quantum efficiency $\eta_o$), a phosphor sample to be measured (for example, a phosphor powder or the like) was stuffed up in a cell with its surface smoothed sufficiently to keep high measurement accuracy, followed by setting it on a condenser such as an integrating sphere.
A Xe lamp was attached to the condenser as the light emission source for exciting the phosphor sample. The light emission source was adjusted with a filter, monochromator (grating monochromator) or the like so that the emission-peak wavelength thereof was that of a monochromatic light of 400-nm wavelength.
Then the spectrum including those of the emitted light (fluorescence) and reflected light was measured, using a spectrometer (MCPD7000, manufactured by Otsuka Electronics Co., Ltd.) by irradiating the phosphor sample to be measured with the above-mentioned light from the light emission source, of which emission-peak wavelength was adjusted.

<Absorption efficiency $\alpha_q$>

Absorption efficiency $\alpha_q$ was calculated as $N_{abs}/N$, where $N_{abs}$ is the number of photons in the excitation light that was absorbed in the phosphor sample and N is the number of all the photons in the excitation light.
A concrete calculation procedure is as follows.
First, the latter one, namely the total number N of all the photons in the excitation light was determined as follows. That is, the reflection spectrum (hereinafter designated as "$I_{ref}(\lambda)$") was measured using the spectrometer with respect to a measurement object having reflectance R of approx. 100% to the excitation light, such as a white reflection plate "Spectralon" manufactured by Labsphere (with 98% of reflectance R to an excitation light of 400-nm wavelength), which was attached to the above-mentioned condenser in the same disposition as the phosphor sample.
From this reflection spectrum $I_{ref}(\lambda)$, a numeric value represented by the (formula I) below was determined. In the (formula I) below, the integration interval was set at from 385 nm to 415 nm. The numeric value represented by the (formula I) below is proportional to N, the total number of photons in the excitation light.

[Mathematical Formula 18]

$$\frac{1}{R}\int \lambda \cdot I_{ref}(\lambda) d\lambda \quad \text{(formula I)}$$

In addition, the numerical value represented by the (formula II) below was determined from the reflection spectrum I(λ) of the phosphor sample, of which absorption efficiency $\alpha_q$ was to be measured, attached to the condenser. The integration interval of the above (formula II) was set to be the same as that of the above (formula I). The numerical value calculated from the following (formula II) is proportional to the number $N_{abs}$ of the photons in the excitation light that was absorbed in the phosphor sample.

[Mathematical Formula 19]

$$\frac{1}{R}\int \lambda \cdot I_{ref}(\lambda)d\lambda - \int \lambda \cdot I(\lambda)d\lambda \qquad \text{(formula II)}$$

In this way, the absorption efficiency $\alpha_q$ was calculated based on the following equation.

[Mathematical Formula 20]

Absorption efficiency $\alpha_q = N_{abs}/N$ = (formula II)/(formula I)

<Internal quantum efficiency $\eta_i$>

Internal quantum efficiency $\eta_i$ was calculated as $N_{PL}/N_{abs}$, where $N_{PL}$ is the number of photons originating from the fluorescence phenomenon and $N_{abs}$ is the number of photons absorbed in the phosphor sample.

The numerical value represented by the (formula III) below from the above-mentioned I(λ). The lower limit of the integration interval of the (formula III) was set at from 416 nm to 780 nm. The numerical value calculated from the following (formula III) is proportional to the number $N_{PL}$ of the photons originating from the fluorescence phenomenon.

[Mathematical Formula 21]

$$\int \lambda \cdot I(\lambda)d\lambda \qquad \text{(formula III)}$$

In this way, the internal quantum efficiency $\eta_i$ was calculated based on the following equation.

[Mathematical Formula 22]

$\eta_i$ = (formula III)/ (formula II)

<External quantum efficiency $\eta_o$>

The external quantum efficiency $\eta_o$ was decided as a product of the absorption efficiency $\alpha_q$ and internal

quantum efficiency $\eta_i$, which were obtained by the above procedures.

[Temperature characteristics]

The temperature characteristics was examined using a multi-channel spectrum analyzer, MCPD7000, manufactured by Otsuka Electronics Co., Ltd. as an emission spectrum measurement device, a stage equipped with a cooling mechanism using a peltiert device and a heating mechanism using a heater, and a light source device equipped with a 150-W xenon lamp.

A cell holding a phosphor sample was put on the stage, and the temperature was changed within the range from 20°C to 180°C. After verifying the surface temperature of the phosphor was kept constant at 25°C, 125°C, or 160°C, respectively, the emission spectrum was measured under excitation by a light from the light source having wavelength of 400 nm, which was isolated with a diffraction grating. Then the emission-peak intensities were decided from the measured emission spectra. As each measurement value of the temperature, a value corrected by utilizing the temperature values measured with a radiation thermometer and a thermocouple was used.

<Emission intensity retention rate>

Ratios of the emission-peak intensities at various temperatures relative to the emission-peak intensity at 25°C was defined as the emission intensity retention rate. Specifically, the emission intensity retention rates were determined as follows.

Namely, the emission intensity retention rate at 125°C under excitation by 400 nm was calculated as I(125)/I(25), where I(25) represents the emission-peak intensity under excitation by light of 400-nm peak wavelength at 25°C, and I(125) represents the emission-peak intensity under excitation by light of 400-nm peak wavelength at 125°C.
In addition, the emission intensity retention rate at 160°C under excitation by 400 nm was calculated as I(160)/I(25), where I(160) represents the emission-peak intensity under excitation by light of 400-nm peak wavelength at 160°C.

[Powder X-ray structural analysis]

Precise measurements were performed with a powder X-ray diffractometry apparatus X'Pert (manufactured by PANalytical). The measurement conditions were as follows.

- · Use of a Cuk$\alpha$ tube
- · X-ray output: 45 KV, 40 mA
- · Divergence slit: 1/4 °
- · X-ray mirror
- · Detector: a semiconductor array detector, X'Celerator (using an Ni filter)
- · Scan range: 2$\theta$ = 10 ° to 90 °
- · Reading width: 0.03 °
- · Counting time: 33 secs

[Reference Example I-1]

<Mixing process>

$SrCO_3$ (manufactured by KANTO CHEMICAL CO., INC.), $SrHPO_4$ (manufactured by KANTO CHEMICAL CO., INC.), $Eu_2O_3$ (manufactured by Shin-Etsu Chemical Co., Ltd., purity 99.99%), and $SrCl_2$ (manufactured by KANTO CHEMICAL CO., INC.) were weighed out in molar amounts described in [Table I-A] and mixed in a small size V type blender (dry-type mixing).

[Table9]

| [Table I-A] | | | | | | | | | | |
|---|---|---|---|---|---|---|---|---|---|---|
| | Amount of materials [mol] | | | | | Composition ratio of each material [molar ratio] | | | | |
| | $SrCO_3$ | $SrHPO_4$ | $Eu_2O_3$ | $SrCl_2$ | $(NH_4)_2HPO_4$ | Eu | M | Sr | P | Cl |
| Reference Example I-1 | 0.28 | 0.605 | 0.010 | 0.1 | 0 | 0.2 | 0 | 9.8 | 6 | 2 |
| Reference Example I-2 | 0.25 | 0.605 | 0.025 | 0.1 | 0 | 0.5 | 0 | 9.5 | 6 | 2 |
| Example I-1 | 0.22 | 0.605 | 0.040 | 0.1 | 0 | 0.8 | 0 | 9.2 | 6 | 2 |
| Example I-2 | 0.20 | 0.605 | 0.050 | 0.1 | 0 | 1.0 | 0 | 9.0 | 6 | 2 |
| Reference Example I-3 | 0.28 | 0.605 | 0.010 | 0.1 | 0 | 0.2 | 0 | 9.8 | 6 | 2 |
| Reference Example I-4 | 0.27 | 0.605 | 0.015 | 0.1 | 0 | 0.3 | 0 | 9.7 | 6 | 2 |
| Example I-3 | 0.26 | 0.605 | 0.020 | 0.1 | 0 | 0.4 | 0 | 9.6 | 6 | 2 |
| Example I-4 | 0.25 | 0.605 | 0.025 | 0.1 | 0 | 0.5 | 0 | 9.5 | 6 | 2 |
| Example I-5 | 1.35 | 3.025 | 0.075 | 0.5 | 0 | 0.3 | 0 | 9.7 | 6 | 2 |
| Example I-6 | 0.25 | 0.605 | 0.025 | 0.1 | 0 | 0.5 | 0 | 9.5 | 6 | 2 |
| Example I-7 | 0.20 | 0.605 | 0.050 | 0.1 | 0 | 1.0 | 0 | 9.0 | 6 | 2 |
| Example I-8 | 0.15 | 0.605 | 0.075 | 0.1 | 0 | 1.5 | 0 | 8.5 | 6 | 2 |

<Firing process>

(Primary firing)

The material mixture obtained was filled in an alumina crucible and placed in a box-type electric furnace (manufactured by Motoyama, RH-2035D).

The temperature was raised at a temperature rising rate of 5 °C/min until it reached 1050°C (maximum heating temperature) under atmospheric pressure in the air. The temperature was maintained at that temperature for 5 hrs to obtain a fired product. The fired product emitted red light when excited with light of 254-nm wavelength. This red luminescence was probably due to luminescence of $Eu^{3+}$.

The mixture was then cooled to room temperature, taken out of the crucible, and pulverized.

(Secondary firing)

After the fired product obtained was added with 0.05 mole of $SrCl_2$ and mixed in a small size V type blender, the mixture was then filled in an alumina crucible. Then, the crucible was placed in the same electric furnace as that of the primary firing.

While hydrogen-containing nitrogen gas (hydrogen : nitrogen = 4 : 96 (by volume)) was passed at a rate of 2.5 ± 0.5 L/min, the temperature was raised at a rate of 5 °C/min until it reached 920°C (maximum heating temperature) under atmospheric pressure in a reducing atmosphere. The temperature was maintained at that temperature for 3 hrs. The mixture was then cooled to room temperature, taken out of the crucible, and pulverized.

(Tertiary firing)

After the fired product obtained was added with 0.05 mole of $SrCl_2$ and mixed in a small size V type blender, the mixture was then filled in an alumina crucible. Then, the crucible was placed again in the same electric furnace as that of the secondary firing.

While hydrogen-containing nitrogen gas (hydrogen : nitrogen = 4 : 96 (by volume)) was passed at a rate of 2.5 ± 0.5 L/min, the temperature was raised at a rate of 5 °C/min until it reached 950°C (maximum heating temperature) under atmospheric pressure in a reducing atmosphere. The temperature was maintained at that temperature for 3 hrs.

<Post-treatment etc.>

After the obtained fired lump was subjected to a coarse milling to have a particle diameter of about 5 mm, a mixture was prepared so that the phosphor : 3-mm alumina ball : water = 1 : 3 : 1 (by weight). The mixture was treated in a ball mill at 60 rpm for 6 hrs to give a phosphor slurry.

In order to wash the phosphor, the phosphor slurry was mixed and stirred with a large amount of water. After the mixture was allowed to settle to precipitate the phosphor particles, the supernatant was decanted off. This procedure was repeated until the electric conductivity of the supernatant fell below 3 mS/m. After verifying that the electric conductivity of the supernatant fell below 3 mS/m, a classification was performed to remove the coarse particles and minute particles of the phosphor.

The obtained phosphor slurry was dispersed in an $Na_3PO_4$ aqueous solution (pH=10) and, after removing the small particles by classification, treated with calcium phosphate. After dehydration, the phosphor was obtained by drying at 150°C for 10 hrs.

<Measurement of characteristics and the like>

Luminescent characteristics, quantum efficiencies, temperature characteristics, particle diameter, and particle shape were measured on the phosphor obtained, by the methods described above. The results are shown in [Table I-F] to [Table I-H].

Further, on [Reference Example I-1], the X-ray diffraction patterns of $(Sr_{9.8}Eu_{0.2})(PO_4)_6Cl_2$ after the primary, secondary and tertiary firing were measured. The results are shown in [Fig. 5] to [Fig. 7].

[Reference Example I-2], [Example I-1], and [Example I-2]

A phosphor was obtained in the same way as described for [Reference Example I-1], except that the mixing ratio of materials in the mixing process was as described in [Table I-A] above.

Luminescent characteristics, quantum efficiencies, temperature characteristics, particle diameter, and particle shape were measured on the phosphor obtained, by the methods described above. The results are shown in [Table I-F] to [Table I-H].

[Reference Example I-3], [Reference Example I-4], [Example I-3], and [Example I-4]

A phosphor was obtained in the same way as described for [Reference Example I-1], except that the mixing ratio of materials in the mixing process was as described in [Table I-A] above, the maximum heating temperature in the primary firing was 1100°C, the maximum heating temperature in the secondary firing was 1020°C and it was maintained for 5 hrs, and the maximum heating temperature in the tertiary firing was 1080°C and it was maintained for 5 hrs.

[Example I-5]

A phosphor was obtained in the same way as described for [Reference Example I-4], except that the mixing ratio of materials in the mixing process was as described in [Table I-A] above, namely, the amount of each material and flux used was 5 times the amount described in [Reference Example I-4].

Luminescent characteristics, quantum efficiencies, temperature characteristics, particle diameter, and particle shape were measured on the phosphor obtained, by the methods described above. The results are shown in [Table I-F] to [Table I-H].

[Example I-6] to [Example I-8]

A phosphor was obtained in the same way as described for [Reference Example I-1], except that the mixing ratio of materials in the mixing process was as described in [Table I-A] above, the maximum heating temperature in the primary firing was 1020°C, the maximum heating temperature in the secondary firing was 950°C and it was maintained for 3 hrs, and the maximum heating temperature in the tertiary firing was 950°C and it was maintained for 3 hrs.

Luminescent characteristics, quantum efficiencies, temperature characteristics, particle diameter, and particle shape were measured on the phosphor obtained, by the methods described above. The results are shown in [Table I-F] to [Table I-H].

(Conditions in firing process)

Conditions in the firing process such as temperature conditions in the above [Reference Example I-1] to [Reference Example I-4] and [Example I-1] to [Example I-8] are summarized in [Table I-B] for confirmation.

[Table 10]

| [Table I-B] | | | | | | | | |
|---|---|---|---|---|---|---|---|---|
| | Primary firing | | Secondary firing | | | Tertiary firing | | |
| | Firing temperature [°C] | Firing time [hr] | Amount of $SeCl_2$ added [mol] | Firing temperature [°C] | Firing time [hr] | Amount of $SeCl_2$ added [mol] | Firing temperature [°C] | Firing time [hr] |
| Reference Example I-1 | 1050 | 5 | 0.05 | 920 | 3 | 0.05 | 950 | 3 |
| Reference Example I-2 | 1050 | 5 | 0.05 | 920 | 3 | 0.05 | 950 | 3 |
| Example I-1 | 1050 | 5 | 0.05 | 920 | 3 | 0.05 | 950 | 3 |
| Example I-2 | 1050 | 5 | 0.05 | 920 | 3 | 0.05 | 950 | 3 |
| Reference Example I-3 | 1100 | 5 | 0.05 | 1020 | 5 | 0.05 | 1080 | 5 |
| Reference Example I-4 | 1100 | 5 | 0.05 | 1020 | 5 | 0.05 | 1080 | 5 |
| Example I-3 | 1100 | 5 | 0.05 | 1020 | 5 | 0.05 | 1080 | 5 |
| Example I-4 | 1100 | 5 | 0.05 | 1020 | 5 | 0.05 | 1080 | 5 |
| Example I-5 | 1100 | 5 | 0.25 | 1020 | 5 | 0.25 | 1080 | 5 |
| Example I-6 | 1020 | 5 | 0.05 | 950 | 3 | 0.05 | 950 | 3 |
| Example I-7 | 1020 | 5 | 0.05 | 950 | 3 | 0.05 | 950 | 3 |

(continued)

| [Table I-B] | | | | | | | | |
|---|---|---|---|---|---|---|---|---|
| | Primary firing | | Secondary firing | | | Tertiary firing | | |
| | Firing temperature [°C] | Firing time [hr] | Amount of $SeCl_2$ added [mol] | Firing temperature [°C] | Firing time [hr] | Amount of $SeCl_2$ added [mol] | Firing temperature [°C] | Firing time [hr] |
| Example I-8 | 1020 | 5 | 0.05 | 950 | 3 | 0.05 | 950 | 3 |

[Comparative Example I-1] to [Comparative Example I-5]

On a commercially available alkaline-earth metal apatite phosphor, $(Sr,Ca,Ba,Mg,Eu)_{10}(PO_4)_6Cl_2$, of Kasei Optonics, Ltd. (for its production number etc., refer to [Table I-C]), luminescent characteristics, quantum efficiencies, temperature characteristics, particle diameter, and particle shape were measured in the above method. The results are shown in [Table I-F] to [Table I-H].

[Table 11]

| [Table I-C] | |
|---|---|
| | Production number |
| Comparative Example I-1 | LP-B1-BN |
| Comparative Example I-2 | LP-B1-B10 |
| Comparative Example I-3 | LP-B1-B |
| Comparative Example I-4 | LP-B1-B6 |
| Comparative Example I-5 | LP-B1-B7 |

In the following Comparative Examples I-6 to I-10, the phosphors obtained in Examples 1, 3, 4, 7 and 8 of Japanese Patent Laid-Open Publication (Kokai) No. 2004-253747 were reexamined for characteristics such as luminescent characteristics. Namely, the phosphors of Comparative Examples I-6 to I-10 were produced in the following manner.

[Comparative Example I-6]

[Mixing process]

Molar amounts of $SrCO_3$, $SrHPO_4$, $Eu_2O_3$, $SrCl_2$ described in [Table I-D] were weighed and pulverized, mixed, dried in the alumina container and beaded wet-type ball mill, and passed through the nylon mesh together with pure water.

[Table 12]

| [Table I-D] | | | | | | | | | | |
|---|---|---|---|---|---|---|---|---|---|---|
| | Amount of materials [mol] | | | | | Composition ratio of each material [molar ratio] | | | | |
| | $SrCO_3$ | $SrHPO_4$ | $Eu_2O_3$ | $SrCl_2$ | $(NH_4)_2HPO_4$ | Eu | M | Sr | P | Cl |
| Comparative Example I-6 | 0.0352 | 0.1055 | 0.0088 | 0.0176 | 0.0000 | 1 | 0 | 9 | 6 | 2 |
| Comparative Example I-7 | 0.0000 | 0.1055 | 0.0264 | 0.0176 | 0.0000 | 3 | 0 | 7 | 6 | 2 |

(continued)

| [Table I-D] | | | | | | | | | | |
|---|---|---|---|---|---|---|---|---|---|---|
| | Amount of materials [mol] | | | | | Composition ratio of each material [molar ratio] | | | | |
| | $SrCO_3$ | $SrHPO_4$ | $Eu_2O_3$ | $SrCl_2$ | $(NH_4)_2HPO_4$ | Eu | M | Sr | P | Cl |
| Comparative Example I-8 | 0.0000 | 0.0879 | 0.0352 | 0.0176 | 0.0176 | 4 | 0 | 6 | 6 | 2 |
| Comparative Example I-9 | 0.0000 | 0.0527 | 0.0527 | 0.0176 | 0.0527 | 6 | 0 | 4 | 6 | 2 |
| Comparative Example I-10 | 0.0000 | 0.0000 | 0.0791 | 0.0176 | 0.1055 | 9 | 0 | 1 | 6 | 2 |

<Firing process>

The material mixture obtained was filled in an alumina crucible and fired by heating at 1200°C for 2 hrs under a stream of nitrogen gas containing 4% hydrogen.

<Post-treatment etc.>

The lump obtained after firing was washed with water, dried, and classified to produce phosphor $Sr_{4.5}Eu_{0.5}(PO_4)_3Cl$.

<Measurement of characteristics and the like>

Luminescent characteristics, quantum efficiencies, temperature characteristics, particle diameter, and particle shape were measured on the phosphor obtained, by the methods described above. The results are shown in [Table I-F] to [Table I-H].
The values of quantum efficiencies in Comparative Examples I-7 to I-10 were those remeasured, by varying the integration range, for the phosphors produced in Examples 3, 4, 7 and 8 described in Japanese Patent Laid-Open Publication (Kokai) No. 2004-253747. The value of quantum efficiencies of Comparative Example I-6 were calculated by extrapolating values of Eu concentration and quantum efficiencies on the basis of values of quantum efficiencies of Comparative Examples I-7 to I-10.

[Comparative Example I-7]

$Sr_{3.5}Eu_{1.5}(PO_4)_3Cl$ was obtained in the same way as that described for [Comparative Example I-6], except that materials were used in the mixing process in the ratio described in [Table I-D].
Luminescent characteristics, quantum efficiencies, temperature characteristics, particle diameter, and particle shape were measured on the phosphor obtained, by the methods described above. The results are shown in [Table I-F] to [Table I-H].

[Comparative Example I-8]

$Sr_3Eu_2(PO_4)_3Cl$ was obtained in the same way as that described for [Comparative Example I-6], except that materials were used in the mixing process in the ratio described in [Table I-D].
Luminescent characteristics, quantum efficiencies, temperature characteristics, particle diameter, and particle shape were measured on the phosphor obtained, by the methods described above. The results are shown in [Table I-F] to [Table I-H].

[Comparative Example I-9]

$Sr_2Eu_3(PO_4)_3Cl$ was obtained in the same way as that described for [Comparative Example I-6], except that materials were used in the mixing process in the ratio described in [Table I-D].
Luminescent characteristics, quantum efficiencies, temperature characteristics, particle diameter, and particle shape were measured on the phosphor obtained, by the methods described above. The results are shown in [Table I-F] to [Table I-H].

[Comparative Example I-10]

$Sr_{0.5}Eu_{4.5}(PO_4)_3Cl$ was obtained in the same way as that described for [Comparative Example I-6], except that materials were used in the mixing process in the ratio described in [Table I-D].
Luminescent characteristics, quantum efficiencies, temperature characteristics, particle diameter, and particle shape were measured on the phosphor obtained, by the methods described above. The results are shown in [Table I-F] to [Table I-H].

(Conditions in firing process)

Conditions in the firing process such as temperature conditions in the above [Comparative Example I-6] to [Comparative Example I-10] are summarized in [Table I-E] for confirmation.

[Table 13]

| [Table I-E] | | |
|---|---|---|
| | Primary firing | |
| | Firing temperature [°C] | Firing time [hr] |
| Comparative Example I-6 | 1200 | 2 |
| Comparative Example I-7 | 1200 | 2 |
| Comparative Example I-8 | 1200 | 2 |
| Comparative Example I-9 | 1200 | 2 |
| Comparative Example I-10 | 1200 | 2 |

[Result and Discussion]

Physical property values measured in [Reference Example I-1] to [Reference Example I-4], [Example I-1] to [Example I-8], and [Comparative Example I-1] to [Comparative Example I-10] are shown in the following [Table I-F] to [Table I-H].

[Table 14]

| [Table I-F] | | | | | | | | | |
|---|---|---|---|---|---|---|---|---|---|
| | Luminescent characteristics (excitation wavelength: 400 nm) | | | | | | | | |
| | Emission peak wavelength [nm] | Emission peak intensity | Brightness | Emission spectrum characteristics | | | Color coordinates | | Excitati on spectrum characte -ristics |
| | | | | $I_{emi}(450)/I_{emi}(430)$ | $I_{emi}(450)/I_{emi}(470)$ | Full width at half maximum [nm] | x value | y value | $I_{ex}(400)/I_{ex}(350)$ |
| Reference Example I-1 | 447 | 251 | 81 | 2.3 | 3.0 | - | 0.154 | 0.031 | 0.76 |
| Reference Example I-2 | 447 | 329 | 103 | 2.7 | 2.9 | - | 0.153 | 0.031 | 0.85 |
| Example I-1 | 449 | 369 | 134 | 3.4 | 2.8 | - | 0.152 | 0.036 | 0.91 |
| Example I-2 | 449 | 378 | 128 | 4.1 | 2.7 | 30 | 0.152 | 0.034 | 0.96 |
| Reference Example I-3 | 447 | 274 | 86 | 2.4 | 2.9 | 32 | 0.154 | 0.030 | 0.78 |
| Reference Example I-4 | 447 | 312 | 97 | 2.7 | 2.9 | 32 | 0.153 | 0.030 | 0.81 |
| Example I-3 | 447 | 364 | 113 | 3.1 | 2.8 | 32 | 0.153 | 0.031 | 0.90 |
| Example I-4 | 448 | 362 | 113 | 3.3 | 2.8 | 31 | 0.152 | 0.031 | 0.91 |
| Example I-5 | 447 | 355 | 110 | 2.9 | 2.8 | 32 | 0.153 | 0.030 | 0.87 |
| Example I-6 | 447 | 386 | 123 | 3.0 | 2.9 | 31 | 0.153 | 0.032 | 0.91 |
| Example I-7 | 449 | 393 | 131 | 3.6 | 2.7 | 29 | 0.152 | 0.034 | 0.95 |
| Example I-8 | 450 | 380 | 137 | 4.5 | 2.6 | 29 | 0.152 | 0.037 | 0.98 |
| Comparative Example I-1 | 447 | 177 | 113 | 2.3 | 2.8 | 29 | 0.153 | 0.054 | 0.75 |
| Comparative Example I-2 | 447 | 191 | 117 | 2.0 | 2.3 | 30 | 0.153 | 0.053 | 0.75 |
| Comparative Example I-3 | 448 | 126 | 161 | 2.0 | 1.8 | 33 | 0.153 | 0.093 | 0.73 |

(continued)

| [Table I-F] | | | | | | | | | |
|---|---|---|---|---|---|---|---|---|---|
| | Luminescent characteristics (excitation wavelength: 400 nm) | | | | | | | | |
| | Emission peak wavelength [nm] | Emission peak intensity | Brightness | Emission spectrum characteristics | | | Color coordinates | | Excitati on spectrum characte -ristics |
| | | | | $I_{emi}(450)/I_{emi}(430)$ | $I_{emi}(450)/I_{emi}(470)$ | Full width at half maximum [nm] | x value | y value | $I_{ex}(400)/I_{ex}(350)$ |
| Comparative Example I-4 | 450 | 107 | 226 | 1.8 | 1.5 | 36 | 0.156 | 0.134 | 0.71 |
| Comparative Example I-5 | 450 | 67 | 269 | - | - | 44 | 0.162 | 0.196 | 0.68 |
| Comparative Example I-6 | 446 | 285 | 101 | 3.2 | 3.5 | 29 | 0.154 | 0.030 | 0.83 |
| Comparative Example I-7 | 452 | 240 | 95 | 7.1 | 2.2 | - | 0.150 | 0.041 | 0.99 |
| Comparative Example I-8 | 453 | 192 | 87 | 7.4 | - | - | 0.151 | 0.046 | 1.00 |
| Comparative Example I-9 | 455 | 142 | 73 | 9.1 | 1.7 | - | 0.151 | 0.053 | 1.00 |
| Comparative Example I-10 | 456 | 104 | 52 | 10.5 | 1.5 | - | 0.147 | 0.053 | 1.09 |

[Table 15]

| [Table I-G] | | | | | |
|---|---|---|---|---|---|
| | Particle diameter | | Shape of phosphor particles | | |
| | Weight median diameter $D_{50}$ [$\mu$m] | QD | Average degree of circularlity (in the range of 5 $\mu$m to 30 $\mu$m) | Ratio of particles with a degree of circularity of smaller than 0.85 | SEM photo |
| Reference Example I-1 | 6.0 | 0.24 | 0.941 | 7.26% | distinct crystal habit could be observed |
| Reference Example I-2 | 7.4 | 0.24 | 0.940 | 6.59% | distinct crystal habit could be observed |
| Example I-1 | 10.8 | 0.24 | 0.940 | 5.55% | distinct crystal habit could be observed |
| Example I-2 | 13.7 | 0.24 | 0.940 | 6.17% | distinct crystal habit could be observed |
| Reference Example I-3 | 5.9 | 0.24 | 0.951 | 1.80% | distinct crystal habit could be observed |
| Reference Example I-4 | 6.0 | 0.23 | 0.950 | 1.68% | distinct crystal habit could be observed |
| Example I-3 | 10.2 | 0.26 | 0.951 | 5.58% | distinct crystal habit could be observed |
| Example I-4 | 11.2 | 0.25 | 0.948 | - | distinct crystal habit could be observed |
| Example I-5 | 10.7 | 0.26 | 0.956 | 4.84% | distinct crystal habit could be observed |
| Example I-6 | 8.4 | 0.23 | 0.957 | 2.11% | - |
| Example I-7 | 7.7 | 0.24 | - | - | - |
| Example I-8 | 9.2 | 0.24 | - | - | - |
| Comparative Example I-1 | - | - | - | - | abounding in fracture planes |
| Comparative Example I-2 | 5.8 | 0.36 | 0.933 | - | abounding in fracture planes |
| Comparative Example I-3 | - | - | - | - | abounding in fracture planes |
| Comparative Example I-4 | 6.0 | 0.27 | 0.930 | 6.28% | abounding in fracture planes |
| Comparative Example I-5 | 7.2 | 0.31 | - | - | abounding in fracture planes |
| Comparative Example I-6 | - | - | - | - | - |
| Comparative Example I-7 | - | - | 0.932 | 7.82% | - |
| Comparative Example I-8 | - | - | - | - | - |

(continued)

| [Table I-G] | | | | | |
|---|---|---|---|---|---|
| | Particle diameter | | Shape of phosphor particles | | |
| | Weight median diameter $D_{50}$ [μm] | QD | Average degree of circularlity (in the range of 5 μm to 30 μm) | Ratio of particles with a degree of circularity of smaller than 0.85 | SEM photo |
| Comparative Example I-9 | - | - | - | - | - |
| Comparative Example I-10 | - | - | - | - | - |

[Table 16]

| [Table I-H] | | | | | |
|---|---|---|---|---|---|
| | Quantum efficiency (excitation wavelength: 400 nm) | | | Temperature characteristics | |
| | Absorption efficiency (%) | Internal quantum efficiency (%) | External quantum efficiency (%) | Emission intensity retention rate | |
| | | | | I(125)/I(25) | I(160)/I(25) |
| Reference Example I-1 | 67.3 | 91.6 | 61.7 | - | - |
| Reference Example I-2 | 82.7 | 91.0 | 75.2 | - | - |
| Example I-1 | 93.2 | 87.1 | 81.2 | - | - |
| Example I-2 | 95.8 | 85.6 | 82.0 | 0.67 | 0.55 |
| Reference Example I-3 | 71.1 | 92.0 | 65.5 | 0.78 | 0.66 |
| Reference Example I-4 | 77.5 | 92.3 | 71.6 | 0.75 | 0.65 |
| Example I-3 | 89.1 | 91.2 | 81.3 | 0.72 | 0.60 |
| Example I-4 | 92.2 | 89.3 | 82.4 | 0.71 | 0.59 |
| Example I-5 | 84.7 | 94.3 | 79.9 | 0.77 | 0.65 |
| Example I-6 | 89.3 | 91.9 | 82.0 | - | - |
| Example I-7 | 93.2 | 86.9 | 80.9 | - | - |
| Example I-8 | 96.8 | 79.8 | 77.3 | - | - |
| Comparative Example I-1 | 56.9 | 98.7 | 56.2 | 0.75 | 0.67 |
| Comparative Example I-2 | 58.8 | 98.1 | 57.7 | 0.74 | 0.62 |
| Comparative Example I-3 | 53.9 | 100.5 | 54.2 | 0.75 | 0.66 |
| Comparative Example I-4 | 52.7 | 97.2 | 51.2 | 0.78 | 0.69 |
| Comparative Example I-5 | 52.5 | 79.8 | 47.9 | - | - |

(continued)

| [Table I-H] | | | | | |
|---|---|---|---|---|---|
| | Quantum efficiency (excitation wavelength: 400 nm) | | | Temperature characteristics | |
| | Absorption efficiency (%) | Internal quantum efficiency (%) | External quantum efficiency (%) | Emission intensity retention rate | |
| | | | | I(125)/I(25) | I(160)/I(25) |
| Comparative Example I-6 | 90.9 | 82.5 | 75.0 | 0.54 | 0.40 |
| Comparative Example I-7 | 96.2 | 58.5 | 56.3 | 0.45 | 0.33 |
| Comparative Example I-8 | 96.2 | 46.9 | 45.1 | 0.41 | 0.28 |
| Comparative Example I-9 | 96.0 | 35.4 | 33.9 | 0.33 | 0.21 |
| Comparative Example I-10 | 96.8 | 25.1 | 24.3 | 0.28 | 0.17 |

(X-ray analysis)

In the production process of Reference Example I-1, the X-ray diffraction patterns of $(Sr_{9.8}Eu_{0.2})$ $(PO_4)_6Cl_2$ after the primary, secondary and tertiary firing were measured. The results are shown in [Fig. 5].
From the X-ray diffraction patterns obtained, the main diffraction pattern after either primary firing, secondary firing or tertiary firing can be attributed to the X-ray diffraction pattern derived from an apatite structure $Sr_5(PO_4)_3Cl$ (83-0973). The number after the composition formula (for example, "83-0973") corresponds to the number assigned by Joint Committee on Powder Diffraction Standards (JCPDS card).
[Fig. 6] is a graph showing an enlarged view at around 27.8° of the X-ray diffraction pattern of [Fig. 5]. The peak at 27.8° seen in the X-ray diffraction pattern of Fig. 6 coincides with the diffraction pattern of $Sr_3Eu(PO_4)_3$ (46-0133). [Fig. 7] is a graph showing an enlarged view at around 33° of the X-ray diffraction pattern of [Fig. 5]. The peak at 33° seen in the X-ray diffraction pattern of Fig. 7 coincides with the diffraction pattern of $Sr_3Eu(PO_4)_3$ (46-0133).
These data show that, in the phosphor after the primary firing, a substance having a structure different from that of apatite (impurity phase) is present. This peak is no longer present in the X-ray diffraction patterns after the secondary and tertiary firings. It is evident that the amount of impurity phases decreased during the multistep firing processes, leading to increased purity of the phosphor. Further, since the intensity of the X-ray diffraction increased after the tertiary firing, crystallinity of $(Sr_{9.8}Eu_{0.2})$ $(PO_4)_6Cl_2$ was probably enhanced.
In addition, the X-ray diffraction pattern of the phosphor obtained in Example I-3 is shown in [Fig. 8]. From this Fig., it is evident that, in Example I-3, the intended phosphor with very high crystallinity could be obtained as a single phase containing no impurities.

(Non-luminous object color)

In every Example, the non-luminous object color of the product after the primary firing was white with a reddish tint (pale pink). As the firing progresses to the secondary and tertiary, the color faded and became close to white. This was probably due to the fact that Eu, which was present as trivalent ions $Eu^{3+}$ after the primary firing, was reduced to $Eu^{2+}$ in the fired products after the secondary and tertiary firings.
In the secondary firing, $Eu^{3+}$ is reduced to $Eu^{2+}$, and $Eu^{2+}$ probably occupy $Sr^{2+}$ site of Sr chloroapatite. Crystal nuclei of $Eu^{2+}$-activated Sr chloroapatite phosphor are thereby formed, which is the object compound.
In the following tertiary firing, by performing the firing in the presence of excess $SrCl_2$, growth of the above crystal nuclei is promoted. When firing is done by adding a component which has a flux effect such as $SrCl_2$ in the absence of formation of the above crystal nuclei, microcrystals may be fused together to form particles with a low degree of circularity, particle size distribution of the primary particles may be broadened, or particles with low crystallinities and indistinct crystal habits may be formed.
According to the production method of the present invention, firing is done by adding a component which has a flux effect after crystal nuclei mentioned above are formed. In this way, crystalline particles (primary particles) with high crystallinities and distinct crystal habits can be produced. Furthermore, these crystalline particles are narrow in particle size distribution pattern (namely, small QD value) and have a high degree of circularity, as shown in [Table I-G].

(SEM photo)

An SEM photo of each phosphor obtained is shown in [Fig. 9] for Reference Example I-2, in [Fig. 10] and [Fig. 13] for Example I-2, in [Fig. 11] and [Fig. 14] for Example I-4 and in [Fig. 12] for Comparative Example I-2. While the phosphors obtained in Reference Example I-2, Example I-2, and Example I-4 have distinct crystal habits, the phosphor obtained in Comparative Example I-2 abounds in fracture planes.
In addition, since [Fig. 9] to [Fig. 12] were photographed with the same magnification, it is evident that the crystals of Reference Example I-2, Example I-2, and Example I-4 are large in comparison with the crystals of Comparative Example I-2.
In the production method of the present invention, it is probable that homogeneous oxides are produced at the time of the primary firing and crystal nuclei whose composition is close to that of the intended substance are formed at the time of the secondary firing. In the following tertiary firing, it is probable that particle growth of the primary particles is promoted with the aid of flux, leading to a phosphor with high crystallinity having a uniform particle diameter. From the SEM photos, it is clear that, by multistep firing of the present invention, distinct crystal habits reflecting the crystal structure of Sr chloroapatite are developed.

(Luminescent characteristics and quantum efficiencies)

From [Table I-H], it is evident that external quantum efficiencies of the phosphor of Examples are higher than those of Comparative Examples. Further, it is also clear that the phosphor of Examples has higher absorption efficiency than Comparative Examples I-1 to I-5 and has higher internal quantum efficiency than Comparative Examples I-6 to I-10. External quantum efficiency is the product of absorption efficiency and internal quantum efficiency. It is therefore evident that the phosphor of the present invention has high absorption efficiency and high internal quantum efficiency in a well-balanced manner, leading to the high external quantum efficiency. In particular, the phosphors of Examples I-1 to I-4, I-6, and I-7 have high external quantum efficiencies.
Detailed explanation of each Example will be given below.
The phosphors of Reference Example I-1, Reference Example I-2, Example I-1, and Example I-2 were produced under the same conditions with only the amount of Eu changed. It is evident that, as the amount of Eu increased, the absorption efficiency increased and the external quantum efficiency accordingly increased. Further, it is evident that, with the increase in external quantum efficiency, the emission-peak intensity also increased.
In Reference Example I-3, Reference Example I-4, Example I-3 and Example I-4 also, the amount of Eu was changed, but higher firing temperatures were employed than those of the above Reference Example I-1, Reference Example I-2, Example I-1 and Example I-2. In Reference Example I-1 and Reference Example I-3, and also in Reference Example I-2 and Example I-4, the compositions are the same, but Reference Example I-3 and Reference Example I-4 have higher external quantum efficiencies. Therefore, it is evident that it is preferable to perform firing at relatively high temperatures as is the case with Reference Example I-3, Reference Example I-4, Example I-3 and Example I-4. Also, it is clear from [Table I-H] that temperature characteristics were improved when the amount of Eu is small.
In Example I-5, the composition ratio and firing condition were the same as those of Reference Example I-4 but the charge amounts of the materials and flux used were multiplied 5-fold. From [Table I-H], it is clear that the external quantum efficiency of Example I-5 is improved in comparison with Reference Example I-4. It is also clear from [Table I-G] that the weight median diameter of Example I-5 is larger than that of Reference Example I-4. Accordingly, it is probable that, as the amount charged at once is increased, crystal growth is promoted and, with it, the external quantum efficiency is also improved.
Examples I-6 to I-8 were performed by varying the firing conditions of Reference Example I-1, Reference Example I-2, Example I-1 and Example I-2. Specifically, the temperature of the primary firing was lowered and that of the secondary firing was heightened in comparison with Reference Example I-1, Reference Example I-2, Example I-1 and Example I-2. The composition of Example I-7 is the same as that of Example I-2. From [Table I-G] and [Table I-H], it can be seen that, in Example I-7, the weight median diameter is smaller but the external quantum efficiency is almost the same in comparison with Example I-2. Therefore, from the standpoint of growth of crystalline particles, the firing conditions of Reference Example I-1, Reference Example I-2, Example I-1 and Example I-2 are preferable. In Example I-8, the amount of Eu was increased relative to Example I-7, and its external quantum efficiency was a little lower. This shows that too much Eu tends to lower the external quantum efficiency.
In Comparative Examples I-1 to I-5, characteristic values were obtained from measurement of the known (commercially available) phosphor products. External quantum efficiency was less than 60 % in all of them. Their $I_{ex}(400)/I_{ex}(350)$ values, regarding the excitation spectra, are smaller than those of Examples, and therefore, they can not be a suitable phosphor when used in combination with a light source having an emission peak in near-ultraviolet region.

The phosphors of Comparative Examples I-1 to I-5 show high brightness because of high emission intensity in the region higher than wavelength 480 nm, but are inferior to the phosphors of Examples with respect to emission-peak intensity.

In Comparative Examples I-6 to I-10, Examples 1, 3, 4, 7 and 8 described in Japanese Patent Laid-Open Publication (Kokai) No. 2004-253747 were reexamined. As described before, firing was done only once and no flux was used. In Comparative Examples I-6 to I-10, the absorption efficiency was high in all the cases but the internal quantum efficiency tended to be low. Consequently, the external quantum efficiency was low compared with those of the phosphors of the present Examples. In comparison with Comparative Example I-6, which has the same composition as Example I-2 and Example I-7, it is evident that Example I-2 and Example I-7 are improved with respect to emission-peak intensity, brightness, $I_{emi}(450)/I_{emi}(430)$ value (higher this value may mean narrower emission peak and increase in NTSC ratio), flatness of excitation band in near-ultraviolet region, quantum efficiencies, and the like.

When firing is done as multiple steps according to the production method of the present invention, the crystallinity increases, and therefore, the phosphor of the present invention can maintain high external quantum efficiency even after post-treatments such as pulverization. In other words, the phosphor of the present invention is superior particularly in having high external quantum efficiency even after the phosphor particles got evened in particle diameters.

(Emission spectrum)

Emission spectra measured on the phosphors of Example I-3 and Example I-4 are shown in [Fig. 15].

(Excitation spectrum)

[Fig. 16] shows the excitation spectra of Example I-2, Comparative Example 1-1, and Comparative Example I-3. From the graphs shown, it is evident that, for Example I-2 which represents the phosphor of the present invention, the excitation spectrum in the near-ultraviolet region is high in intensity and flat in shape in comparison with those of commercially available phosphors of Comparative Example I-1 and Comparative Example I-3. Therefore, it is clear that the luminescence is stable even when there is some fluctuation in excitation peak wavelength.

In comparing Examples and Comparative Examples I-1 to I-5 in [Table I-F], it is evident that the value of $I_{ex}(400)/I_{ex}(350)$ defined in the formula (2) is higher for the phosphors of Examples.

From [Table I-F], it is clear that, for the Sr chloroapatite phosphor, its excitation spectrum tends to become flat as the amount of activating element $Eu^{2+}$ increases. For the phosphors of Example I-2 and Example I-7, which were produced according to the production method of the present invention, their excitation spectra are flat, although the amount of $Eu^{2+}$ is the same as that of the phosphor of Comparative Example I-6. This shows that, when a phosphor is produced according to the production method of the present invention, it is possible to produce a phosphor with higher crystallinity, leading to a phosphor with a flat excitation spectrum without using a large amount of Eu source.

(Temperature characteristics)

From the comparison of Examples I-2 to I-5, and Reference Examples I-3 and I-4 with Comparative Examples I-6 to I-10, it is evident that the value of I(125)/I(25) defined in the formula (3) is higher for the phosphors of Examples I-2 to I-5 and Reference Examples I-3 and I-4, which means better temperature characteristics.

In general, in Sr chloroapatite phosphors, when increasing $Eu^{2+}$ amount, brightness increases but emission intensity retention rate, namely, a temperature characteristic tends to become worse. In contrast, a phosphor produced according to the method of the present invention shows higher emission-peak intensity than commercially available products of Comparative Examples I-1 to I-5, as well as better temperature characteristics than those of Comparative Examples I-6 to I-10. For example, it is evident that the phosphor of Example I-2 has better temperature characteristics and is superior in emission-peak intensity and brightness in comparison with the phosphor of Comparative Example I-6, although the amounts of $Eu^{2+}$ are the same. This is probably because phosphors with high crystallinity can be produced by the production method of the present invention. Such a phosphor can be of high emission intensity even when containing a comparatively small amount of $Eu^{2+}$, which leads to the improvement in both emission intensity and temperature characteristics.

[Example I-9]

A white light emitting devices was produced using a blue phosphor, a green phosphor, and a red phosphor according to the following procedure. As the blue phosphor, the $Sr_9Eu(PO_4)_6Cl_2$ obtained in Example I-2 was used. As the red phosphor, $Ca_{0.992}Eu_{0.008}AlSiN_3$ (hereinafter referred to as phosphor (A) as appropriate) was used. As the green phosphor, $Ba_{0.65}Eu_{0.35}Mg_{0.65}Mn_{0.35}Al_{10}O_{17}$ (hereinafter referred to as phosphor (B) as appropriate) was used.

As the phosphor (A), the one synthesized referring to Electrochemical and Solid-State Letters, vol. 9, No. 4, pp. H22-H25 (2006) was used. As the phosphor (B), the one synthesized referring to Japanese Patent Application No. 2007-092852 was used.

In the following explanation of the present Example, the reference numerals of the parts corresponding to those in FIG. 2(b) are shown in "[]".

As the first luminous body, a near-ultraviolet LED [22] (C395-EZ, manufactured by Cree, Inc.) having an emission wavelength of from 395 nm to 400 nm was used. The near-ultraviolet LED [22] was bonded to the terminal [27] disposed at the bottom of the recess in the frame [24] by means of die bonding using a silver paste as adhesive. Then, the near-ultraviolet LED [22] and the electrode [26] of the frame [24] were connected using a gold wire [25] as wire having a diameter of 25 $\mu$m.

The phosphor mixture comprising the above three kinds of phosphors (the blue, red, and green phosphors) were blended sufficiently with a silicone resin (JCR6101UP, manufactured by Dow Corning Toray Co., Ltd.) in a ratio described in [Table I-I], and then the phosphor-silicone resin mixture (phosphor-containing composition) was poured inside the recess of the above-mentioned frame [24].

The mixture was kept at 150°C for 2 hrs so as to cure the silicone resin, thereby forming the phosphor-containing part [23]. A surface-mount white light emitting device was thus produced.

[Example I-10]

A white light emitting devices was produced in the same manner as in Example I-9, except that the $Sr_9Eu(PO_4)_6Cl_2$ obtained in Example I-2 was used as the blue phosphor, $La_{1.8}Eu_{0.2}O_2S$ (hereinafter referred to as phosphor (C) as appropriate) was used as the red phosphor, and the phosphor (B) was used as the green phosphor at a rate shown in [Table I-I]. As the phosphor (C), the one synthesized referring to the Description of Japanese Patent Application No. 2005-290570 (Japanese Patent Laid-Open Publication (Kokai) No. 2007-99878) was used.

[Table 17]

| [Table I-I] | | | | | | |
|---|---|---|---|---|---|---|
| | Blue phosphor (phosphor of the present invention) | Red phosphor | Green phosphor | Blue phosphor mixing ratio [weight %] | Green phosphor mixing ratio [weight %] | Red phosphor mixing ratio [weight %] |
| Example I-9 | Example 1-2 | Phosphor [A] | Phosphor [B] | 24 | 70 | 5 |
| Example I-10 | Example I-2 | Phosphor [C] | Phosphor [B] | 4 | 15 | 81 |

* Phosphor A: $Ca_{0.992}Eu_{0.008}AlSiN_3$
* Phosphor B: $Ba_{0.65}Eu_{0.35}Mg_{0.65}Mn_{0.35}Al_{10}O_{17}$
* Phosphor C: $La_{1.8}Eu_{0.2}O_2S$

[Result and Discussion]

When carrying a 20-mA current to the near-ultraviolet LED (22) of the obtained surface-mount light emitting device to drive and have it emit light, the light emitting devices of all the Examples could emit a white light.

On the obtained surface-mount white light emitting device, the emission spectra were measured. Specifically, the measurement was performed in a room of which temperature was kept at 25$\pm$1°C using a software for measuring color and illumination intensity and a spectroscope of USB2000 series (integrating sphere version) manufactured by Ocean Optics, Inc. The result is shown in [Fig. 17]. Various luminescent characteristics values (entire luminous flux, light output, color coordinates, color temperature, and chromaticity deviation) calculated from the obtained emission spectrum are shown in [Table I-J]. In [table I-J], Tcp represents correlated color temperatures (unit: K) and Duv represents chromaticity deviations, respectively.

[Table 18]

| [Table I-J] | | | | | | |
|---|---|---|---|---|---|---|
| | Entire luminous flux [lm] | Light output [mW] | Color coordinates | | Tcp [K] | Duv |
| | | | x | y | | |
| Example I-9 | 0.9 | 4.8 | 0.32 | 0.33 | 7038 | -1.3 |
| Example I-10 | 1 | 4.3 | 0.33 | 0.34 | 6796 | -0.6 |

In this way, by combining the phosphor of the present invention with arbitrary red and green phosphors, a light emitting device and a light source for image display with broad color reproduction ranges could be obtained.

[Example Group II]

The present invention will be explained more specifically below with the citation of Production Examples, Examples, and Comparative Examples of backlights and color image displays of the present invention.

[II-1] Synthesis of phosphor

[II-1-1] Synthesis Example 1: Synthesis of red phosphor $(La_{0.9}Eu_{0.1})_2O_2S$ (hereinafter also referred to as "LOS")

Each material was weighed out in a molar ratio of $La_2O_3$ 0.9, $Eu_2O_3$ 0.1, $Li_2CO_3$ 0.05, $Na_2CO_3$ 0.2, $K_2CO_3$ 0.75, $KH_2PO_4$ 0.1 and sulfur powder 5 (as sulfur), and they were mixed in a dry type manner. The mixture obtained was filled in a high purity alumina crucible and, after the crucible was covered with an airtight alumina lid, heated at 1300°C for 2 hrs in a nitrogen gas atmosphere. Lithium sulfide, sodium sulfide and potassium sulfide, formed during the heating, functioned as alkali sulfide flux and reacted with lanthanum oxide and europium oxide to generate oxysulfides. Subsequently, the flux was allowed to continue to be in contact with them and thereby the target phosphor was obtained. After washing with water to remove alkali sulfide flux attached to the surface and drying at 140°C, a phosphor $(La_{0.9}Eu_{0.1})_2O_2S$ was obtained.

[II-1-2] Synthesis Example 2: Synthesis of red phosphor $Ca_{0.985}Eu_{0.015}AlSi_{1.03}N_3$ (hereinafter also referred to as "CASN")

$Ca_3N_2$ (manufactured by CERAC, inc., 200 mesh pass), AlN (manufactured by TOKUYAMA Corp., grade F), $Si_3N_4$ (manufactured by Ube Industries, Ltd., SN-E10) and $EuF_3$ (manufactured by Shin-Etsu Chemical Co., Ltd.) were weighed out in a nitrogen atmosphere so that the metal-element composition ratio of Eu:Ca:Al:Si was 0.015:0.985:1:1.03. They were mixed in a mixer for 10 mins thereby to form a phosphor material.
The phosphor material obtained was filled in a boron nitride crucible, placed in a resistance-heating, vacuum pressurized-atmosphere heat-treating furnace (manufactured by Fujidenpa Kogyo Co., Ltd.) and vacuum heated until the temperature was increased from room temperature to 800°C at a temperature rising rate of 10 °C/min under a reduced pressure of $<5\times10^{-3}$ Pa (namely, less than $5\times10^{-3}$ Pa). When the temperature reached 800°C, a high-purity (99.9995 %) nitrogen gas was introduced during 30 mins until the pressure reached 0.75 MPa while maintaining the temperature. After the introduction, the temperature was further raised to 1800°C at a temperature rising rate of 5 °C/min while the pressure was maintained at 0.75 MPa. After the temperature was maintained for 3 hrs, the product was allowed to cool to room temperature. Examination of the fluorescence characteristics showed that the emission-peak wavelength, when excited with light of 455 nm, was 659 nm.

[II-1-3] Synthesis Example 3: Synthesis of green phosphor $Ba_{0.65}Eu_{0.35}Mg_{0.65}Mn_{0.35}Al_{10}O_{17}$ (hereinafter also referred to as "GBAM")

As the phosphor materials, 0.65 mole barium carbonate ($BaCO_3$), 0.175 mole europium oxide ($Eu_2O_3$), 0.65 mole basic magnesium carbonate (mass of 93.17 per 1 mole Mg), 0.35 mole manganese carbonate ($MnCO_3$) and 10 mole $\alpha$-alumina ($Al_2O_3$) were weighed out. Also weighed out as the fluxes were 0.4 weight % aluminum fluoride ($AlF_3$) and 0.6 weight % potassium fluoride (KF), relative to the weight of the phosphor after firing.
The phosphor materials and fluxes mentioned above were mixed in a mortar for 30 mins and filled in an alumina crucible. In order to create a reducing atmosphere at the time of firing, bead-shaped graphite was placed in a space around the crucible. This mixture of the phosphor materials and fluxes was fired at 1550°C for 2 hrs under atmospheric pressure. The fired product obtained was ground to obtain a phosphor. The composition formula of the phosphor obtained was $Ba_{0.65}Eu_{0.35}Mg_{0.65}Mn_{0.35}Al_{10}O_{17}$. An elemental analysis on the content ratio of each element showed that the content ratio of K (potassium) relative to the number of sites which can be replaced by Eu was 1 mole %. The non-luminous object color of this phosphor was vivid green.

[II-1-4] Synthesis Example 4: Synthesis of green phosphor $Ba_{1.65}Sr_{0.2}Eu_{0.15}SiO_4$ (hereinafter also referred to as "BSS")

As the phosphor materials, barium carbonate ($BaCO_3$), strontium carbonate ($SrCO_3$), europium oxide ($Eu_2O_3$) and silicon dioxide ($SiO_2$) were used, each in the powder form. Each of these phosphor materials was 99.9% or higher in purity and its weight median diameter $D_{50}$ was in the range of 10 nm or larger and 5 μm or smaller. These phosphor materials were weighed out so that their molar ratio Ba:Sr:Eu:Si was 1.65:0.2:0.15:1. The powders of these phosphor materials were mixed well in an automatic mortar until they were sufficiently homogeneous, transferred to an alumina crucible and fired at 1100°C in air under atmospheric pressure for 12 hrs.

The content of the crucible was taken out, $SrCl_2$ was added as flux to give an above-mentioned molar ratio of 0.1, and the mixture was mixed and ground in a dry-type ball mill. The powdered mixture obtained was again transferred to an alumina crucible. At the time of firing, solid carbon (in a block shape) was placed as a lid on the material filled in the alumina crucible. In a vacuum furnace, the pressure was reduced to 5 Pa or lower using a vacuum pump and then a hydrogen-containing nitrogen gas (nitrogen : hydrogen = 96 : 4 (volume ratio)) was introduced until atmospheric pressure was restored. This operation was repeated and firing was done at 1200°C for 4 hrs in atmospheric pressure under a flow of a hydrogen-containing nitrogen gas (nitrogen : hydrogen = 96 : 4 (volume ratio)).

The fired product obtained was powdered using a ball mill and, just as it is slurry, passed through a sieve to remove coarse particles, washed with water and elutriated to remove fine particles. After drying, it was sieved again to disintegrate aggregated particles, thereby to produce a phosphor. Examination of the fluorescence characteristics showed that the emission-peak wavelength, when excited with light of 455 nm, was 520 nm.

[II-1-5] Synthesis Example 5: Synthesis of blue phosphor $Sr_9(PO_4)_6Cl_2$:Eu (hereinafter also referred to as "SCA")

<Mixing process>

0.20 mol of $SrCO_3$ (manufactured by KANTO CHEMICAL CO., INC.), 0.605 mol of $SrHPO_4$ (manufactured by KANTO CHEMICAL CO., INC.), 0.050 mol of $Eu_2O_3$ (manufactured by Shin-Etsu Chemical Co., Ltd., purity 99.99%), and 0.1 mol of $SrCl_2$ (manufactured by KANTO CHEMICAL CO., INC.) were weighed out and mixed with a small size V type blender by a dry-type mixing method.

<Firing process>

(Primary firing)

The material mixture obtained was filled in an alumina crucible and placed in a box-type electric furnace (manufactured by Motoyama, RH-2035D).

The temperature was raised at a temperature rising rate of 5 °C/min until it reached 1050°C (maximum heating temperature) under atmospheric pressure in the air. That temperature was maintained for 5 hrs, thereby to obtain a fired product. The fired product emitted red light when excited with a light of 254-nm wavelength. This red luminescence was probably due to luminescence of $Eu^{3+}$.

The mixture was then cooled to room temperature, taken out of the crucible, and pulverized.

(Secondary firing)

After the fired product obtained was added with 0.05 mole of $SrCl_2$ and mixed in a small size V type blender, the mixture was filled in an alumina crucible. Then, the crucible was placed in the same electric furnace as that of the primary firing.

While hydrogen-containing nitrogen gas (hydrogen : nitrogen = 4 : 96 (by volume)) was passed at a rate of 2.5 ± 0.5 L/min, the temperature was raised at a rate of 5 °C/min until it reached 920°C (maximum heating temperature) under atmospheric pressure in a reducing atmosphere. That temperature was maintained for 3 hrs. The mixture was then cooled to room temperature, taken out of the crucible, and pulverized.

(Tertiary firing)

After the fired product obtained was added with 0.05 mole of $SrCl_2$ and mixed in a small size V type blender, the mixture was filled in an alumina crucible. Then, the crucible was placed again in the same electric furnace as that of the secondary firing.

While hydrogen-containing nitrogen gas (hydrogen : nitrogen = 4 : 96 (by volume)) was passed at a rate of 2.5 ± 0.5 L/min, the temperature was raised at a rate of 5 °C/min until it reached 950°C (maximum heating temperature) under atmospheric pressure in a reducing atmosphere. That temperature was maintained for 3 hrs.

<Post-treatment etc.>

After the obtained fired lump was subjected to a coarse milling to have a particle diameter of about 5 mm, a mixture was prepared so that the phosphor : 3-mm alumina ball : water = 1 : 3 : 1 (by weight). The mixture was treated in a ball mill at 60 rpm for 6 hrs thereby to give a phosphor slurry.

In order to wash the phosphor, the phosphor slurry was mixed with a large amount of water and stirred. After the mixture was allowed to settle to precipitate the phosphor particles, the supernatant was decanted off. This procedure was repeated until the electric conductivity of the supernatant fell below 3 mS/m. After verifying that the electric conductivity of the supernatant fell below 3 mS/m, a classification was performed to remove the coarse particles and minute particles of the phosphor.

The obtained phosphor slurry was dispersed in an $Na_3PO_4$ aqueous solution (pH=10) and, after removing the small particles by classification, treated with calcium phosphate. After dehydration, the phosphor was obtained by drying at 150°C for 10 hrs.

[II-1-6] Evaluation of temperature dependence of phosphor

On each phosphor prepared in [II-1-1] to [II-1-5], the temperature dependences of brightness and emission intensity (hereinafter also referred to as "temperature characteristics" collectively) under excitation by 395-nm wavelength were measured.

The temperature characteristics were examined as follows, using a multi-channel spectrum analyzer, MCPD7000, manufactured by Otsuka Electronics Co., Ltd. as emission spectrum measurement device, a luminance colorimeter BM5A as brightness measurement apparatus, a stage equipped with a cooling mechanism using a peltiert device and a heating mechanism using a heater, and a light source device equipped with a 150-W xenon lamp.

A cell holding a phosphor sample was put on the stage, and the temperature was changed to 25°C, then 150°C, followed by verifying the surface temperature of the phosphor at each temperature. Then, the brightness value and the emission spectrum were measured by exciting the phosphor with a light from the light source having a wavelength of 395 nm, which was separated using a diffraction grating. Then the emission-peak intensity was decided from the measured emission spectrum. At this point, as the measurement value of the surface temperature of the phosphor on the side irradiated with the excitation light, was used a value corrected by the temperature values measured with a radiation thermometer and a thermocouple. The results are shown in Table II-A below.

[Table 19]

| [Table II-A] | | | | | |
|---|---|---|---|---|---|
| | Phosphor | Internal quantum efficiency (395-nm excitation) (%) | Absorption efficiency (395-nm excitation) (%) | External quantum efficiency (395-nm excitation) (%) | 150-°C emission peak intensity / 25-°C emission peak intensity (%) |
| Synthesis Example 1 | LOS | 70.2 | 79.1 | 55.5 | 20 |
| Synthesis Example 2 | CASN | 87.1 | 90.5 | 78.8 | 81 |
| Synthesis Example 3 | GBAM | 87.4 | 87.7 | 76.6 | 78 |
| Synthesis Example 4 | BSS | 85.7 | 97.8 | 83.8 | 29 |
| Synthesis Example 5 | SCA | 85.7 | 95.8 | 82.1 | 60 |

(continued)

| [Table II-A] | | | | | |
|---|---|---|---|---|---|
| | Phosphor | Internal quantum efficiency (395-nm excitation) (%) | Absorption efficiency (395-nm excitation) (%) | External quantum efficiency (395-nm excitation) (%) | 150-°C emission peak intensity / 25-°C emission peak intensity (%) |
| Commercialized product red | KX-681 | - | - | 28.9 | 0 |
| Commercialized product green | LP-G3 | - | - | 32.2 | 93 |
| Commercialized product blue | LP-B4 | - | - | 40.9 | 101 |
| Commercialized product blue | LP-B1 | - | - | 39.3 | 91 |

[II-2] Production of backlight

[II-2-1] Production Example II-1: Production of backlight 1 (BL-1)

A light emitting device was produced by a procedure described below.

An nUV light-emitting diode (Cree, Inc., 395 MB) whose peak luminous wavelength is 395 nm was bonded to the bottom of a cup formed in a frame by die bonding. Then, the electrodes of the light-emitting diode and the frame were connected by wire bonding.

SCA was used as blue phosphor, GBAM was used as green phosphor, and CASN was used as red phosphor. A paste was formed by mixing the phosphors into a silicone resin "JCR6101UP" manufactured by Dow Corning Toray Co., Ltd., and it was applied on the light-emitting diode in the cup and then cured.

As the optical waveguide, a wedge-shaped cyclic polyolefin resinous plate (commercial name: "ZEONOR", manufactured by ZEON CORPORATION) which has a size of 289.6 × 216.8 mm and thicknesses of 2.0 mm in the heavy-wall portion and 0.6 mm in the thin-wall portion and is tapered in the short side direction was used. Along the long side edge on the heavy-wall side, the above-mentioned light-emitting diode was disposed as light source so that the outgoing light from the linear light source can efficiently enter the heavy-wall side (light incidence plane) of the optical waveguide.

On the surface confronting the light-outgoing plane of the optical waveguide, rough-surfaced, minute circle patters were transferred from a metallic mold, which got larger in diameter with distance from the linear light source. The diameters of the rough-surfaced patterns, which increased with distance from the light source, were 130 μm in the vicinity of the light source and 230 μm at the farthest region.

The metallic mold used for forming the rough-surfaced, minute circle patterns was prepared as follows. A dry film resist with a thickness of 50 μm was laminated on an SUS substrate, and an apertural area that corresponds the patterns by photolithography was formed. After the metallic mold was subjected to blast processing under 0.3 MPa projection pressure with a sandblasting with spherical glass beads #600, the dry film resist was peeled.

On the light outgoing plane of the optical waveguide, an array of triangular prisms, of which apical angle was 90° and pitch was 50 μm, was formed so that the ridgeline thereof was approximately perpendicular to the light incident plane of the optical waveguide. Thereby, the condensing capability of the luminous flux outgoing from the optical waveguide was enhanced. The metallic mold used for forming the light-condensing array consisting of array of triangular prisms was prepared by grinding of an M nickel stainless steel substrate electroless-plated with nickel using a single crystal diamond bit.

A light-reflecting sheet ("LUMIRROE E60L", manufactured by TORAY INDUSTRIES, INC.) was disposed on the side confronting the light outgoing plane of the optical waveguide, and a light-diffusion sheet was disposed on the light outgoing plane. Further on the light-diffusion sheet, two sheets ("BEFIII", manufactured by Sumitomo 3M Limited) each formed with an array of triangular prisms of which apical angle was 90° and pitch was 50 μm was applied so that the ridgelines of the two prism sheets crossed at right angles. Thereby a backlight 1 (BL-1) was produced.

On the backlight 1 produced as above, the entire luminous flux and emission spectrum was measured with OCEAN OPTICS HR-2000. The driving current for the LED was set at 20 mA. Fig. 18 shows the relative emission spectrum of the backlight 1. It is evident from Fig. 18 that the backlight 1 had one emission peak at wavelengths of 447 nm, 516 nm, and 652 nm, respectively. The entire luminous flux of the backlight 1 was 0.9 lm (lumen).

[II-2-2] Production Example II-2: Production of backlight 2 (BL-2)

A backlight 2 (BL-2) was produced in the same way as Production Example II-1 except for using LOS as red phosphor in Production Example II-1. Fig. 19 shows the relative emission spectrum of the backlight 2. It is evident from Fig. 19 that the backlight 2 had one emission peak at wavelengths of 445 nm, 516 nm, and 624 nm, respectively. The entire luminous flux of the backlight 2 was 1.01 lm (lumen).

[II-2-3] Production Example II-3: Production of backlight 3 (BL-3) for Comparative Example

A backlight 3 (BL-3) was produced in the same way as Production Example II-1 except for, in Production Example II-1, using an oxysulfide red phosphor "KX-681" manufactured by Kasei Optonics, Ltd. as red phosphor, an aluminate green phosphor "LP-G3" manufactured by Kasei Optonics, Ltd. as green phosphor, and a halophosphate blue phosphor "LP-B1" manufactured by Kasei Optonics, Ltd. as blue phosphor. Fig. 20 shows the relative emission spectrum of the backlight 3. It is evident from Fig. 20 that the backlight 3 had one emission peak at wavelengths of 448 nm, 516 nm, and 624 nm, respectively. The entire luminous flux of the backlight 3 was 0.61 lm (lumen).

[II-2-4] Production Example II-4: Production of backlight 4 (BL-4) for Comparative Example

A backlight 4 (BL-4) was produced in the same way as Production Example II-3 except for, in Production Example II-3, using an aluminate blue phosphor "LP-B4" manufactured by Kasei Optonics, Ltd. as blue phosphor. Fig. 21 shows the relative emission spectrum of the backlight 4. It is evident from Fig. 21 that the backlight 4 had one emission peak at wavelengths of 451 nm, 516 nm, and 624 nm, respectively. The entire luminous flux of the backlight 4 was 0.61 lm (lumen).

[II-2-5] Production Example II-5: Production of backlight 5 (BL-5) for Comparative Example

A backlight 5 (BL-5) for Comparative Example was produced in the same way as Production Example II-1 except that, in Production Example II-1, a blue-light emitting diode of which peak luminous wavelength is 454 nm was used in place of the nUV light-emitting diode, BSS was used as green phosphor, and the proportion between BSS and CASN was such that it gave an emission spectrum shown in Fig. 22. It is evident from Fig. 22 that the backlight 5 had one emission peak at wavelengths of 456 nm, 516 nm, and 642 nm, respectively.

[II-2-6] Production Example II-6: Production of backlight 6 (BL-6) for Comparative Example

A light emitting device was produced by a procedure described below.

A blue light-emitting diode whose dominant luminous wavelength is 460 nm was bonded to the bottom of the cup formed in a frame by die bonding. Then, the electrodes of the light-emitting diode and the frame were connected by wire bonding. $Y_{2.8}Tb_{0.1}Ce_{0.1}Al_5O_{12}$ was used as yellow phosphor. A paste was formed by mixing the phosphor in an epoxy resin, and it was applied and cured on the light-emitting diode in the cup. Then, a conventional type backlight 6, to be used for Comparative Example, was produced subsequently by the same procedure as Production Example II-1. Fig. 23 shows the relative emission spectrum of the backlight 6, obtained in such a way.

[II-3] Production of binder resin

[II-3-1] Production Example II-7: Binder resin A

55 weight parts of benzyl methacrylate, 45 weight parts of methacrylic acid, and 150 weight parts of propylene glycol monomethyl ether acetate were transferred into a 500-ml separable flask and the atmosphere in the flask was replaced by nitrogen sufficiently. After adding 6 weight parts of 2,2'-azobisisobutyronitrile and stirring them at 80°C for 5 hrs, a polymer solution was obtained. The weight-average molecular weight of the polymer synthesized was 8000, and the acid value thereof was 176 mgKOH/g.

[II-3-2] Production Example II-8: Binder resin B

145 weight parts of propylene glycol monomethyl ether acetate was stirred while performing substitution with nitrogen, and the temperature was raised to 120°C. Onto it was dropped 20 weight parts of styrene, 57 parts of glycidyl methacrylate, and 82 weight parts of monoacrylate (FA-513M, manufactured by Hitachi Chemical Co., Ltd.) having a skeletal structure of tricyclodecane, and further stirring was performed at 120°C for 2 hrs.

After the substitution in the reaction vessel was changed to air, 27 weight parts of acrylic acid, 0.7 weight parts of tris dimethylaminomethyl phenol, and 0.12 weight parts of hydroquinone were charged. Then, they reacted at 120°C for 6 hrs. After adding 52 weight parts of tetrahydro phthalic anhydride (THPA) and 0.7 weight parts of triethyl amine, another reaction was conducted at 120°C for 3.5 hrs.

The weight-average molecular weight Mw of the polymer obtained in this way was about 8000.

[II-4] Production Example II-9: Production of clear resist solution

Each component listed below were mixed in the proportion below, followed by stirring with a stirrer until each component fully dissolved. A resist solution was thereby obtained.

binder resin B prepared in Production Example II-8: 2.0 parts
dipentaerythritol hexaacrylate: 1.0 part
photopolymerization initiator
2-(2'-chlorophenyl)-4,5-diphenyl imidazole: 0.06 parts
2-mercapto benzothiazole: 0.02 parts
4,4'-bis(diethylamino)benzophenone: 0.04 parts
solvent (propylene glycol monomethyl ether acetate): 9.36 parts
surfactant ("F-475", manufactured by DIC Corporation): 0.0003 parts

[II-5] Production of color filter

[II-5-1] Production Example II-10: Production of red picture element for Examples II-1 to II-12 and Comparative Examples II-1 and II-2

A mill base of which solid component concentration was 25 weight % was prepared by mixing 75 parts of propylene glycol monomethyl ether acetate, 16.7 parts of a red pigment P.R.254, 4.2 parts of acrylic dispersant "DB2000" manufactured by BYK Japan KK, and 5.6 parts of binder resin A produced in Production Example II-7 and stirring them with a stirrer for 3 hrs. This mill base was subjected to a dispersion treatment with a beads mill using 600 parts of 0.5-mmϕ zirconia beads at a circumferential velocity of 10 m/s for a holding time of 3 hrs, thereby obtaining a dispersed ink of P.R.254.

In addition, another mill base was prepared in the same proportion of materials as the above-mentioned P.R. 254 except that the pigment was changed into P.Y.150. The mill base was subjected to a dispersion treatment in the same dispersion conditions for a holding time of 2 hrs, thereby obtaining a P.Y.150 dispersed ink.

Furthermore, still another mill base was prepared in the same proportion of materials as the above-mentioned P.R.254 except that the pigment was changed into P.Y.177. The mill base was subjected to a dispersion treatment in the same dispersion conditions for a holding time of 3 hrs, thereby obtaining a P.Y.177 dispersed ink.

The dispersed ink obtained as above and the resist solution obtained in the above Production Example II-9 were mixed in a proportion shown in Table II-B below and stirred. Then a solvent (propylene glycol monomethyl ether acetate) was added thereto so that the resultant solid component concentration was 25 weight %, thereby obtaining a composition for red color filter.

The composition for color filter obtained as above was applied on a 10 cm × 10 cm glass substrate ("AN635" manufactured by ASAHI GLASS CO., LTD.) with a spin coater and then dried. After irradiating the entire substrate with ultraviolet light of which exposure amount is 100 mJ/cm$^2$, a development was performed with an alkali developer, followed by post-baking at 230°C for 30 mins in an oven. Thereby, a red picture element sample for measurement was prepared. The film thickness of the red picture element after preparation was adjusted to be 2.5 μm.

[Table 20]

| [Table II-B] | | | | |
|---|---|---|---|---|
| Red picture element | R254 | Y150 | R177 | Clear resist |
| For Example 11-1, II-3, II-5 | 15.0 | 8.6 | 0 | 76.4 |
| For Example II-2, II-4, II-6 | 12.5 | 7.2 | 0 | 80.2 |

(continued)

| [Table II-B] | | | | |
|---|---|---|---|---|
| Red picture element | R254 | Y150 | R177 | Clear resist |
| For Example II-7, II-9, II-11 | 18.1 | 7.9 | 0 | 77.5 |
| For Example II-8, II-10, II-12 | 14.4 | 6.2 | 0 | 82.2 |
| For Comparative Example II-1 | 16.4 | 0 | 6.3 | 77.3 |
| For Comparative Example II-2 | 16.7 | 0 | 17.2 | 66.1 |

[II-5-2] Production Example II-11: Production of green picture element for Examples II-1 to II-12 and Comparative Examples II-1 and II-2

A mill base was prepared in the same proportion of materials as P.R.254 of Production Example II-10 except that the pigment was changed into P.G.36. The mill base was subjected to a dispersion treatment in the same dispersion conditions for a holding time of 1 hr, thereby obtaining a P.G.36 dispersed ink.
Another mill base was prepared in the same way except for using a pigment P.G.7 instead. The mill base was subjected to a dispersion treatment in the same dispersion conditions for a holding time of 2 hrs, thereby obtaining a P.G.7 dispersed ink.
In addition, still another mill base was prepared in the same proportion of materials as Production Example II-10 except that the pigment was changed into P.Y.150. The mill base was subjected to a dispersion treatment in the same dispersion conditions for a holding time of 2 hrs, thereby obtaining a P.Y.150 dispersed ink.
Furthermore, still another mill base was prepared in the same proportion of materials as Production Example II-10 except that the pigment was changed into zinc bromide phthalocyanine and the dispersant was changed into an acrylic dispersant "LPN6919" manufactured by BYK Japan KK. The mill base was subjected to a dispersion treatment in the same dispersion conditions for a holding time of 3 hrs, thereby obtaining a dispersed ink of zinc bromide phthalocyanine. The zinc bromide phthalocyanine pigment was synthesized by the procedure shown in [II-5-2-1] below.

[II-5-2-1] Synthesis Example II-1: Synthesis of zinc bromide phthalocyanine

Zinc phthalocyanine was formed from materials of phthalodinitrile and zinc chloride. Its 1-chloronaphthalene solution showed absorption of light at wavelengths of 600 nm to 700 nm. Halogenation was performed by mixing 3.1 mass parts of sulfuryl chloride, 3.7 weight parts of aluminium chloride anhydride, 0.46 weight parts of sodium chloride, and 1 weight parts of zinc phthalocyanine at 40°C and dropping 4.4 weight parts of bromine thereonto. After the reaction at 80°C for 15 hrs, the mixture after reaction was thrown in water to precipitate a coarse pigment of zinc bromide phthalocyanine. This aqueous slurry was filtrated, washed with hot water at 80°C, and dried at 90°C, thereby affording 3.0 weight parts of refined zinc bromide phthalocyanine coarse pigment.
1 weight parts of this zinc bromide phthalocyanine coarse pigment, 12 weight parts of pulverized sodium chloride, 1.8 weight parts of diethylene glycol, and 0.09 weight parts of xylene were charged in a dual arm kneader, furrowed by being kneaded at 100°C for 6 hrs. The mixture kneaded was transferred in 100 weight parts of 80-°C water, stirred for 1 hr, filtrated, washed with hot water, dried, and pulverized, thereby giving a zinc bromide phthalocyanine pigment.
A mass spectrometry of halogen content revealed that the obtained zinc bromide phthalocyanine pigment had an average composition of $ZnPcBr_{14}Cl_2$ (Pc: phthalocyanine) and averaged 14 bromines contained in one molecule. In addition, the mean value of primary particle diameters, which were measured with a transmission electron microscope (H-9000UHR, manufactured by Hitachi, Ltd.) was 0.023 $\mu$m. The average primary particle diameter of the pigments was calculated from the primary particle diameters that was measured from images of the pigment primary particles. The primary particles images were obtained by a transmission electron microscope (TEM) observation of the pigment that was dispersed in chloroform with ultrasonic, dropped on a mesh with a collodion film affixed, and dried.
The dispersed ink obtained as above and the resist solution obtained in the above Production Example II-9 were mixed in a proportion shown in Table II-C below and stirred. Then a solvent (propylene glycol monomethyl ether acetate) was added thereto so that the resultant solid component concentration was 25 weight %, thereby obtaining a composition for green color filter.
The composition for color filter obtained as above was applied on a 10 cm $\times$ 10 cm glass substrate ("AN635" manufactured by ASAHI GLASS CO., LTD.) with a spin coater and then dried. After irradiating the entire substrate with ultraviolet light of which exposure amount is 100 mJ/$cm^2$, a development was performed with an alkali developer, followed by a post-baking at 230°C for 30 mins in an oven. Thereby, a green picture element sample for measurement was prepared. The film thickness of the green picture element after preparation was adjusted at 2.5 μm.

[Table 21]

| [Table II-C] | | | | | |
|---|---|---|---|---|---|
| Green picture element | G36 | G7 | Zinc bromide phthalocyanine | Y150 | Clear resist |
| For Example II-1 | 17.0 | 0 | 0 | 26.7 | 56.3 |
| For Example II-2 | 14.3 | 0 | 0 | 22.6 | 63.1 |
| For Example II-3 | 0 | 12.7 | 0 | 28.5 | 58.9 |
| For Example II-4 | 0 | 9.8 | 0 | 22.1 | 68.1 |
| For Example II-5 | 0 | 0 | 21.3 | 20.1 | 58.6 |
| For Example II-6 | 0 | 0 | 18.0 | 17.0 | 65.1 |
| For Example II-7 | 17.0 | 0 | 0 | 26.7 | 56.3 |
| For Example II-8 | 13.4 | 0 | 0 | 21.2 | 65.4 |
| For Example II-9 | 0 | 12.7 | 0 | 28.5 | 58.9 |
| For Example II-10 | 0 | 8.8 | 0 | 19.7 | 71.5 |
| For Example II-11 | 0 | 0 | 21.3 | 20.1 | 58.6 |
| For Example II-12 | 0 | 0 | 16.3 | 15.3 | 68.4 |
| For Comparative Example II-1 | 0 | 13.0 | 0 | 14.4 | 72.6 |
| For Comparative Example II-2 | 60.4 | 0.0 | 0 | 2.9 | 36.7 |

[II-5-3] Production Example II-12: Production of blue picture element for Examples II-1 to II-12 and Comparative Examples II-1 and II-2

A mill base was prepared in the same proportion of materials as P.R.254 of Production Example II-10 except that the pigment was changed into P.G.15:6. The mill base was subjected to a dispersion treatment in the same dispersion conditions for a holding time of 1 hr, thereby obtaining a P.G.15:6 dispersed ink.

Another mill base was prepared in the same proportion of materials as P.R.254 of Production Example II-12 except that the pigment was changed into P.V.23. The mill base was subjected to a dispersion treatment in the same dispersion conditions for a holding time of 2 hrs, thereby obtaining a P.V.23 dispersed ink.

The dispersed ink obtained as above and the resist solution obtained in the above Production Example II-9 were mixed in a proportion shown in Table II-D below and stirred. Then a solvent (propylene glycol monomethyl ether acetate) was added thereto so that the resultant solid component concentration was 25 weight %, thereby obtaining a composition for blue color filter.

The composition for color filter obtained as above was applied on a 10 cm × 10 cm glass substrate ("AN100" manufactured by ASAHI GLASS CO., LTD.) with a spin coater and then dried. After irradiating the entire substrate with ultraviolet light of which exposure amount is 100 mJ/$cm^2$, a development was performed with an alkali developer, followed by a post-baking at 230°C for 30 mins in an oven. Thereby, a blue picture element sample for measurement was prepared. The film thickness of the blue picture element after preparation was adjusted to be 2.5 μm.

[Table 22]

| [Table II-D] | | | | |
|---|---|---|---|---|
| Blue picture element | B15:6 | V23 | G36 | Clear resist |
| For Example II-1, II-3, II-5 | 14.2 | 4.9 | 0 | 81.9 |
| For Example II-2, II-4, II-6 | 12.6 | 4.3 | 0 | 83.1 |
| For Example II-7, II-9, II-11 | 11.2 | 5.6 | 0 | 83.2 |

(continued)

| [Table II-D] | | | | |
|---|---|---|---|---|
| Blue picture element | B15:6 | V23 | G36 | Clear resist |
| For Example II-8, II-10, II-12 | 8.9 | 4.5 | 0 | 86.6 |
| For Comparative Example II-1 | 7.7 | 2.7 | 0 | 89.6 |
| For Comparative Example II-2 | 16.4 | 1.4 | 9.7 | 72.5 |

[II-5-4] Color filter

Color filters of Examples II-1 to II-12 and Comparative Examples II-1 and II-2 were produced by combining each corresponding red, green, and blue picture elements listed in Table II-B, Table II-C, and Table II-D. Fig. 24 to Fig. 36 show calculated results of transmittance spectra of the red, green, and blue picture element samples of the color filters used for Examples II-1 to II-12 and Comparative Examples II-1 and II-2.

[II-6] Color image display

[II-6-1] Examples II-1 to II-6 and Comparative Examples II-1 and II-2

Color image displays of Examples II-1 to II-6 and Comparative Examples II-1 and II-2 were produced by combining backlights (BL-1, BL-5, and BL-6) described in Production Examples II-1, II-5, and II-6 and the above color filters for Examples II-1 to II-6 and Comparative Examples II-1 and II-2. Chromaticities (x,y,Y) of these color image displays were determined by simulations from the relative emission spectra of the above-mentioned respective backlights and the transmittance spectra of the above-mentioned respective color filters. In addition, color reproductions (NTSC ratios) and brightnesses (color temperatures) thereof were also determined. In this context, the Y value corresponds to the utilization efficiency of the luminescence from the backlight. The results are shown in Table II-E.

[Table 23]

| [Table II-E] | | | | | | | | | |
|---|---|---|---|---|---|---|---|---|---|
| | Phosphor | LOS + GBAM + SCA | | | | | | CASN + BSS | Yellow phosphor |
| | Backlight | BL-1 | BL-1 | BL-1 | BL-1 | BL-1 | BL-1 | BL-5 | BL-6 |
| | Color filter | Example II-1 | Example II-2 | Example II-3 | Example II-4 | Example II-5 | Example II-6 | Comparative Example II-1 | Comparative Example II-2 |
| | Image display | Example II-1 | Example II-2 | Example II-3 | Example II-4 | Example II-5 | Example II-6 | Comparative Example II-1 | Comparative Example II-2 |
| Red | x | 0.674 | 0.663 | 0.674 | 0.663 | 0.674 | 0.663 | 0.660 | 0.660 |
| | y | 0.317 | 0.320 | 0.317 | 0.320 | 0.317 | 0.320 | 0.319 | 0.330 |
| | Y | 26.6 | 27.3 | 26.6 | 27.3 | 26.6 | 27.3 | 23.700 | 14.30 |
| Green | x | 0.201 | 0.209 | 0.186 | 0.204 | 0.195 | 0.202 | 0.224 | 0.250 |
| | y | 0.704 | 0.696 | 0.709 | 0.692 | 0.710 | 0.701 | 0.650 | 0.650 |
| | Y | 45.5 | 50.5 | 41.2 | 49.3 | 49.6 | 54.0 | 44.6 | 30.20 |
| Blue | x | 0.158 | 0.156 | 0.158 | 0.156 | 0.158 | 0.156 | 0.143 | 0.140 |
| | y | 0.052 | 0.057 | 0.052 | 0.057 | 0.052 | 0.057 | 0.092 | 0.080 |
| | Y | 3.4 | 4.9 | 3.4 | 4.9 | 3.4 | 4.9 | 9.9 | 5.80 |
| White | x | 0.373 | 0.349 | 0.375 | 0.348 | 0.367 | 0.344 | 0.318 | 0.310 |
| | y | 0.353 | 0.339 | 0.343 | 0.336 | 0.363 | 0.347 | 0.312 | 0.310 |
| | Y | 25.2 | 27.6 | 23.7 | 27.2 | 26.5 | 28.7 | 26.1 | 16.8 |
| Color temperature (K) | | 4029 | 4791 | 3913 | 4806 | 4286 | 5006 | 6300 | 6824 |
| NTSC ratio (%) | | 103 | 98 | 105 | 98 | 104 | 99 | 85 | 85 |

The Y value of White in Table II-E indicates the utilization efficiency of light from the backlight for the entire color image display. As shown in Table II-E, the present invention technology achieves much higher Y value compared to significantly low ones of the conventional backlights, even when a color image display with such a high NTSC ratio (color reproduction range) of 85%, which exceeds the EBU standard (NTSC ratio of 72%), is designed. In other words, it is possible to obtain higher brightness even with low power consumption.

Moreover, the present invention technology can achieve an NTSC ratio which is even higher than the Adobe-RGB (NTSC ratio of 94%). The Adobe-RGB NTSC ratio could not be obtained in previous backlights because the film thickness of the color filter was then too large (larger than 10 μm) and thus plate-making capability could not be acquired. In addition, for Example II-3, when a coated film of the composition for each color filter, prepared in Production Examples II-10 to II-12 mentioned above, was exposed and developed at 100 $mJ/cm^2$ using a test pattern mask, a good pattern was observed to be formed in every sample. The film thickness after drying of the composition of every color filter, which was prepared in Example II-3, was 2.50 μm.

[II-6-2] Examples II-7 to II-12 and Comparative Examples II-1 and II-2

Color image displays of Examples II-7 to II-12 were produced by combining backlights (BL-2) described in Production Examples II-2 and the above color filters for Examples II-7 to II-12. On these color image displays, chromaticity (x,y,Y), NTSC ratio, and color temperature were measured, as is the case with Examples II-1 to II-6 mentioned above. The result is shown in Table II-F.

[Table 24]

| [Table II-F] | | | | | | | | | |
|---|---|---|---|---|---|---|---|---|---|
| | Phosphor | CASN + GBAM + SCA | | | | | | CASN + BSS | Yellow phosphor |
| | Backlight | BL-2 | BL-2 | BL-2 | BL-2 | BL-2 | BL-2 | BL-5 | BL-6 |
| | Color filter | Example II-7 | Example II-8 | Example II-9 | Example II-10 | Example II-11 | Example II-12 | Comparative Example II-1 | Comparative Example II-2 |
| | Image display | Example II-7 | Example II-8 | Example II-9 | Example II-10 | Example II-11 | Example II-12 | Comparative Example II-1 | Comparative Example II-2 |
| Red | x | 0.676 | 0.671 | 0.676 | 0.671 | 0.676 | 0.671 | 0.660 | 0.660 |
| | y | 0.318 | 0.319 | 0.318 | 0.319 | 0.318 | 0.319 | 0.319 | 0.330 |
| | Y | 25.2 | 26.0 | 25.2 | 26.0 | 25.2 | 26.0 | 23.7 | 14.30 |
| Green | x | 0.186 | 0.202 | 0.167 | 0.200 | 0.178 | 0.195 | 0.224 | 0.250 |
| | y | 0.707 | 0.696 | 0.726 | 0.693 | 0.718 | 0.694 | 0.650 | 0.650 |
| | Y | 48.4 | 50.9 | 44.5 | 49.1 | 53.0 | 54.8 | 44.6 | 30.20 |
| Blue | x | 0.159 | 0.158 | 0.159 | 0.158 | 0.159 | 0.158 | 0.143 | 0.140 |
| | y | 0.047 | 0.058 | 0.047 | 0.058 | 0.047 | 0.058 | 0.092 | 0.080 |
| | Y | 4.1 | 4.8 | 4.1 | 4.8 | 4.1 | 4.8 | 9.9 | 5.80 |
| White | x | 0.341 | 0.348 | 0.341 | 0.348 | 0.335 | 0.342 | 0.318 | 0.310 |
| | y | 0.331 | 0.344 | 0.324 | 0.340 | 0.342 | 0.352 | 0.312 | 0.310 |
| | Y | 25.9 | 27.2 | 24.6 | 26.6 | 27.4 | 28.5 | 26.1 | 16.8 |
| Color temperature (K) | | 5091 | 4870 | 5082 | 4820 | 5370 | 5117 | 6300 | 6824 |
| NTSC ratio (%) | | 106 | 100 | 110 | 100 | 108 | 100 | 85 | 85 |

It is evident from Table II-F that, also in Examples II-7 to II-12, a higher light utilization efficiency could be achieved than in the past even with a high NTSC ratio as is the case with Examples II-1 to II-6. The film thickness after drying of the composition of every color filter, which was prepared in Example II-9, was 2.50 μm. A good pattern was observed to be formed as is the case with Example II-3.

Industrial Applicability

The present invention can be used in various fields utilizing light. It can be preferably used for image displays of various electronic equipments such as cellular phones, domestic electric appliances and outdoor displays, as well as for indoor and outdoor lighting systems, for example.

The present invention has been explained in detail above with reference to specific embodiments. However, it is evident to those skilled in the art that various modifications can be added thereto without departing from the intention and the scope of the present invention.

The present application is based on Japanese Patent Application (Patent Application No. 2007-173319) filed on June 29, 2007 and Japanese Patent Application (Patent Application No. 2007-209521) filed on August 10, 2007, and their entireties are incorporated herewith by reference.

## Claims

**1.** A phosphor
of which chemical composition is represented by the formula (1) below, and
external quantum efficiency when excited with light of 400 nm wavelength is 77% or higher.

$$(Sr_{10-x-y-z}M_xEu_yMn_z)(PO_4)_6(Cl_{1-a}Q_a)_2 \qquad (1)$$

(In the above formula (1),
"M" represents at least one kind of element selected from the group consisting of Ba, Ca, Mg, and Zn,
"Q" represents at least one kind of element selected from the group consisting of F, Br, and I, and
each of "x", "y", "z", and "a" represents a number satisfying the following requirements:

$0 \leq x < 10$,
$0.3 \leq y \leq 1.5$,
$0 \leq z \leq 3$,
$0 \leq a \leq 1$, and
$x+y+z \leq 10$.)

**2.** A phosphor according to claim 1, wherein
the weight median diameter $D_{50}$ is 7.5 μm or larger and 20 μm or smaller.

**3.** A phosphor according to claim 1 or claim 2,
wherein
the excitation spectrum at 25°C satisfies the formula (2) below.

$$0.8 \leq I_{ex}(400)/I_{ex}(350) \qquad (2)$$

(In the above formula (2),
$I_{ex}(400)$ represents the intensity of excitation peak at a wavelength of 400 nm, and
$I_{ex}(350)$ represents the intensity of excitation peak at a wavelength of 350 nm.)

**4.** A phosphor according to any one of claims 1 to 3, wherein
the absorption efficiency of the excitation light is 80% or higher.

**5.** A phosphor according to any one of claims 1 to 4, wherein
the standard deviation (quantile deviation) of the weight median diameter $D_{50}$ takes a value of 0.26 or smaller.

**6.** A phosphor according to any one of claims 1 to 5, wherein said phosphor satisfies the formula (3) below.

$$0.65 \leq I(125)/I(25) \quad (3)$$

(In the above formula (3),
I(25) represents the emission-peak intensity of said phosphor when excited with light of 400 nm wavelength at 25°C, and
I(125) represents the emission-peak intensity of said phosphor when excited with light of 400 nm wavelength at 125°C.)

**7.** A phosphor according to any one of claims 1 to 6, wherein said phosphor contains at least Sr in the above-mentioned formula (1).

**8.** A production method of a phosphor represented by the formula (1) below, comprising a plurality of firing steps and carrying out the second or subsequent firing step in the presence of a flux.

$$(Sr_{10-x-y-z}m_xEu_yMn_z)(PO_4)_6(Cl_{1-a}Q_a)_2 \quad (1)$$

(In the above formula (1),
"M" represents at least one kind of element selected from the group consisting of Ba, Ca, Mg, and Zn,
"Q" represents at least one kind of element selected from the group consisting of F, Br, and I, and
each of "x", "y", "z", and "a" represents a number satisfying the following requirements:

$0 \leq x < 10$,
$0.3 \leq y \leq 1.5$,
$0 \leq z \leq 3$,
$0 \leq a \leq 1$, and
$x+y+z \leq 10$.)

**9.** A production method of a phosphor, according to claim 8, comprising a step in which a firing is performed in the presence of a flux after nucleation of phosphor crystals.

**10.** A phosphor-containing composition comprising: said phosphor according to any one of claims 1 to 7 and a liquid medium.

**11.** A light emitting device comprising: a first luminous body and a second luminous body that emits visible light when irradiated with light from said first luminous body, wherein said light emitting device comprises, as said second luminous body, a first phosphor including at least one kind of said phosphor according to any one of claims 1 to 7.

**12.** A light emitting device according to claim 11, wherein said light emitting device comprises, as said second luminous body, a second phosphor including at least one kind of a phosphor of which emission-peak wavelength is different from that of said first phosphor.

**13.** A light emitting device according to claim 12, wherein said first luminous body has an emission peak in the wavelength range of from 300 nm to 420 nm, and said second luminous body comprises, as said second phosphor, at least one kind of a phosphor having an emission peak in the wavelength range of from 500 nm to 570 nm and at least one kind of a phosphor having an emission peak in the wavelength range of from 570 nm to 700 nm.

**14.** An illuminating device comprising a light emitting device according to any one of claims 11 to 13.

**15.** A display comprising a light emitting device according to any one of claims 11 to 13.

**16.** A color image display according to claim 15, constituted by combining an optical shutter, a color filter corresponding to said optical shutter and comprising at least trichromatic components of red, green, and blue, and a backlight for transillumination, wherein
a light source used for said backlight comprises a semiconductor light emitting device in which phosphor is combined with solid luminous element that emits light of ultraviolet to near-ultraviolet region, and
the relationship between NTSC ratio W, which is a ratio of color reproduction range of color image display elements, and light utilization efficiency Y is represented by the formula below.
$Y \geq -0.24W+49$ (where, $W \geq 87$)

[Mathematical Formula 1]

$$X = \frac{\int_{380}^{780} \bar{x}(\lambda)S(\lambda)T(\lambda)d\lambda}{\int_{380}^{780} \bar{y}(\lambda)S(\lambda)d\lambda} \qquad x = \frac{X}{X+Y+Z}$$

$$Y = \frac{\int_{380}^{780} \bar{y}(\lambda)S(\lambda)T(\lambda)d\lambda}{\int_{380}^{780} \bar{y}(\lambda)S(\lambda)d\lambda} \qquad y = \frac{Y}{X+Y+Z}$$

$$Z = \frac{\int_{380}^{780} \bar{z}(\lambda)S(\lambda)T(\lambda)d\lambda}{\int_{380}^{780} \bar{y}(\lambda)S(\lambda)d\lambda}$$

where, the symbols in the above formula are defined as follows.

[Mathematical Formula 2]

$\bar{x}(\lambda), \bar{y}(\lambda), \bar{z}(\lambda)$ : Color-matching function in a XYZ colorimetric-system

$S(\lambda)$ : Relative emission distribution spectrum of a backlight

$T(\lambda)$ : Transmittance of a color filter

FIG. 1

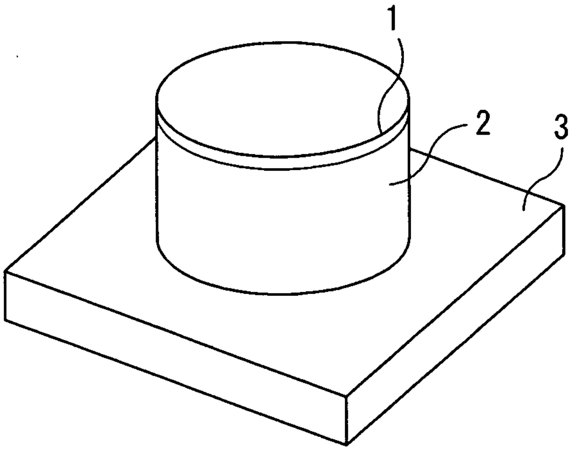


FIG. 2(a)

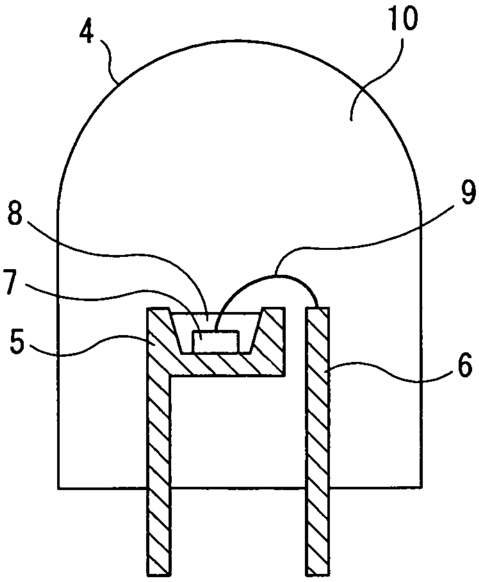


FIG. 2(b)

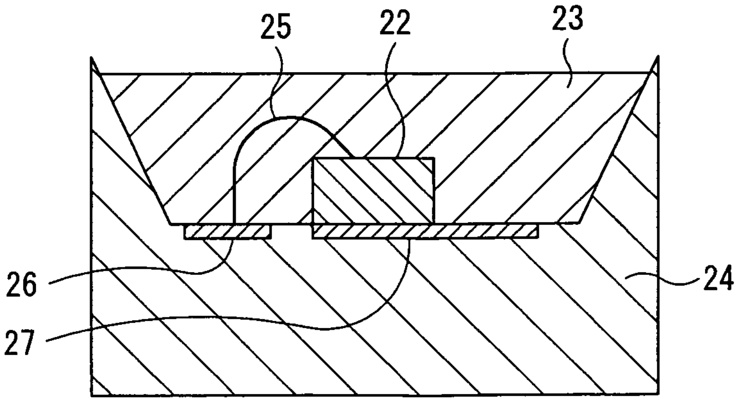

FIG. 3

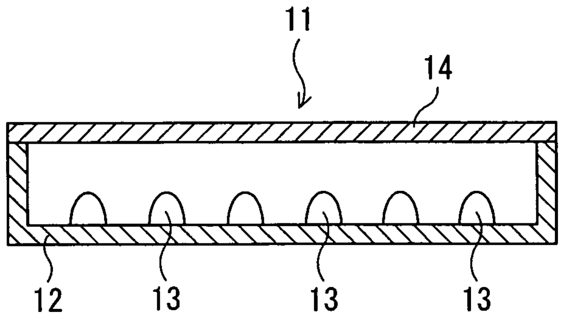
11
14
12
13
13
13

FIG. 4

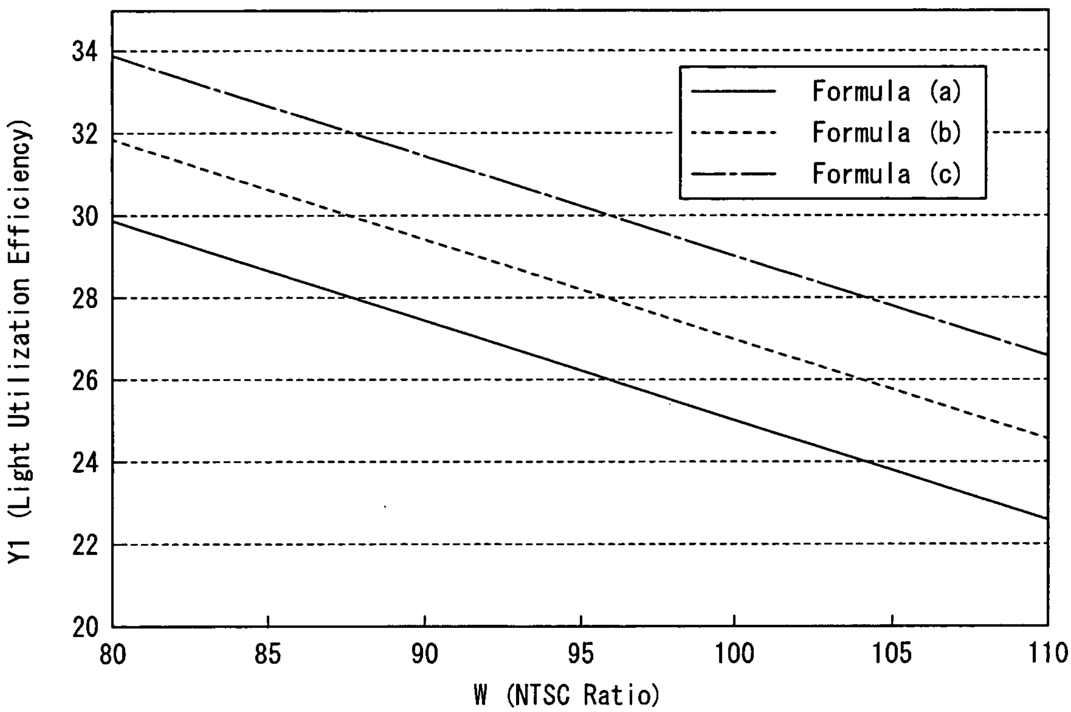
Y1 (Light Utilization Efficiency)
34
32
30
28
26
24
22
20
80
85
90
95
100
105
110
W (NTSC Ratio)
Formula (a)
Formula (b)
Formula (c)

FIG. 5

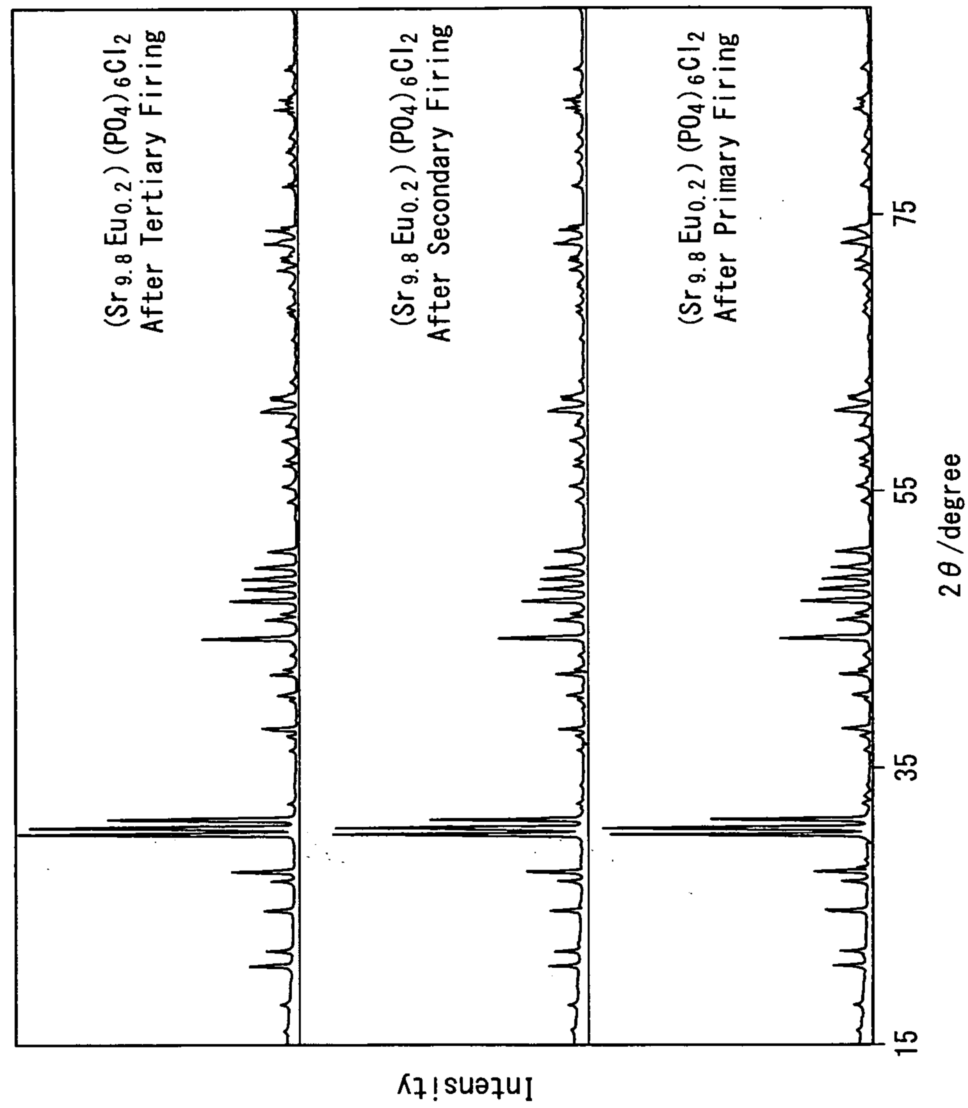
(Sr9.8 Eu0.2)(PO4)6Cl2
After Tertiary Firing
(Sr9.8 Eu0.2)(PO4)6Cl2
After Secondary Firing
(Sr9.8 Eu0.2)(PO4)6Cl2
After Primary Firing
Intensity
15
35
55
75
2θ/degree

FIG. 6

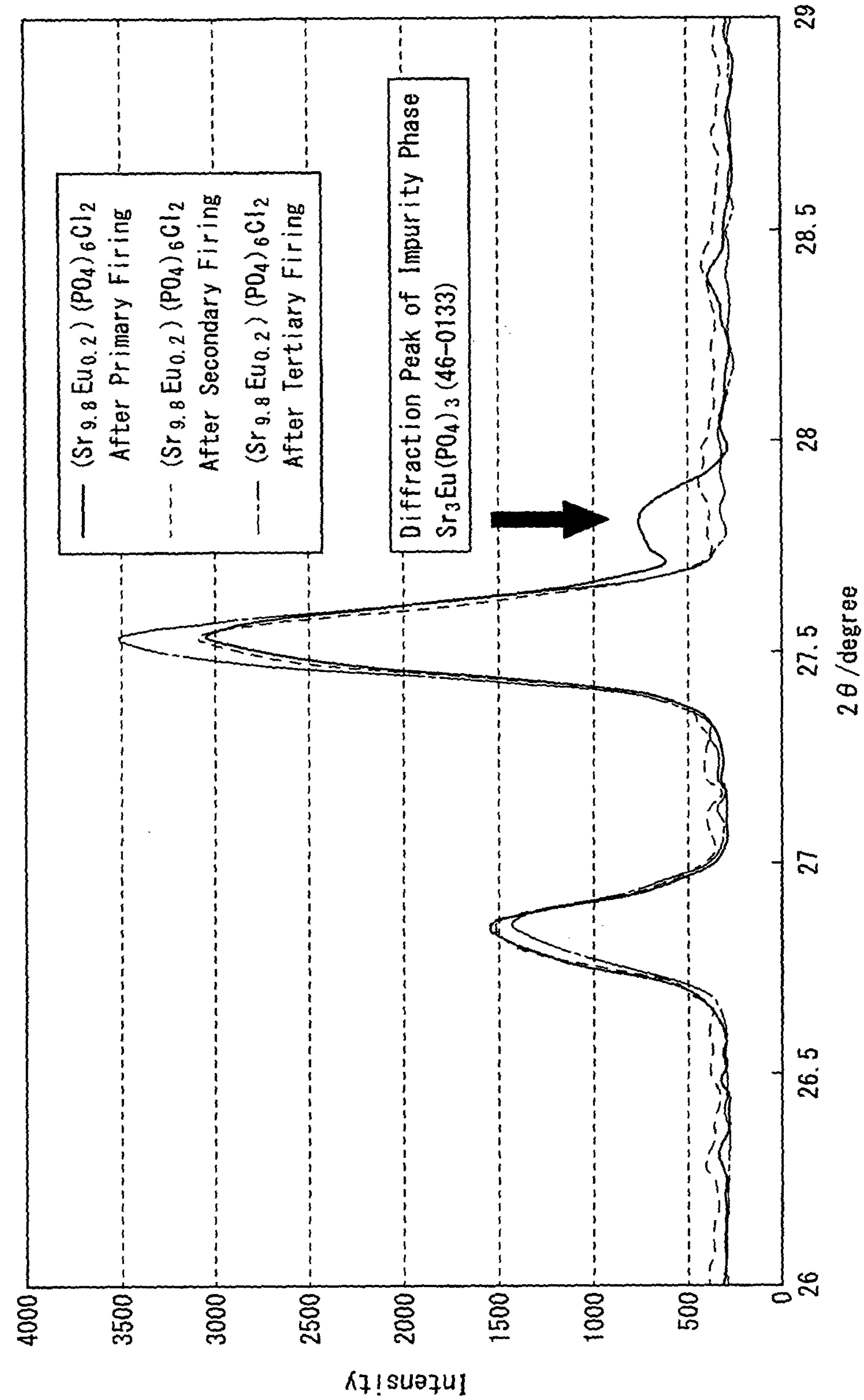

Intensity
4000
3500
3000
2500
2000
1500
1000
500
0
26
26.5
27
27.5
28
28.5
29
2θ/degree
(Sr9.8Eu0.2)(PO4)6Cl2 After Primary Firing
(Sr9.8Eu0.2)(PO4)6Cl2 After Secondary Firing
(Sr9.8Eu0.2)(PO4)6Cl2 After Tertiary Firing
Diffraction Peak of Impurity Phase
Sr3Eu(PO4)3 (46-0133)

FIG. 7

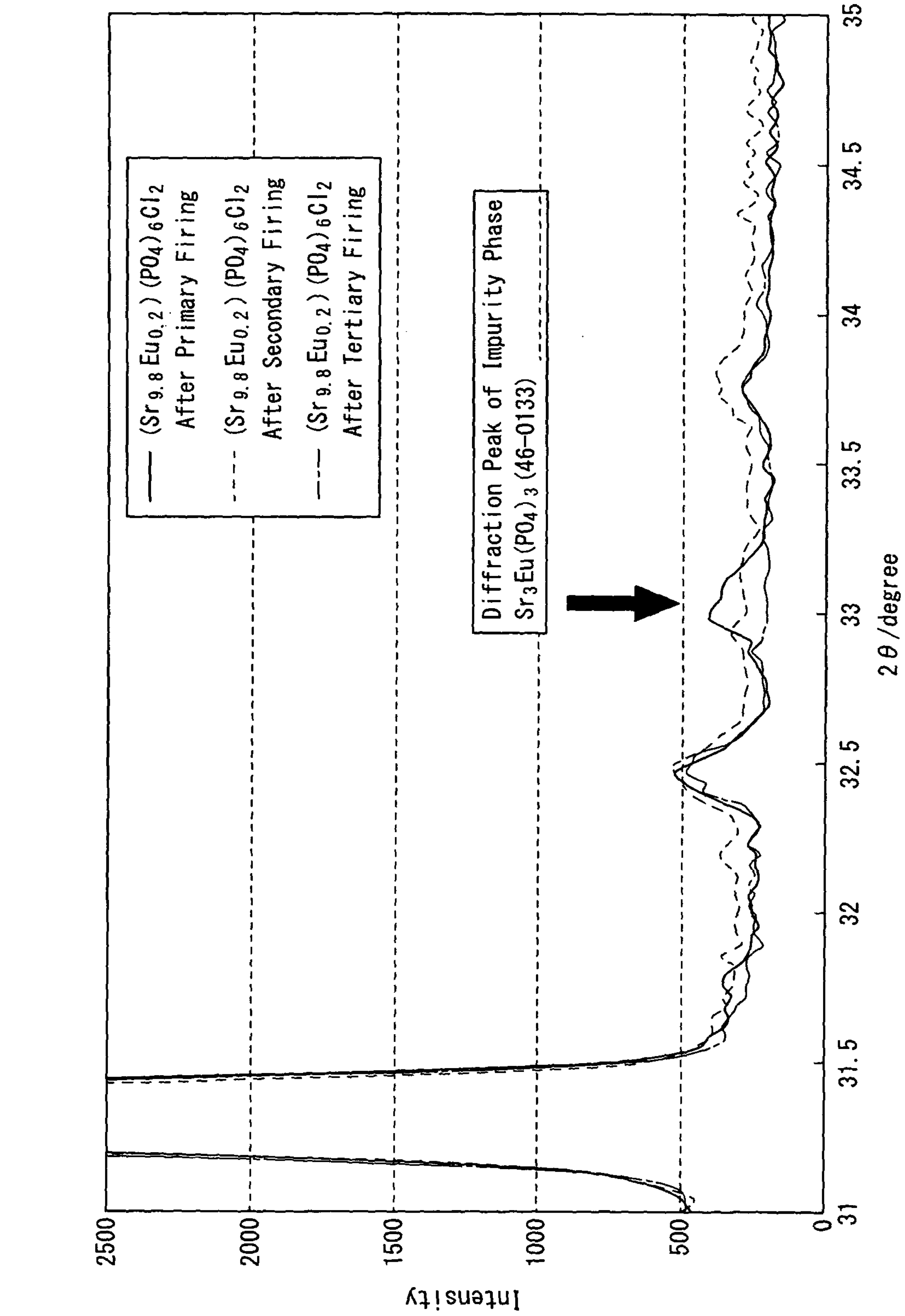
(Sr9.8Eu0.2)(PO4)6Cl2 After Primary Firing
(Sr9.8Eu0.2)(PO4)6Cl2 After Secondary Firing
(Sr9.8Eu0.2)(PO4)6Cl2 After Tertiary Firing
Diffraction Peak of Impurity Phase
Sr3Eu(PO4)3 (46-0133)
Intensity
0
500
1000
1500
2000
2500
31
31.5
32
32.5
33
33.5
34
34.5
35
2θ/degree

FIG. 8

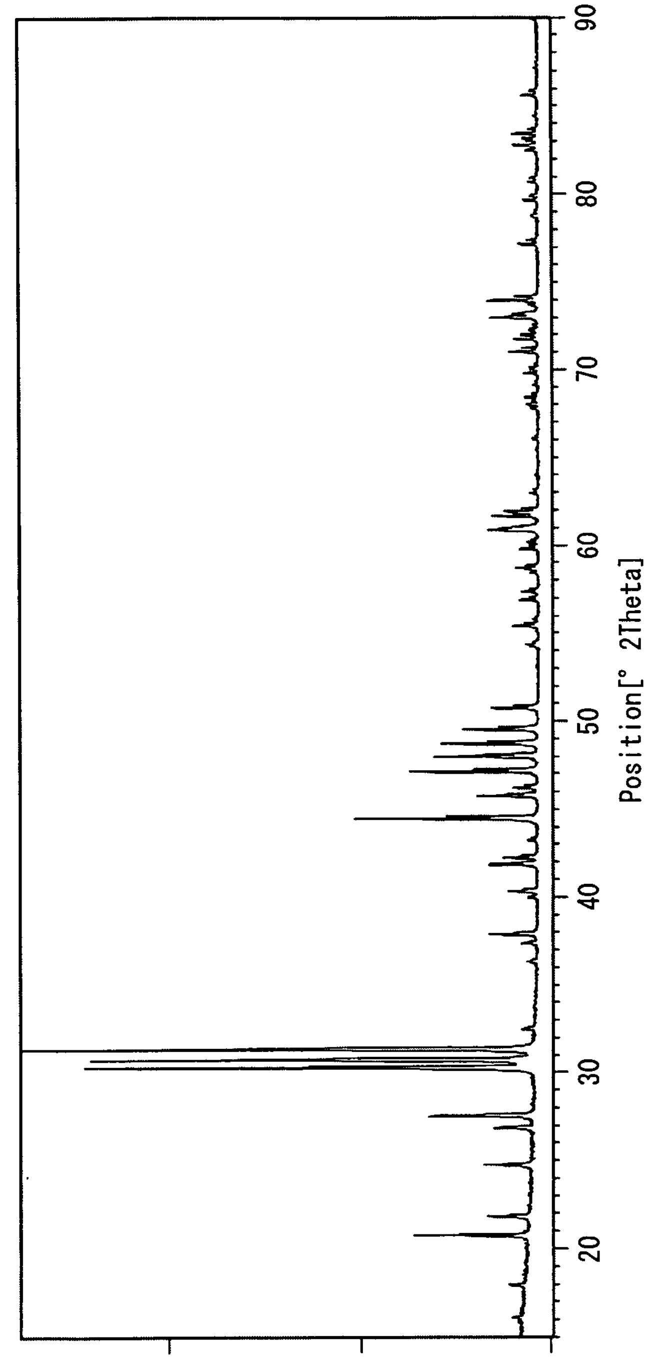

FIG. 9

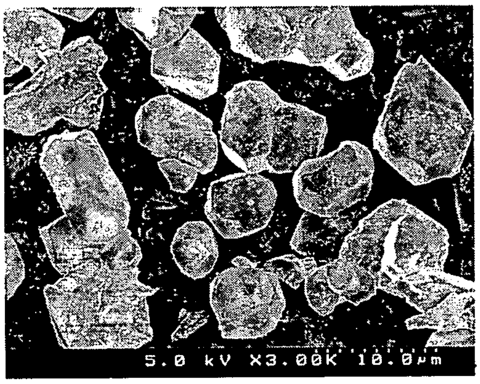


FIG. 10

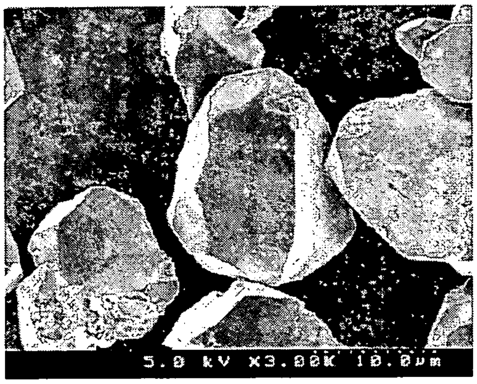


FIG. 11

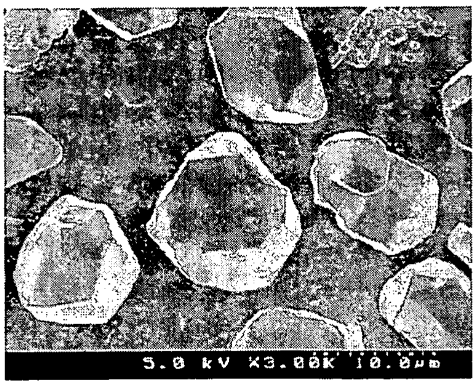

FIG. 12

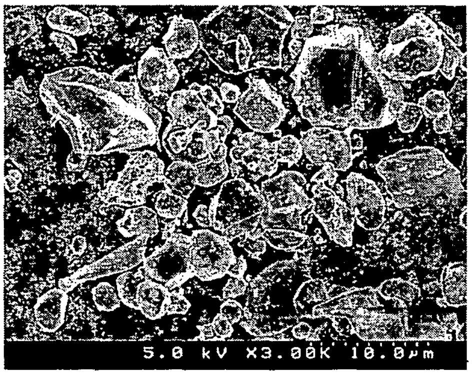


FIG. 13

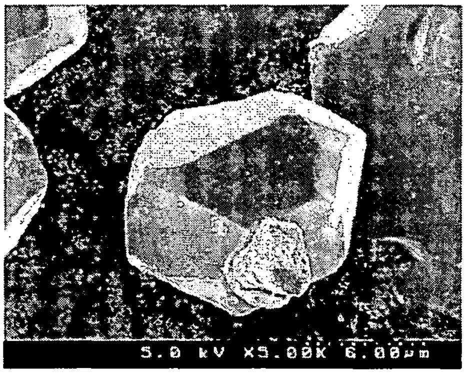


FIG. 14

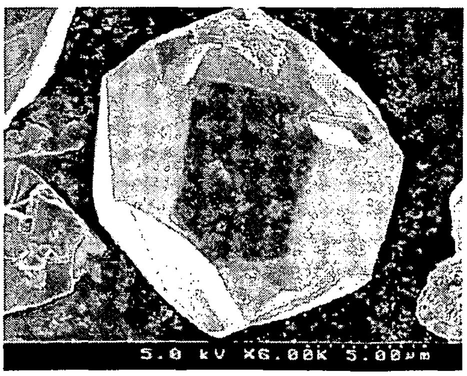

FIG. 15

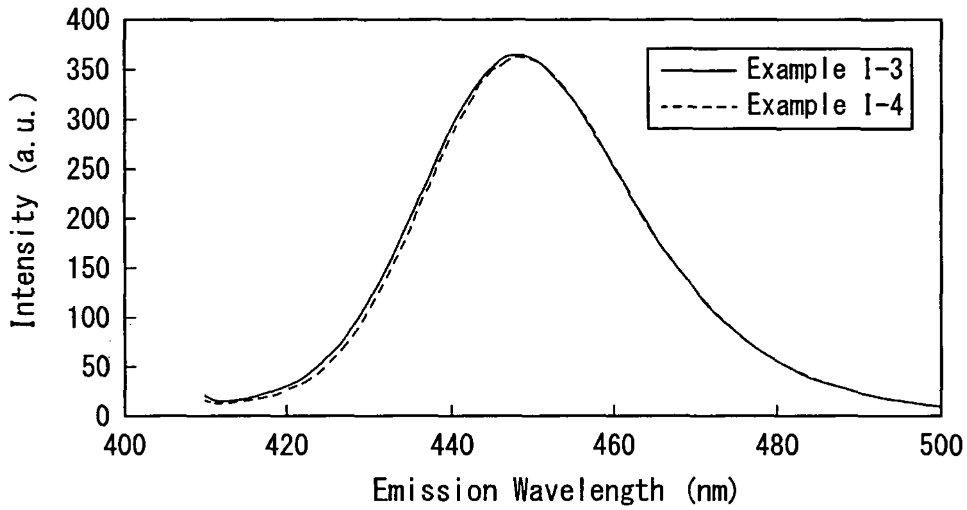
400
350
300
250
200
150
100
50
0
Intensity (a.u.)
400
420
440
460
480
500
Emission Wavelength (nm)
Example I-3
Example I-4

FIG. 16

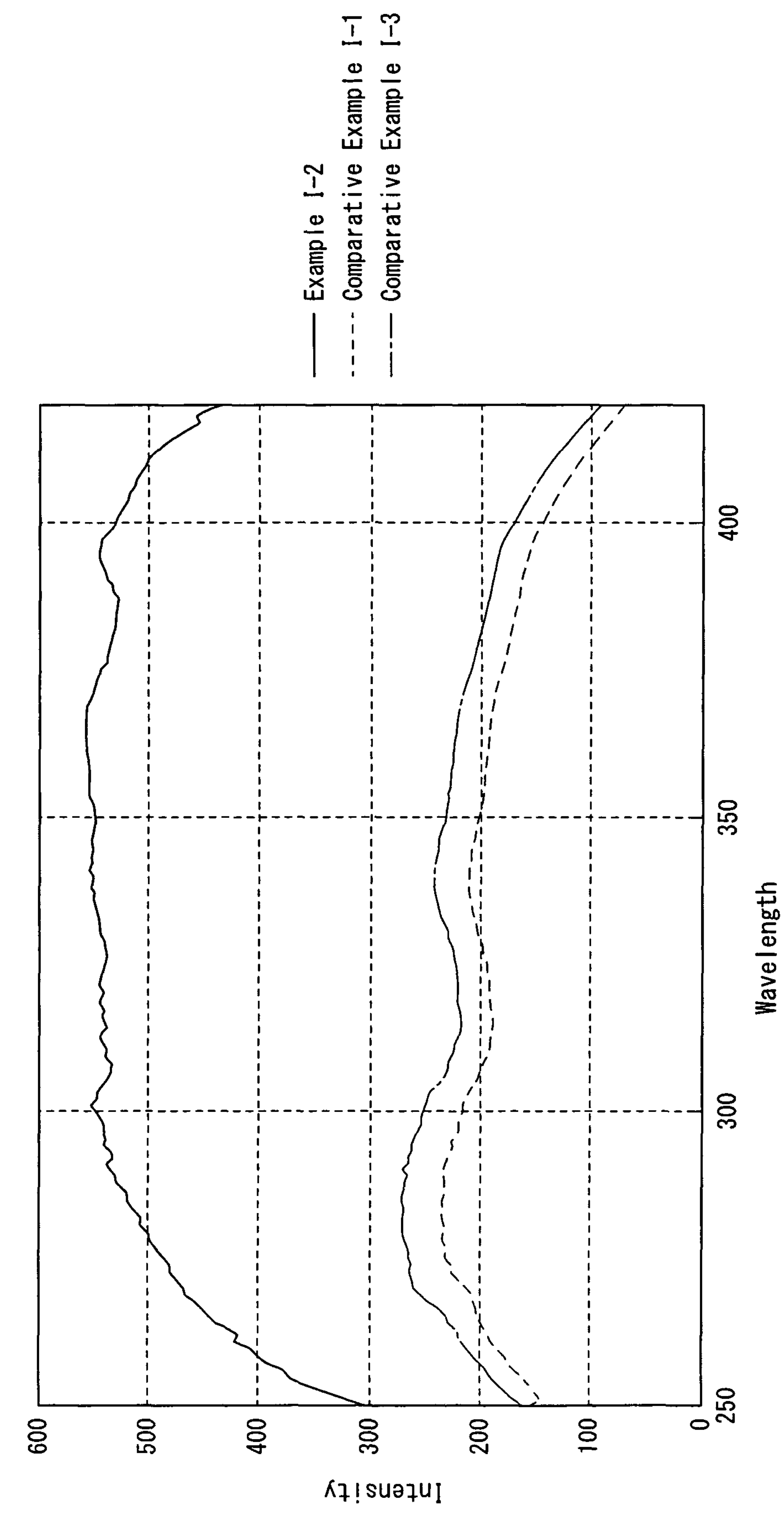
Example I-2
Comparative Example I-1
Comparative Example I-3
Intensity
Wavelength
600
500
400
300
200
100
0
250
300
350
400

FIG. 17

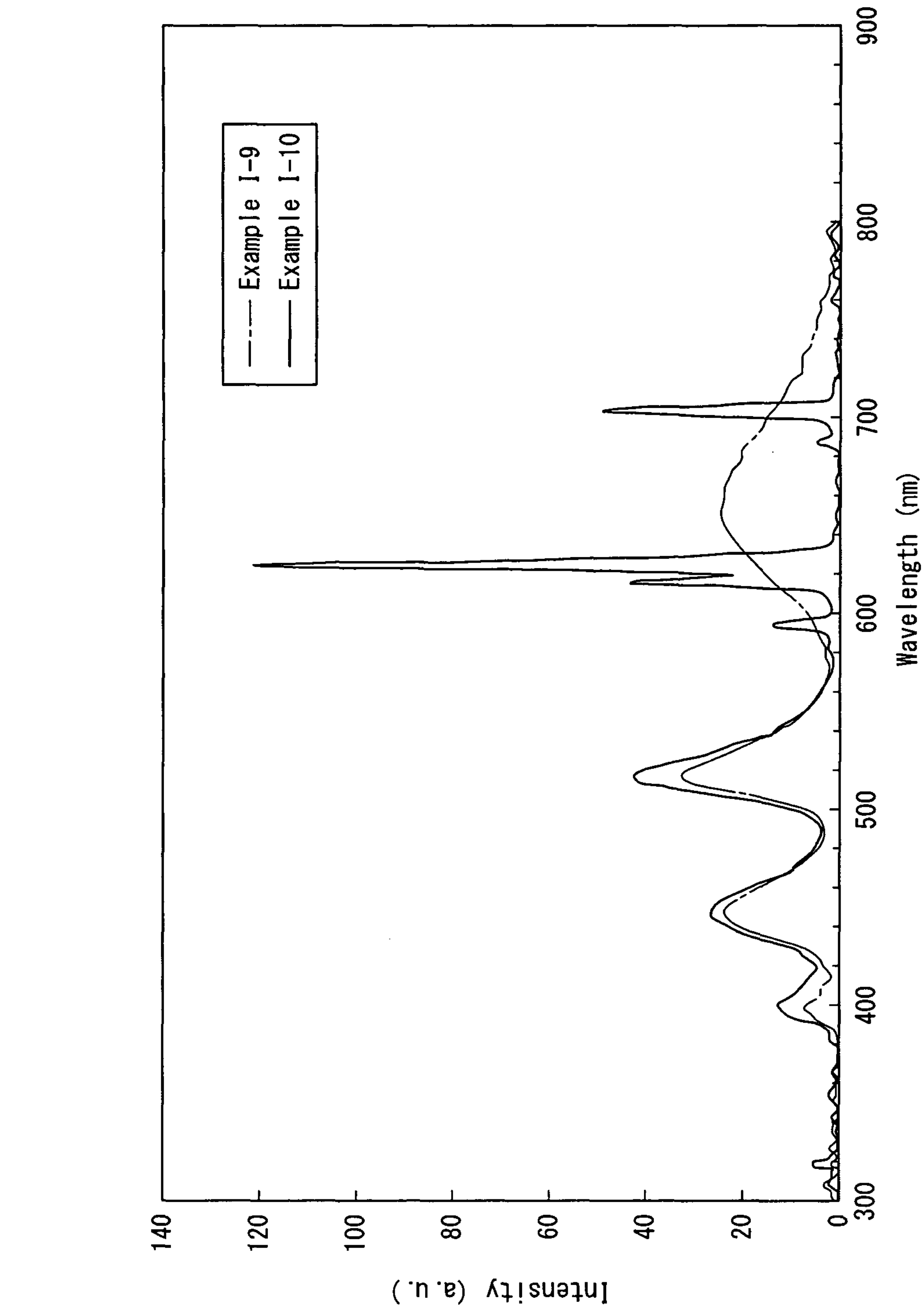
Intensity (a.u.)
140
120
100
80
60
40
20
0
300
400
500
600
700
800
900
Wavelength (nm)
Example I-9
Example I-10

FIG. 18

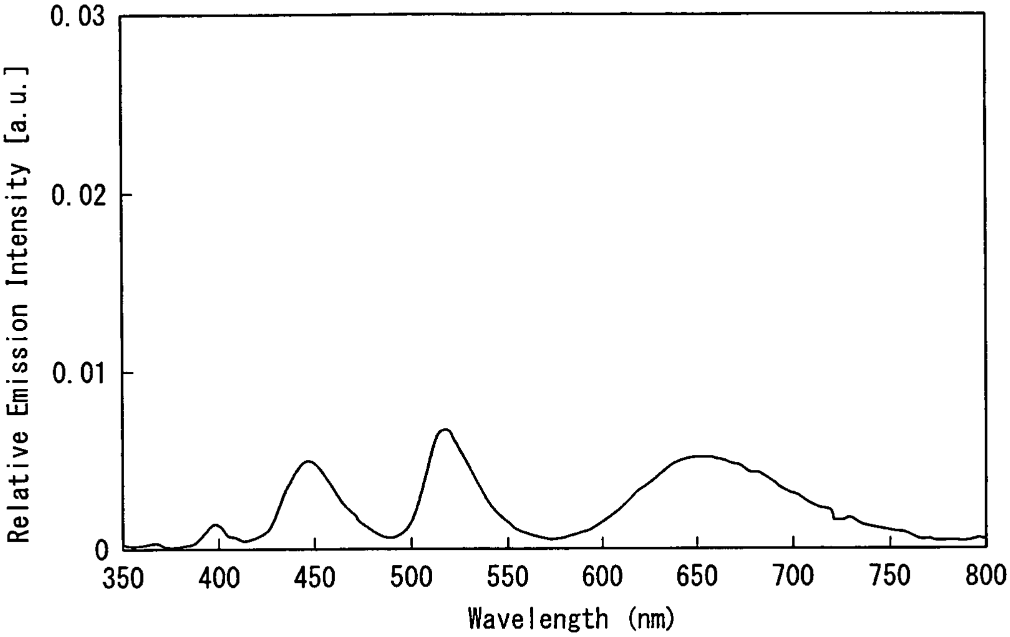
0.03
0.02
0.01
0
Relative Emission Intensity [a.u.]
350
400
450
500
550
600
650
700
750
800
Wavelength (nm)

FIG. 19

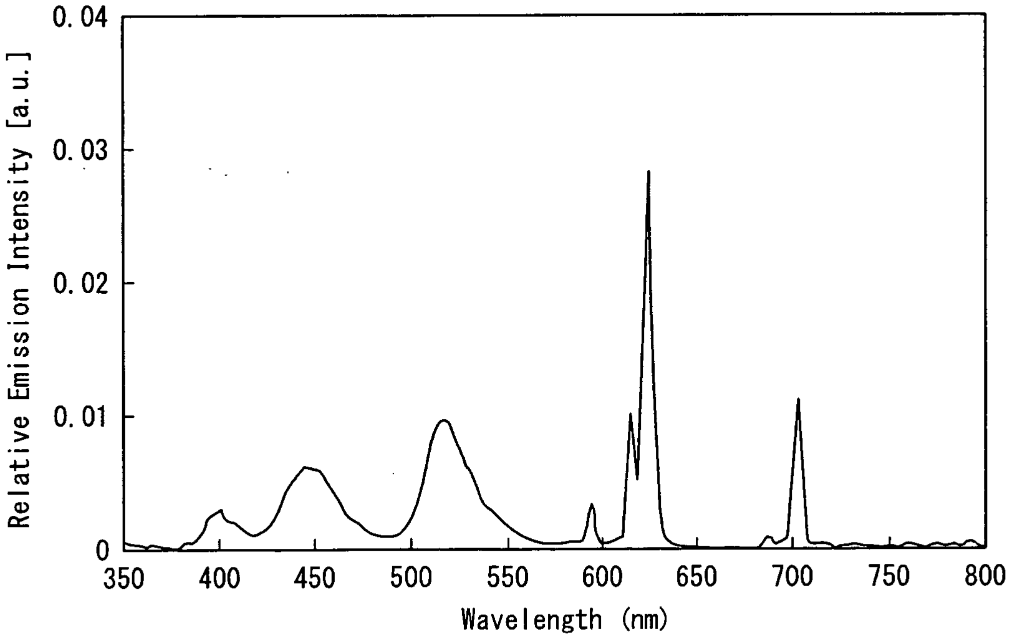
0.04
0.03
0.02
0.01
0
Relative Emission Intensity [a.u.]
350
400
450
500
550
600
650
700
750
800
Wavelength (nm)

FIG. 20

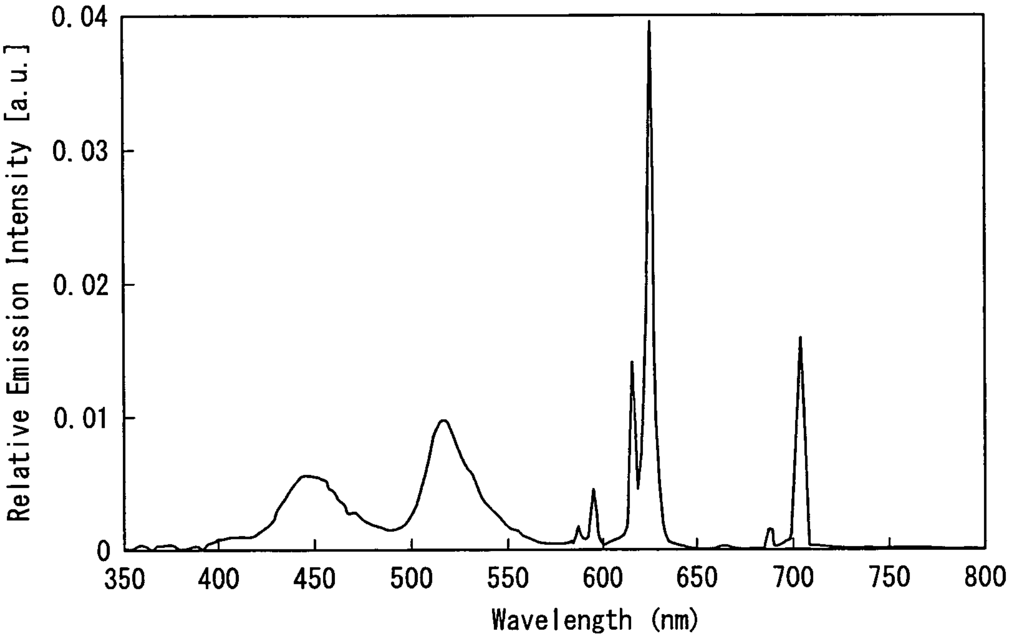
0.04
0.03
0.02
0.01
0
Relative Emission Intensity [a.u.]
350
400
450
500
550
600
650
700
750
800
Wavelength (nm)

FIG. 21

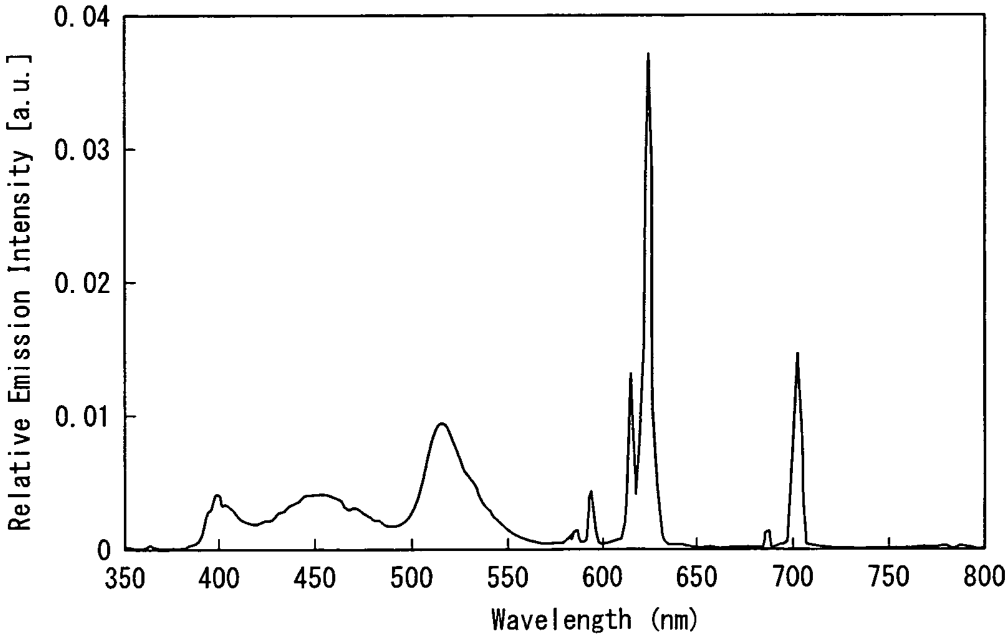
0.04
0.03
0.02
0.01
0
Relative Emission Intensity [a.u.]
350
400
450
500
550
600
650
700
750
800
Wavelength (nm)

FIG. 22

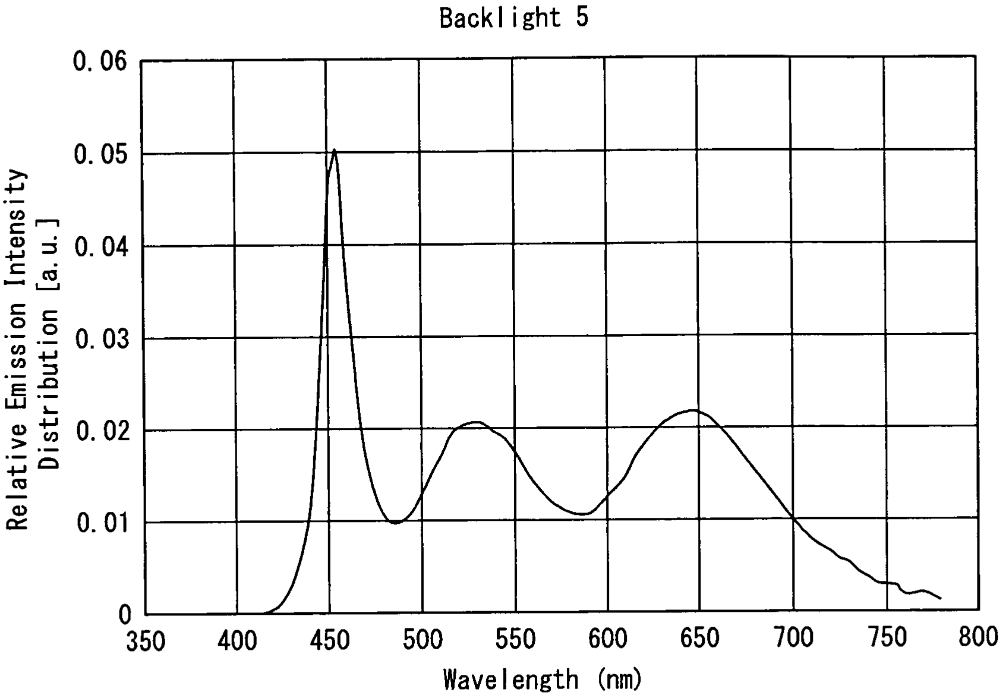
Backlight 5
0.06
0.05
0.04
0.03
0.02
0.01
0
Relative Emission Intensity Distribution [a.u.]
350
400
450
500
550
600
650
700
750
800
Wavelength (nm)

FIG. 23

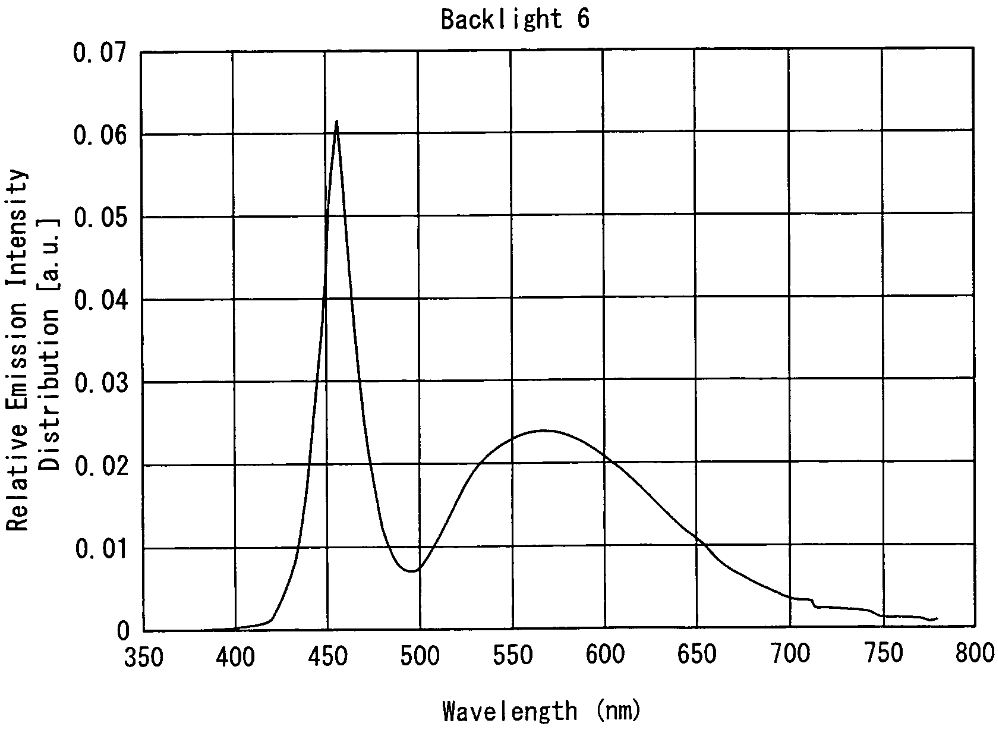
Backlight 6
0.07
0.06
0.05
0.04
0.03
0.02
0.01
0
Relative Emission Intensity Distribution [a.u.]
350
400
450
500
550
600
650
700
750
800
Wavelength (nm)

FIG. 24

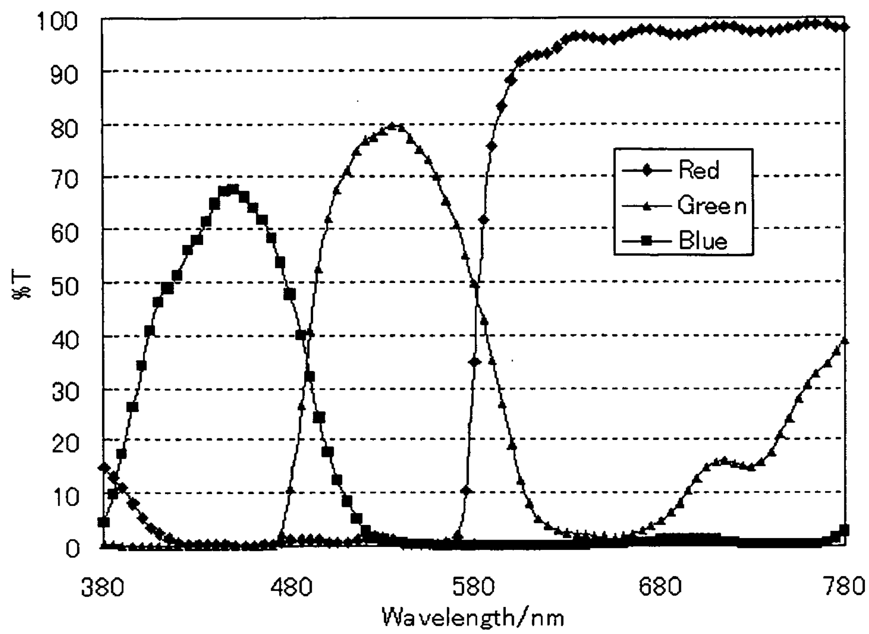
100
90
80
70
60
50
40
30
20
10
0
%T
380
480
580
680
780
Wavelength/nm
Red
Green
Blue

FIG. 25

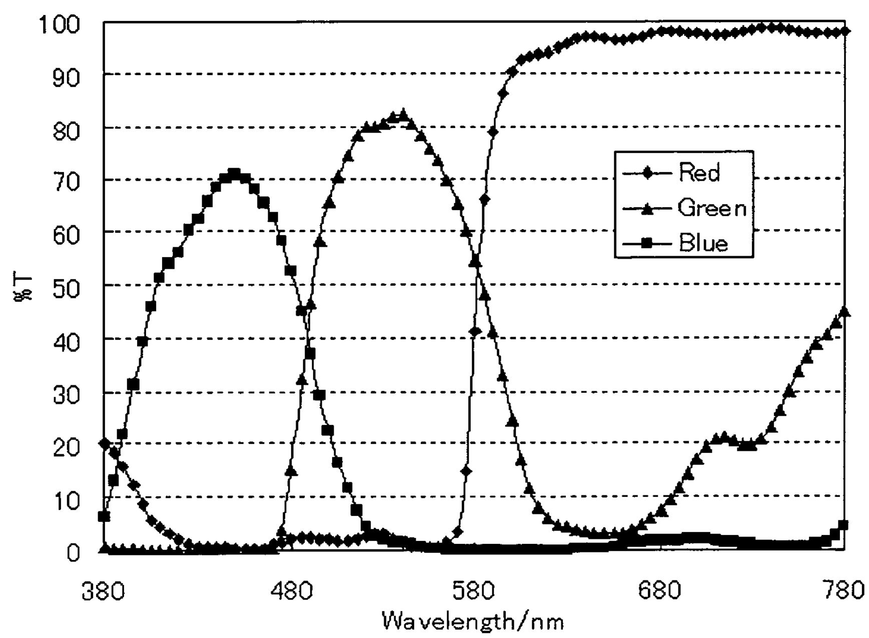
100
90
80
70
60
50
40
30
20
10
0
%T
380
480
580
680
780
Wavelength/nm
Red
Green
Blue

FIG. 26

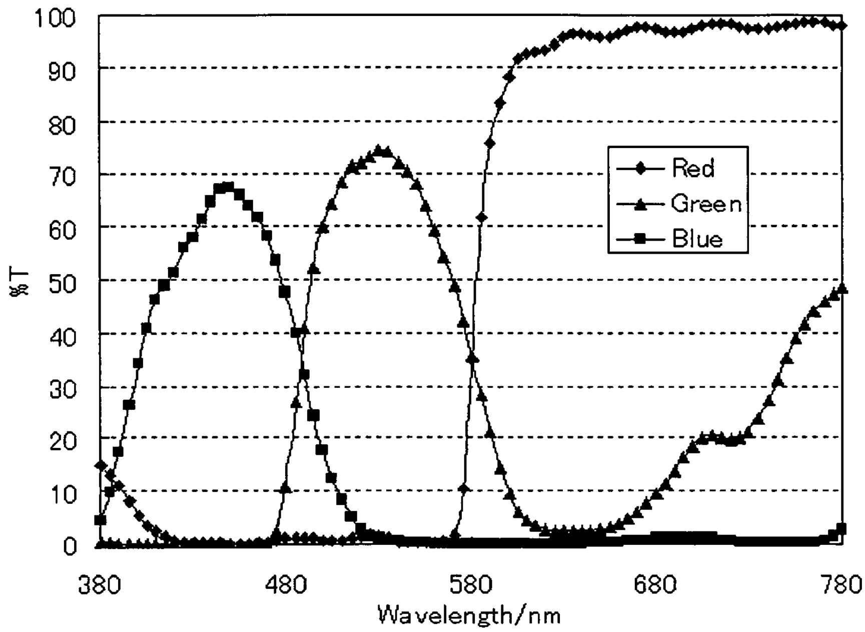
100
90
80
70
60
50
40
30
20
10
0
%T
380
480
580
680
780
Wavelength/nm
Red
Green
Blue

FIG. 27

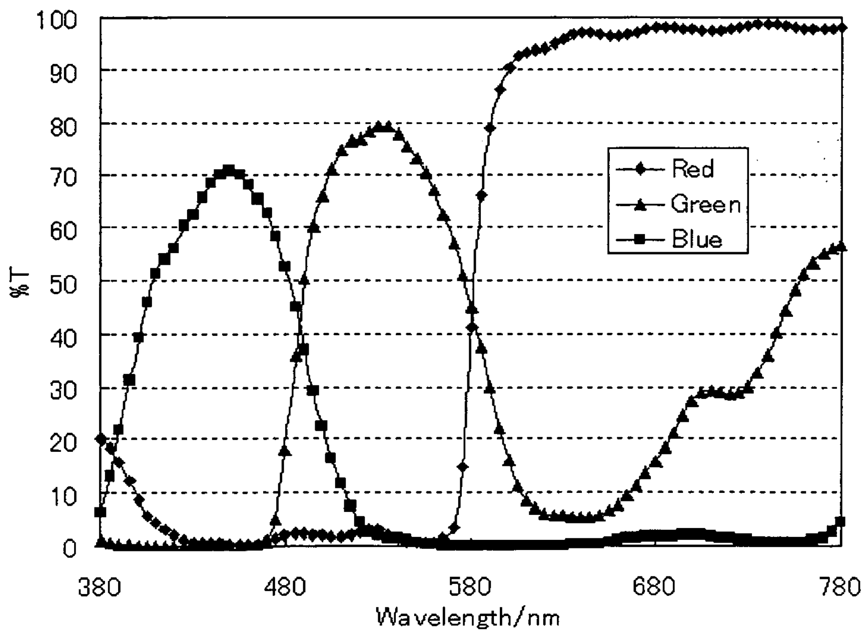
100
90
80
70
60
50
40
30
20
10
0
%T
380
480
580
680
780
Wavelength/nm
Red
Green
Blue

FIG. 28

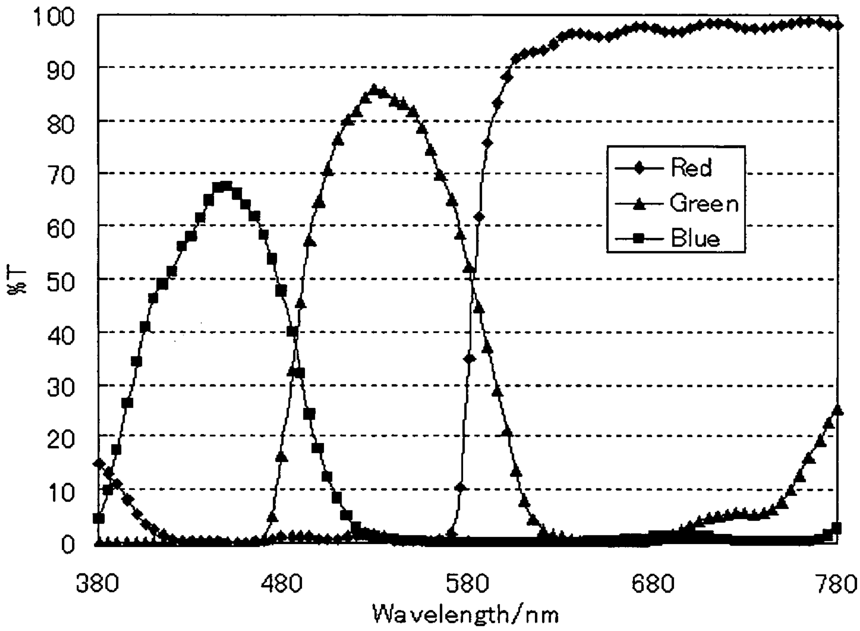
100
90
80
70
60
50
40
30
20
10
0
%T
380
480
580
680
780
Wavelength/nm
Red
Green
Blue

FIG. 29

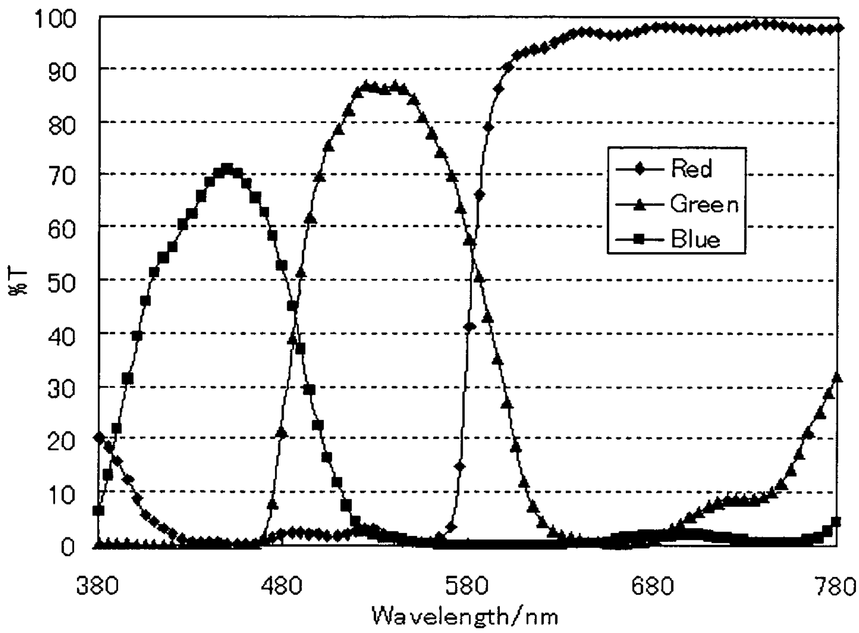
100
90
80
70
60
50
40
30
20
10
0
%T
380
480
580
680
780
Wavelength/nm
Red
Green
Blue

FIG. 30

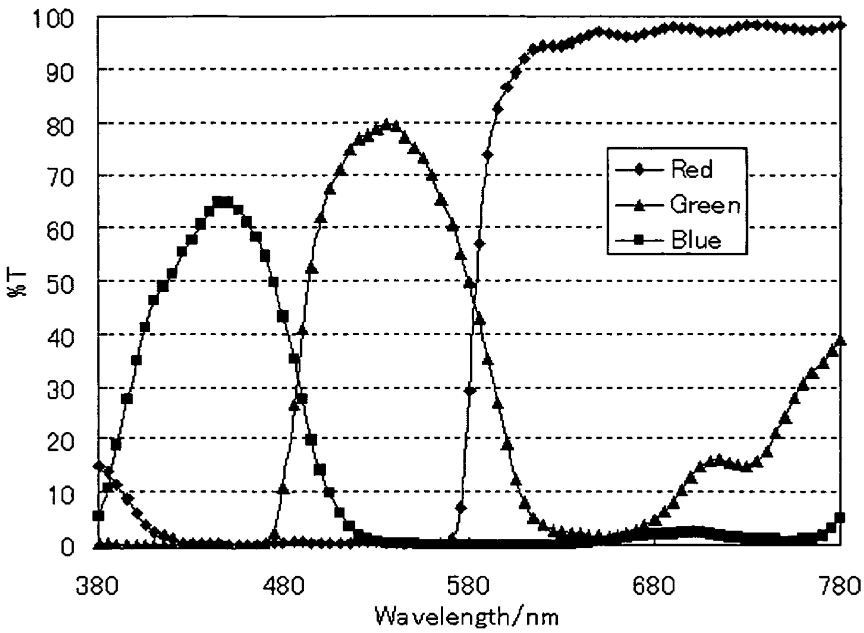
100
90
80
70
60
50
40
30
20
10
0
%T
380
480
580
680
780
Wavelength/nm
Red
Green
Blue

FIG. 31

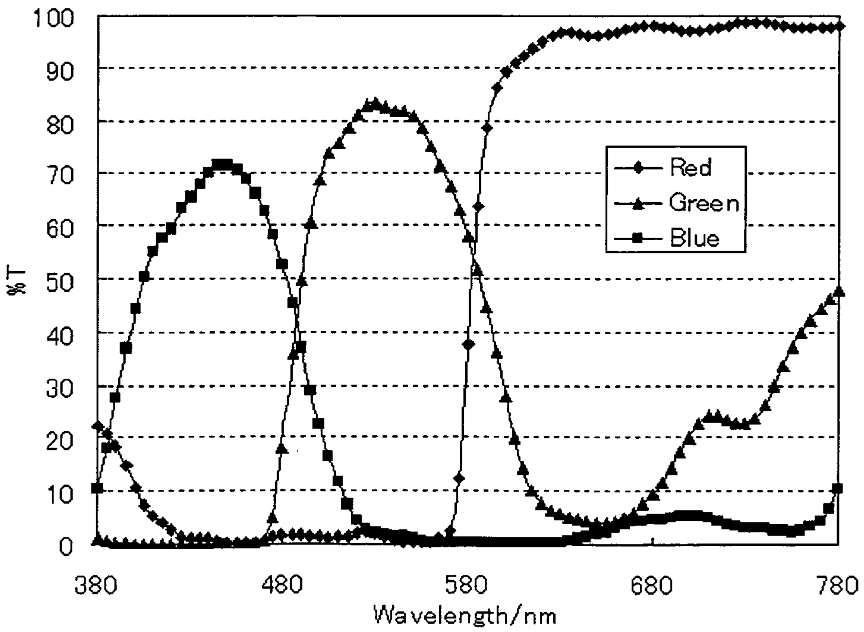
100
90
80
70
60
50
40
30
20
10
0
%T
380
480
580
680
780
Wavelength/nm
Red
Green
Blue

FIG. 32

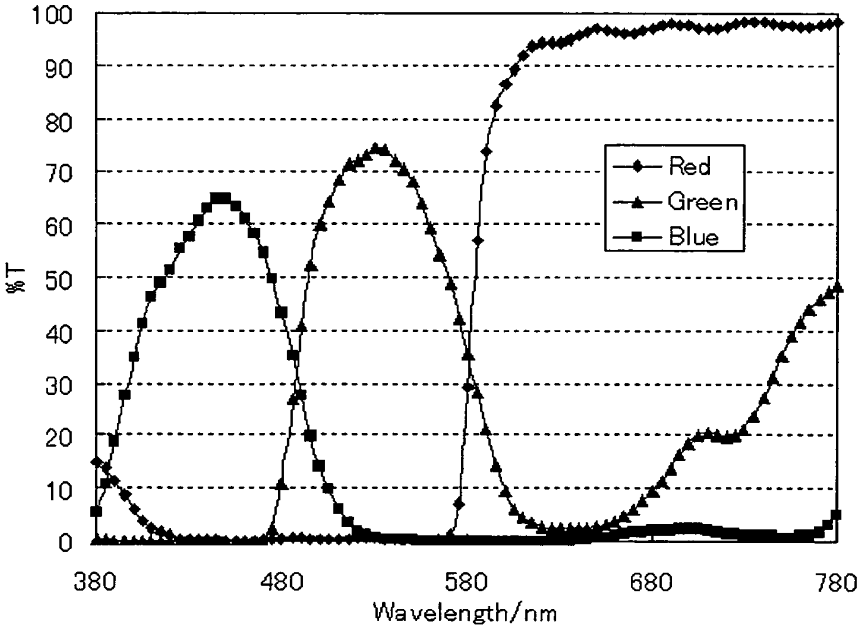
100
90
80
70
60
50
40
30
20
10
0
%T
380
480
580
680
780
Wavelength/nm
Red
Green
Blue

FIG. 33

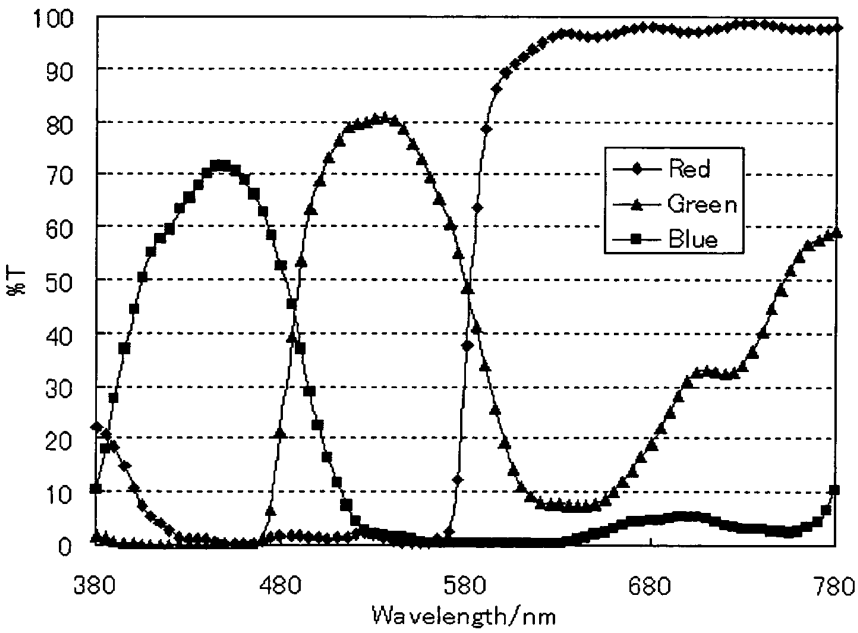
100
90
80
70
60
50
40
30
20
10
0
%T
380
480
580
680
780
Wavelength/nm
Red
Green
Blue

FIG. 34

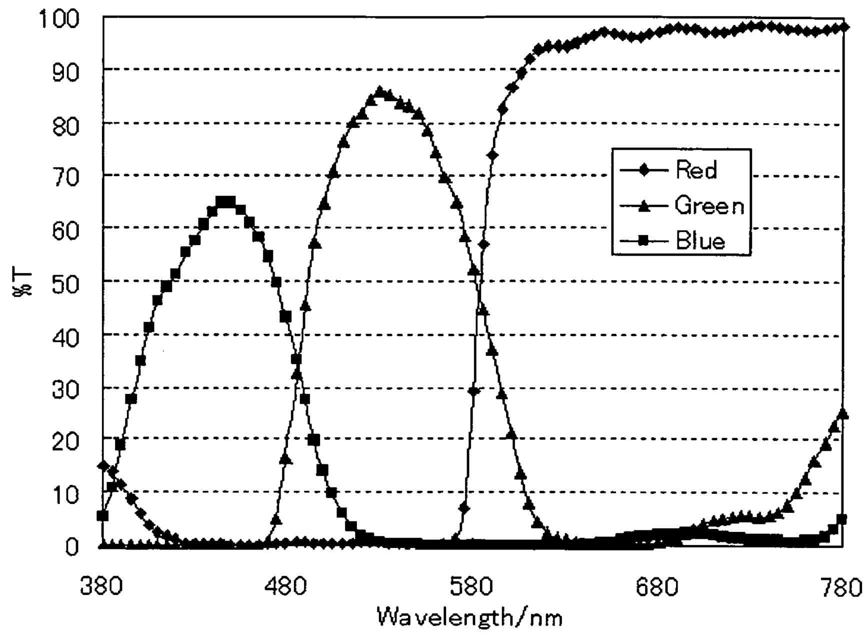
100
90
80
70
60
50
40
30
20
10
0
%T
380
480
580
680
780
Wavelength/nm
Red
Green
Blue

FIG. 35

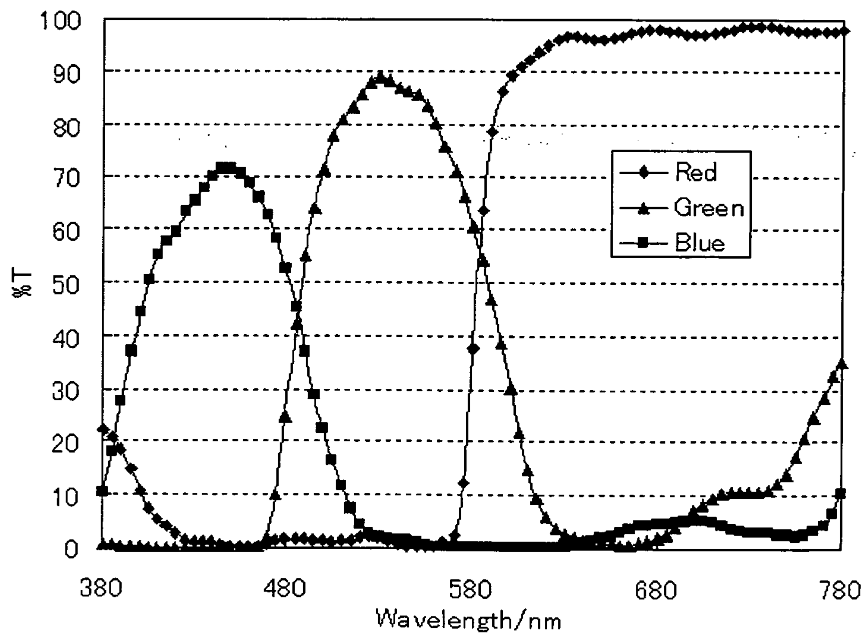
100
90
80
70
60
50
40
30
20
10
0
%T
380
480
580
680
780
Wavelength/nm
Red
Green
Blue

FIG. 36

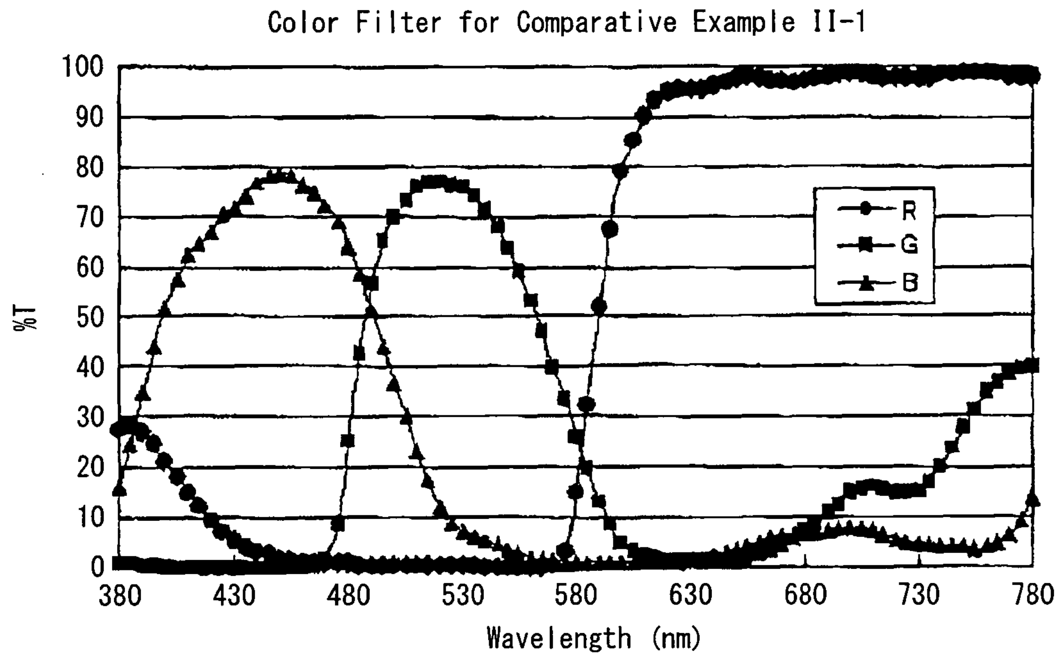
Color Filter for Comparative Example II-1
100
90
80
70
60
50
40
30
20
10
0
%T
380
430
480
530
580
630
680
730
780
Wavelength (nm)
R
G
B

**INTERNATIONAL SEARCH REPORT**

International application No.
PCT/JP2008/061839

A. CLASSIFICATION OF SUBJECT MATTER
*C09K11/73*(2006.01)i, *C09K11/08*(2006.01)i, *H01L33/00*(2006.01)i

According to International Patent Classification (IPC) or to both national classification and IPC

B. FIELDS SEARCHED

Minimum documentation searched (classification system followed by classification symbols)
C09K11/00-11/89, H01L33/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)
CAplus(STN)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2006-233183 A (Koito Manufacturing Co., Ltd.), 07 September, 2006 (07.09.06), Claims; Par. Nos. [0026] to [0030] & JP 2006-233184 A | 8-9<br>1-7,10-16 |
| Y | US 5336437 A (Osram Sylvania Inc.), 09 August, 1994 (09.08.94), Column 1, line 55 to column 2, line 16 & US 5232626 A & EP 575938 A1 & CA 2098627 A | 1-7,10-16 |
| Y | JP 2003-183645 A (Konica Corp.), 03 July, 2003 (03.07.03), Par. No. [0011] (Family: none) | 1-7,10-16 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 September, 2008 (22.09.08) | 07 October, 2008 (07.10.08) |
| Name and mailing address of the ISA/<br>Japanese Patent Office<br>Facsimile No. | Authorized officer<br><br>Telephone No. |

Form PCT/ISA/210 (second sheet) (April 2007)

**INTERNATIONAL SEARCH REPORT**

International application No.
PCT/JP2008/061839

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2004-253747 A (Mitsubishi Chemical Corp.), 09 September, 2004 (09.09.04), Claims; Par. No. [0044] & US 2005/0145854 A1 & EP 1484803 A1 & WO 2003/069686 A1 & CN 1647286 A | 1-7,10-16 |
| Y | JP 5-302082 A (Kasei Optonix, Ltd.), 16 November, 1993 (16.11.93), Claims; Par. Nos. [0012] to [0013] (Family: none) | 1-7,10-16 |
| A | JP 61-292848 A (Toshiba Corp.), 23 December, 1986 (23.12.86), Claims; page 2, lower right column, lines 9 to 19 (Family: none) | 1-16 |
| A | JP 59-24785 A (Tokyo Shibaura Electric Co., Ltd.), 08 February, 1984 (08.02.84), Claims; page 2, upper right column, line 11 to lower right column, line 8 (Family: none) | 1-16 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004253747 A
- JP 2002086978 A
- JP HEI5302082 B
- JP SHO61292848 B
- JP HEI2209989 B
- JP HEI2233794 B
- JP HEI3231987 B
- JP HEI6314593 B
- JP 2002223008 A
- JP 2005082788 A
- JP 2006028458 A
- JP 2006047274 A
- JP 2006047277 A
- JP 2006176468 A
- JP 2004300247 A
- JP 2006128163 A
- JP 2006351540 A
- JP 2007092852 A
- JP 2005290570 A
- JP 2007099878 A
- JP 2007173319 A
- JP 2007209521 A


### Non-patent literature cited in the description


- **Cornelius S. Hurlbut, Jr ; Cornelius Klein.** Manual of Mineralogy. John Wiley & Sons
- *Electrochemical and Solid-State Letters,* 2006, vol. 9 (4), H22-H25